# EUROPEAN PATENT SPECIFICATION

(11) **EP 4 674 133 B1**
(45) Date of publication and mention of the grant of the patent: **25.11.2026**
(21) Application number: 24715698.7
(22) Date of filing: 29.02.2024
(51) Int. Cl.: H04N 25/13

(54) **COLOR IMAGE SENSORS, METHODS AND SYSTEMS**
FARBBILDSENSOREN, VERFAHREN UND SYSTEME
CAPTEURS D'IMAGE EN COULEUR, PROCÉDÉS ET SYSTÈMES

(30) Priority: 02.03.2023 US 202363487941 P; 04.05.2023 US 202363500089 P; 25.07.2023 US 202363515577 P; 01.09.2023 WO PCT/US2023/073352
(43) Date of publication of application: 07.01.2026
(73) Proprietor: TRANSFORMATIVE OPTICS CORPORATION, Portland, OR 97209 (US)
(72) Inventor: BOETTIGER, Ulrich, C., Portland, OR 97209 (US); RHOADS, Geoffrey, B., Portland, OR 97209 (US); CHAPUT, Christopher, J., Portland, OR 97209 (US); LYONS, Robert, G., Portland, OR 97209 (US); BRUNK, Hugh, L., Portland, OR 97209 (US); CONNER, Arlie, R., Portland, OR 97209 (US)
(74) Representative: Forresters IP LLP
(86) International application number: PCT/US2024/017876
(87) International publication number: WO 2024/182612

(56) References cited:
- EP-A1- 3 460 848
- EP-A1- 3 506 357
- CN-A- 113 676 628
- US-A1- 2010 118 172
- US-A1- 2013 343 646
- US-A1- 2020 344 430
- DE GIOIA FRANCESCO ET AL: "Data-Driven Convolutional Model for Digital Color Image Demosaicing", APPLIED SCIENCES, vol. 11, no. 21, 1 November 2021 (2021-11-01), Basel, pages 9975, XP093101214, ISSN: 2076-3417, DOI: 10.3390/app11219975
- SADEGHIPOOR ZAHRA ET AL: "A novel compressive sensing approach to simultaneously acquire color and near-infrared images on a single sensor", ICASSP, IEEE INTERNATIONAL CONFERENCE ON ACOUSTICS, SPEECH AND SIGNAL PROCESSING - PROCEEDINGS 1999 IEEE IEEE, 26 May 2013 (2013-05-26), pages 1646 - 1650, XP032507936, ISSN: 1520-6149, ISBN: 9780780350410, [retrieved on 20131018], DOI: 10.1109/ICASSP.2013.6637931
- GEELEN BERT ET AL: "A compact snapshot multispectral imager with a monolithically integrated per-pixel filter mosaic", PROCEEDINGS OF SPIE, IEEE, US, vol. 8974, 7 March 2014 (2014-03-07), pages 89740L - 89740L, XP060034605, ISBN: 978-1-62841-730-2, DOI: 10.1117/12.2037607

## Description

### Related Application Data

In the U.S., this application is a continuation of international application PCT/US2023/073352, filed September 1, 2023, which claims priority to the following U.S. provisional applications: 63/478,527, titled Color Filter Arrays and Methods, filed 5 January 2023; 63/478,728, titled Color Filter Arrays Employing Filters with Non-Normative Transmission Functions, filed 6 January 2023; 63/479,572, titled Hue Recovery from Noisy Color Photosensor Data, filed 12 January 2023; 63/481,390, titled Color Filter Arrays Having Improved Modulation Transfer Functions, filed 25 January 2023; 63/487,941, titled Color Image Sensors With N-Byte Pixel Signature Mechanism to Increase Manufacturing Yields, filed 2 March 2023; 63/500,089, titled Color Image Sensors Employing Neighborhood-Variant Color Correction Kernels, filed 4 May 2023; and 63/515,577, titled Color Into Infrared Image Sensing, filed 25 July 2023.

The subject matter of this application also relates to that of U.S. application 18/056,704, filed November 17, 2022, and to that of its priority applications, namely applications 63/280,898, filed 18 November 2021; 63/267,892, filed 11 February 2022; 63/269,194, filed 11 March 2022; 63/362,508, filed 5 April 2022; 63/365,482, filed 27 May 2022; 63/367,999, filed 8 July 2022; and 63/381,639, filed 31 October 2022.

### Background

Digital imaging systems have proliferated in recent years, including in consumer, medical, agricultural, automotive and other machine vision applications. Many systems rely on Bayer pattern color filter arrays, first developed in the 1970s.

The advent and growing ubiquity of neural networks have expanded the power of digital imaging systems, and placed new demands on the technology.

US 2020/344430 A1 discloses a high dynamic range image sensor enabled by integrating broadband optical filters with individual sensor pixels of a pixel array. The broadband optical filters are formed of engineered micro or nanostructures that exhibit large differences in transmittance, e.g. up to 5 to 7 orders of magnitude. Such high transmittance difference can be achieved by using a single layer of individually designed filters, which show varied transmittance as a result of the distinct absorption of various material and structures. The high transmittance difference can also be achieved by controlling the polarization of light and using polarization-sensitive structures as filters. With the presence of properly designed integrated nanostructures, broadband transmission spectrum with transmittance spanning several orders of magnitude can be achieved. This enables design and manufacturing of image sensors with high dynamic range which is crucial for applications including autonomous driving and surveillance.

In DOI: 10.1117/12.2037607, Geelen Bert et al. disclose a novel snapshot multispectral imager concept based on optical filters monolithically integrated on top of a standard CMOS image sensor. The adoption of spectral imaging by industry has so far been limited due to the lack of high speed, low cost and compact spectral cameras. Moreover most state-of-the-art spectral cameras utilize some form of spatial or spectral scanning during acquisition, making them ill-suited for analyzing dynamic scenes containing movement. This disclosure overcomes the problems mentioned for scanning applications by snapshot acquisition, where an entire multispectral data cube is sensed at one discrete point in time. This is enabled by depositing interference filters per pixel directly on a CMOS image sensor, extending the traditional Bayer color imaging concept to multi- or hyperspectral imaging without a need for dedicated fore-optics. The monolithic deposition leads to a high degree of design flexibility. This enables systems ranging from application-specific, high spatial resolution cameras with 1 to 4 spectral filters, to hyperspectral snapshot cameras at medium spatial resolutions and filters laid out in cells of 4x4 to 6x6 or more.

Despite the progress made in digital imaging systems since the 1970s, many shortcomings persist. Aspects of the present technology serve to address various of these shortcomings.

One of the shortcomings concerns the noisiness of digital imaging systems in low light environments. When signal-to-noise ratios (SNRs) drop to 10:1, 3:1 and lower, current imaging systems cope poorly, especially in discriminating scene chromaticity. This compromises human enjoyment of the imagery, and impairs machine vision uses of the data.

In accordance with certain aspects of the technology, a digital image sensor is provided that provides superior low light performance.

One particular example is an image sensor comprising a semiconductor substrate fabricated to define a plurality of pixels, including a pixel cell of N pixels. This cell includes a first pixel at a first location in a spatial group, a second pixel at a second location, a third pixel at a third location, and so forth through an Nth pixel at a Nth location. Each of the pixels has a respective spectral response, and at least two pixels in the cell have different spectral responses.

The semiconductor substrate is further fabricated to define hardware circuitry configured to: (a) compare scene values associated with a first pair of pixels in the cell to obtain a first pixel pair datum; (b) compare scene values associated with a second pair of pixels in the cell, different than said first pair of pixels, to obtain a second pixel pair datum; and (c) form query data based on the first and second pixel pair data. In some examples, such comparisons are performed between all pairings of pixels in a cell. In other examples, such comparisons extend further, to pairings between the subject cell and surrounding cells. The resulting query data (which in some examples may be based on dozens or hundreds of pixel pair values) is provided as input data to a color reconstruction module that discerns color information for a pixel in the cell based on the query data.

The foregoing and many other features of the present technology will be more readily apparent from the following Detailed Description, which proceeds with reference to the accompanying drawings.

### Brief Description of the Drawings

Figs. 1 and 1A illustrate two embodiments.
Figs. 2 and 3 detail prior art spectral transmission curves.
Fig. 4 illustrates another embodiment.
Fig. 5 indicates a pixel identification arrangement.
Figs. 6A-6I detail spectral transmission curves for illustrative filters.
Fig. 7 details prior art spectral transmission curves.
Fig. 8 compares curves of Figs. 6A and 6B.
Fig. 9 identifies features of a filter spectral transmission curve.
Figs. 10-10I detail spectral transmission curves for more illustrative filters.
Figs. 11, 11A, 11B, and 11C illustrate pixel fields and their use in one example.
Fig. 12 illustrates variations in spectral transmission function due to filter thickness.
Fig. 13 illustrates spectral transmission functions for illustrative red, green, blue, cyan, magenta and yellow filters having thicknesses of one micron.
Fig. 14 illustrates how filters of different thicknesses, even using the same color resist, can contribute to diversity of spectral transmission functions.
Fig. 15 depicts first-derivatives of the functions of Fig. 14.
Fig. 16 shows a sparse array of transparent pedestals fabricated (e.g., of clear photoresist) on a photosensor array.
Fig. 17 shows the Fig. 16 arrangement after application of resist layers, yielding resist layers of differing thicknesses.
Fig. 18 depicts a green filter atop a transparent pedestal.
Figs. 19A-19E illustrate different arrays of sparse pedestals on an array of photosensors.
Figs 20 and 21 illustrate filter cells employing both relatively-thick and relatively-thin filters.
Fig. 22 shows spectral transmission curves for the filters of Fig. 21.
Fig. 23 illustrates an additional filter cell employing both relatively-thick and relatively-thin filters.
Fig. 24 shows spectral transmission curves for the filters of Fig. 23.
Figs. 25-28 illustrate other filter cells employing both relatively-thick and relatively-thin filters.
Fig. 29 shows spectral transmission curves for a six filter cell employing both relatively-thick and relatively-thin filters.
Fig. 30 shows spectral transmission curves for a prior art color image sensor, and the spectral transmission curve for a monochrome version of the same sensor.
Figs. 31, 32, 32A, 33, and 34 detail exemplary arrangements by which photosensors and color filters can be caused to have spatial relationships that vary across an image sensor.
Fig. 35 shows a color filter array employing two different 2 x 3 filter cells, each comprised of relatively-thick and relatively-thin filters.
Fig. 36 illustrates how the spectral transmission function of a red filter can deviate from a nominal value, such as the mean spectral transmission function of all red filters on an image sensor.
Fig. 37 details how deviations in a nominal spectral transmission function for red filters can vary among pixels of an image sensor.
Fig. 38 illustrates basis functions by which spectral transmission functions of filters can be parameterized.
Fig. 39 illustrates how color correction matrices can vary depending on local position of filter cells (or filters).
Fig. 40 shows how a base pixel (A) is compared against two ordinate pixels (B and C), yielding two pixel pair data.
Fig. 41 is a block diagram of an image sensor embodiment.
Fig. 42 shows how a base pixel can be compared against all other pixels in a cell.
Fig. 43 illustrates that each pixel in a cell can serve as a base pixel for comparison against one or more other pixels in the cell.
Figs. 44-46 illustrate that comparisons with a base pixel can extend beyond the base pixel's filter cell.
Fig. 47 shows the nine-reframings of a 3 x 3 pixel cell, each putting a different pixel at a central position.
Fig. 48 illustrates aspects of an embodiment in which a 2 x 2 Bayer filter cell has been re-framed as a 3 x 3 cell.
Figs. 49A and 49B compare performance of an embodiment against the prior art.
Fig. 50 identifies filter locations within a 2 x 2 cell.

### Detailed Description

This specification begins by detailing a first embodiment that introduces certain aspects of the technology, which are then discussed further in later embodiments. Such aspects include improvements in manufacturing, calibration and image processing procedures, e.g., to lower manufacturing tolerance constraints of image sensor color filter arrays, while maintaining or improving colorimetric, contrast and/or machine vision performance.

This first embodiment concerns a sensor including a color filter array (CFA) organized as 3 x 3 pixel cells (tiles), but other embodiments can naturally employ CFAs of other configurations. Pigment-based CFAs are used in this embodiment, but other filtering materials (e.g., dyes, quantum dots, etc.) can be used as well. Fujifilm and Toppan are well known suppliers of suitable pigments. We refer to all such materials as "pigments," "inks," "resists," or "color resists," regardless of their technical type.

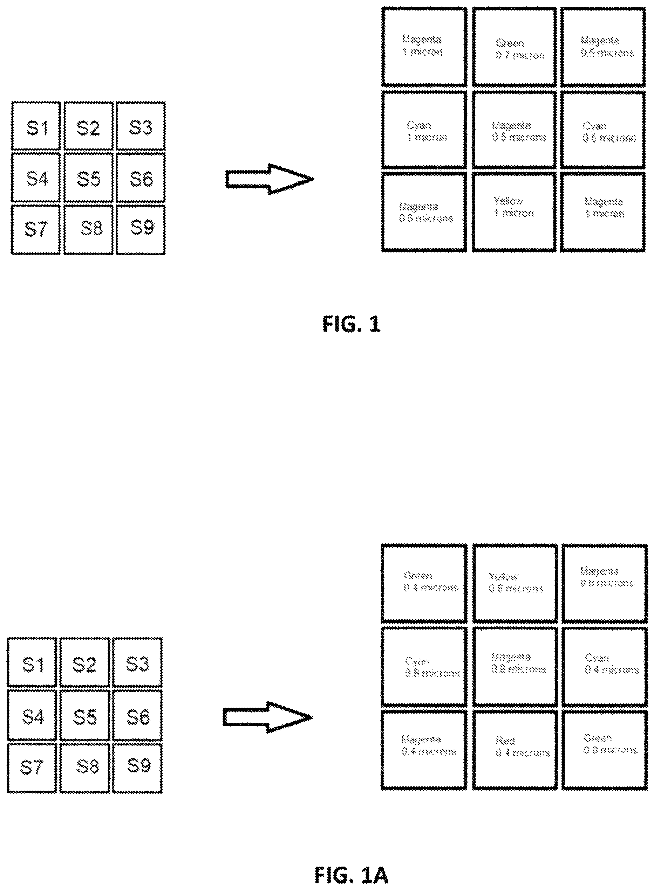

Referring to Fig. 1, the 3 x 3 CFA of the first embodiment employs four different commercially available color resist products (e.g., FujiFilm Color Mosaics^{®} brand products), laid out in the depicted pattern. Six separate photolithographic masks are used, each requiring a sequence of process steps (e.g., cleaning; resist coating/baking; exposure in the litho tool; developing; hard-baking; with associated metrology and inspection operations, as are familiar to artisans). For sake of a specific example, such a color filter array can overlie a 1200 x 1600, or a 3000 x 4000, pixel image sensor, each pixel of which outputs 16-bit brightness values. The pixels may be less than 10, less than 2 or less than 1 microns on a side.

Fig. 1A illustrates an alternative embodiment.

The first layer to be processed is the diagonal of three magenta pixels, S7, S5 and S3 in Fig. 1. The specification of this first layer is to aim for a 0.5 micron thick layer of magenta (M). After the develop and hard bake phases, metrology and inspection specifications will allow relaxed (larger) tolerances as compared to commercial-grade contemporary norms for CFA-based CMOS image sensors. Such relaxed tolerances include, e.g., higher cross-mixing of physical materials beyond the nominally specified color-resist material for any given pixel. That is to say, for example, rather than tolerating only two percent residual 'magenta' resist in an otherwise 'red' pixel, a manufacturer can instead tolerate ten percent. These numbers are used here only to illustrate an aspect of what is meant by relaxed tolerances. Such relaxed tolerances enable lower-cost and more environmentally friendly chemical choices than have been possible within existing tolerance norms.

The second layer specifies the photolithographic mask which corresponds to the two other corners of the 3 by 3 pixel cell, S1 and S9. These two pixel-cells will use the same CFA magenta pigment M, e.g., out of the same bottle and chemical delivery system, but this second layer will be specified to be 1 micron thickness, in contrast to layer 1's 0.5 microns. The second layer photolithographic masks will be manufactured such that a very small physical contact will be allowed, e.g., at the corners of the two cells of the second layer, as they come into contact with the three cells of the first layer. For example, on a sensor where pixels are 2 microns square, there might be a small 100 nm 'overlap' where the layer-2 pixel material covers layer-1 material. During metrology and inspection steps after the second layer is completed, these contacts between layer 1 cells and layer 2 cells can be quantified, e.g., in effective nanometers of overlap. As with layer 1, layer 2's tolerances will be relaxed, as compared to contemporary norms. This relaxation is for the same reason stated for layer 1. For example, current norms might posit a tolerance for 15% standard deviations in color resist thicknesses and only 3 percent cross-material residuals. Embodiments of the present technology increase one or both of these figures by 50%, 100%, 200% or more.

The third layer will specify common green (G) as is used in Bayer filter CFA sensors, and will target only a single cell in the 3 by 3 cell array, S2. There will be two modest differences from current practices of laying down green: A) the specified thickness of this G layer will be on the order of 10 to 40 percent thinner than is typical in a Bayer RGB sensor green layer; and B) the tolerances of metrology and inspection will, as they were with layers 1 and 2, be relaxed over contemporary practices. For this specific design, 0.7 microns is used as the specified thickness for this third layer. The main point is: choose a thickness for green that is thinner than is chosen within modern Bayer CFA designs.

The fourth layer employs commercially available cyan (C) to fill in the left, middle divot of the 3 by 3 cell structure, i.e., pixel location S4. The thickness specification for this fourth layer of cyan is 1 micron. As with the previous three layers, relaxed tolerances are employed. The fifth layer uses the same cyan, this time filling the right, middle pixel-cell-divot of the 3 by 3 cell pattern, S6. This will make it adjacent to a cyan pixel deposited in the fourth layer of the right-adjoining 3x3 cell. The thickness of this fifth layer will be 0.5 microns rather than the 1 micron for the fourth layer. In some embodiments, the physical mask used for layer four is rotated and used as the mask for layer five.

Finally, the sixth layer is the yellow (Y) mask and color resist layer, at pixel location S8. The thickness specification for this sixth layer is 1 micron, with relaxed tolerances as before.

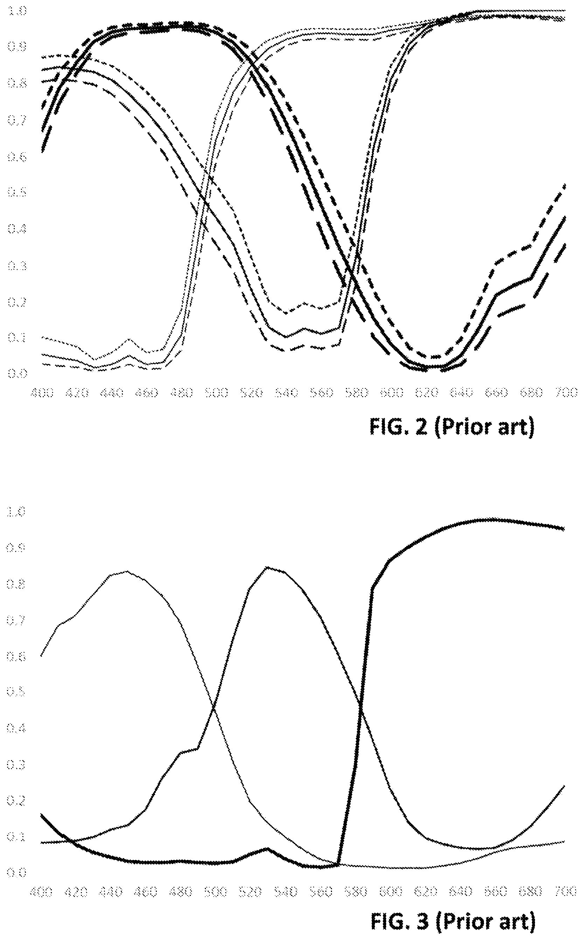

Figs. 2 and 3 show spectral curves associated with these color resists. These curves are based on published information from Fujifilm depicting characteristics of its Color Mosaic line of pigments. Fig. 2 shows cyan, magenta and yellow pigment transmission at different layer thicknesses, with the solid line indicating 0.9 microns (nominal), the dotted line being 0.7 microns, and the dashed line being 1.1 microns. Note, in connection with the differing thicknesses, that the curves don't simply shift up and down with the same profile. Rather, their shapes change. For example, the widths of the notches change, as do the slopes of the curves and the shapes of their stop-bands. Fig. 3 shows the red, green and blue pigment filter transmissions at nominal layer thicknesses.

The end results after a sensor (or large wafer containing many sensors) has been through these process stages is what may be called a very slightly wrinkled mosaiced carpet of color resist cells, where each cell is very slightly different from all its neighbor cells and indeed, from all of the 3 by 3 cells in the entire sensor. All cells share stable, coarsely defined patterning at the 3 by 3 pattern level, but all differ by measurable amounts at the nanometer level of surface measurements. Furthermore, statistically non-trivial amounts (trace amounts) of each layer's material will be present in the isolated pixels of one or more other layer's assigned cells (in some cases all of the other layers' assigned cells). Considering the 3 diagonal cells of layer 1 as one example, electron microscopy can reveal that if we normalize the atomic volume of layer 1's intended material inside its intended cell to the value of 1.0, then we will find volumes of layer 2, 3, 4, 5 and 6's material also occupying that cell with values perhaps in the range of 0.01 to 0.05, and sometimes in the range 0.005 to 0.1 or beyond. In lay terms, all layers' material will be found at some measurable levels in all pixels. Typical 'stratifications' of these trace amounts can also be expected, where such stratification can be expected to mimic the layering order.

The curves of Figs. 2 and 3 exhibit the spectral-axis visible range from 400 to 700 nanometers. Extensions into the near infrared (NIR) and near ultraviolet (NUV) are encouraged within all designs and applications where more than just 'excellent human-viewed color pictures' are desired. As taught in previous disclosures, a balance is encouraged that optimizes the quality of color images while maintaining a specified quality of multichannel information useful to machine vision applications (or vice-versa).

In the embodiment detailed above, all six layers' filters can have at least some transmissivity in the NUV and the NIR. This allows estimation of an NUV channel light signal and an NIR channel light signal. This is different from enabling, for example, two separate NIR light signal estimations, such as the band 700 nm to 750 nm, along with the band 750 nm to 800 nm, although that can be done in other embodiments. That is, we here treat the far-red and NIR band from about 690 nm to about 780 nm band as one single channel, and the deep blue to NUV band from about 360 nm to about 410 nm as one single channel. The six layers of filtering as described above enable diverse filtering behavior for these two new bands, which we term NIR and NUV for simplicity.

The underlying quantum efficiency (QE) of the silicon detector fades toward lower levels as blue light moves into the NUV, and as far red light moves into the NIR. So, in both cases, the underlying behavior of the sensor is moving the photoelectron signal levels downwards. On the NUV side of the spectrum, we have additional attenuation introduced by glass, both from a typical lens that is often utilized, but also from any glass that is a cover for the sensor itself. Thus, for NUV, we can make use of this normally occurring attenuation to provide an all-pixel NUV cut-off frequency in about the 350 nm to 360 nm wavelength range. Likewise, for NIR, the quantum efficiency of silicon falls off with increasing wavelengths, and either through pigmentation supplements, or explicit glass surfaces, or other means, one can fashion an all-pixel NIR cut-off. The first embodiment employs an all-pixel NIR cut-off somewhere between about 750 nm and about 800 nm.

With the all-pixels cut-off for both NIR and NUV established as just-described, we commonly want spectral transmission characteristics of the six layers with the NUV band and the NIR band to be slightly different between the six layers. The four M, C, Y and R commercially available color resists essentially do this already. To the extent a practitioner cannot find commercially available color resists that perform this diversity of transmissivity in the NIR and NUV bands, there remains the option of adding small amounts of pigments into the existing color resists that are largely transparent across the approximately 400 nm to approximately 700 nm visible range but will add some opacity in either or both of the NUV and/or NIR bands.

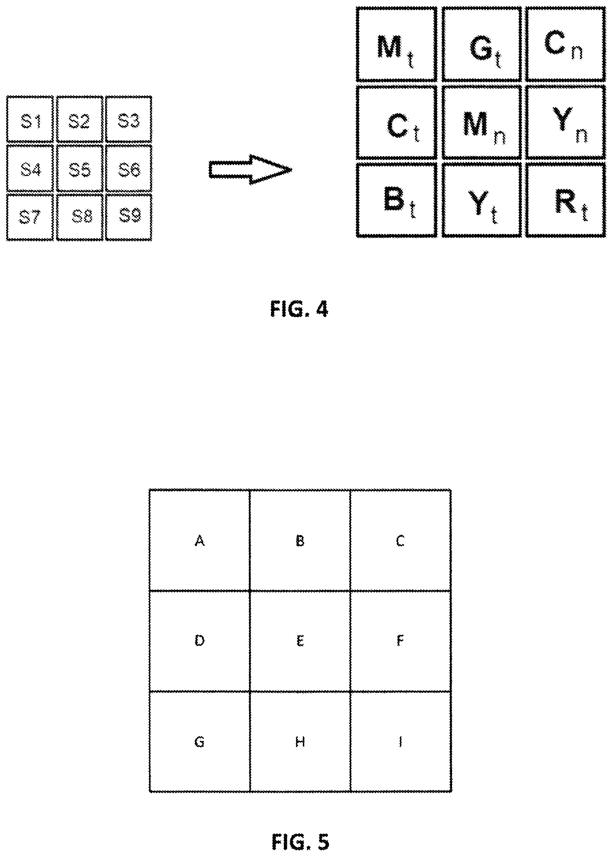

Another embodiment is shown in Fig. 4. This 3 x 3 color filter array includes 3 customary red, green and blue filters, plus two each of cyan, yellow and magenta. Each of these latter filters is fabricated with two different thicknesses - thin and thick (denoted "N" for narrow and "T" for thick in the figure), to yield two different spectral transmission filter curves for each of these three colors. The thin can be, e.g., less than 1.0 microns, such as 0.9, 0.8, or 0.7 microns, while the thick can be, e.g., greater than 0.8 microns, such as 0.9, 1, 1.2 or 1.5 microns (paired appropriately with the thin filter of that color to maintain the thin/thick relationship).

The above-detailed embodiments, of course, are simply exemplary. One underlying concept is that a color filter array can include elements formed of the same color resist, but with different thicknesses, to achieve diversity in filtering action. In one described embodiment, one magenta filter layer is 0.5 microns while another magenta filter layer is 1 micron. In one embodiment, there are three different magenta filter layers, of 0.4, 0.6, and 0.8 microns in thickness. Such ratios of thickness are exemplary only. In different embodiments, one layer may be just be 10% or 20% or 50% thicker than another layer of the same color. Or one layer may be 100% or 200%, or more greater, in thickness than another layer of the same color. One embodiment employs different thickness for only one color, whereas other embodiments employ different thicknesses for multiple colors. As indicated, some embodiments deposit a single photoresist at more than two different thicknesses.

A later section details how pedestals can be used to vary filter thicknesses.

### Tolerance Compensation, Calibrations and Algorithmic Implementations: Pixel-Wise Correction

Using the previously described first embodiment where four separate color resists are specified (C, M, Y, G), every photosite will contain some finite, measurable amount of each of the four pigments, namely its assigned color and trace amounts of the other three. Six different nominal surface thicknesses for these four color resists have been specified. Each photosite has a nominal surface thickness value ranging from a few tenths of a micron to over 1 micron; we call this the nominal thickness of the color resist layer.

Due to relaxation of conventional manufacturing tolerances, 'mixing' of the other three color resist pigments is expected for a specific sensor at all of its photosites. Such relaxation speeds up the processing of sensors, reducing costs.

We define the normalized pigment concentration level of a photosite's assigned pigment as the sensor-global mean value of said pigment, after a sensor has been manufactured and packaged. This global-sensor mean value is normalized, or set to 1.0 (i.e., we are not here talking microns).

For each photosite, detailed measurements will exhibit variations from this sensor-global mean value of 1.0, where the variations will partly be a function of the degree of relaxation of tolerances in manufacturing of the sensor. This variation might have a very low standard deviation about the mean value 1.0 of 0.03 or smaller for a situation where higher (tighter) tolerances in manufacturing have been practiced, all the way to a significantly higher standard deviation of 0.1 or larger, where experiments can be designed to 'push to the edge' of what can be tolerated and nevertheless still function properly. Let's call this standard deviation of the assigned pigments 'normalized slop'.

For each photosite in the first embodiment there are three (contaminating) pigments that are different from the photosite-assigned pigment. Each of these three pigments will have some sensor-global mean as measured across the entire manufactured and packaged sensor, in the cells where it is not the assigned pigment. This global mean for each of the three different pigments can be called the 'mixing mean'. All three pigments will have a unique mixing mean, with values in normalized units of a few hundredths (e.g., 0.015, 0.03, or 0.05) for higher tolerance manufacturing practices, to still higher values, such as 0.06, 0.1, 0.15 or higher normalized units for pushing-the-envelope experimentation.

Likewise relative to the standard deviation of the nominally assigned pigment, these non-assigned pigment mixing means will have their own standard deviations, call these 'mixing slop'. (Empirical practice is expected to show that for many sensors designs, the mixing means and the mixing slop values will be correlated via a simple square root relationship; be this as it may, this disclosure keeps these numbers as independent values.)

Recognizing that we have four pigments and also six specified thicknesses for those pigments across a 3 by 3 CFA (two thicknesses for two of the pigments, and one thickness each for the other two of the pigments, giving a total of six types), we find that there are six normalized 1.0 levels for the six photosite-types, each with their own normalized slop, and then three more mixing means for each of the six photosite-types, where each of these mixing means has an associated mixing slop number. Thus, we have for a baseline design:

Six normalized slop values; eighteen normalized mixing-means; and eighteen normalized mixing slop values. This is a total of forty-two calibration parameters, applicable to any given manufactured sensor. This set of values can be measured and then stored in memory on a sensor chip at a per-pixel or per cell level. One illustrative approach is to measure global means and values, fit histograms to individual pixel behaviors, and then digitize the histogram values, where a given pixel's individual behavior falls into one of these coded histogram bins.

During normal operation of a sensor, in which all photosites produce 'digital numbers' to represent detected photoelectron counts during some exposure, the task is to interpret these digital numbers properly in their context of calibration numbers. This context includes many elements, including:
1) a photosite's unique characteristics relative to global mean values;
2) relatedly, the inference of mixing ratios of the 4 pigments for each photosite;
3) the absolute radiance levels, as a function of the light spectrum, that produce given global mean values, and thus associate the normalized 1.0 values with sensor-irradiance levels;
4) the relationship of a photosite's characteristics relative to its immediate neighborhood of eight photosites surrounding it; essentially, its own surrounding 3 by 3 CFA cell; [Note that there is an alternate definition of a CFA pattern wherein every photosite can claim ownership of 'the center pixel, with then its resulting surrounding neighbors falling where they will; this is a useful algorithmic definition, different from the definitions utilized in the baseline design introductory CFA; we can call this the photosite-centered CFA];
5) the detailed relationship of some photosite-centered CFA and the eight 3 by 3 photosite-centered CFAs around the center CFA.

This list of five is not exhaustive, but it is sufficient for further descriptions of pixel-wise correction (PWC).

One example of the technology is thus a color imaging sensor with plural pixels, where each pixel is associated with a plural byte memory, and this memory stores data relating one or more parameter(s) of the pixel to such parameter(s) for like pixels across the sensor.

Every photosite has its own unique signature relative to these forty-two calibration parameters, which poses the matters of measuring and using these parameters.

The first matter is addressed by what is termed Chromabath and FuGaI illumination. The second matter is addressed by Pixel-Wise Correction.

### Chromabath and FuGaI

This disclosure builds on the Chromabath technology previously taught in applications 63/267,892 and 18/056,704), replacing the monochromator used therein with a multi-LED (e.g., ten- or twelve-LED) illumination system termed the Full Gamut Illuminator (FuGaI). The monochromator arrangement retains a role, however, in that it is used in order to train and calibrate the usage of the FuGaI in a scaled manufacturing line.

We can add further parameters to the parameters noted above, e.g., the dark-median. So each photosite may be characterized by parameters (some of which depend on the type of photosite layer) including: 1) its dark-median value in digital numbers; 2) its nominal equal-white-light gain in digital numbers, which is then related to irradiance (light levels falling upon a photosite); and then 3) through 5) are the CYMG mixing ratios, with the sum of the ratios being 1.0, where only three parameters are required to fully specify those ratios.

We start with spectral curves of the C, Y, M and G photosites; these curves interact with the quantum efficiency curves of the underlying silicon sensor photosites. These spectral curves also reflect Beers-Lambert behavior of the photosites, such that thickness and mixing ratio knowledge refines the spectral estimations. We then characterize the five noted spectrometric parameters of each photosite.

Measurement of the dark medians draws from 'dark frame' characterization in astronomy. No light is allowed to fall onto a sensor; many frames of data are captured; and the long-term global average of the frames is stored, sometimes associated with metadata indicating the temperature of the sensor. Such data is then used to correct later measurements, e.g., by subtracting the dark frame data on a pixel-by-pixel basis. Many existing CMOS image sensors have some form of dark level adjustment and/or correction.

In some examples, applicant uses the median, rather than the mean, of a series of dark frames for correction. This is believed to aid in certain operations that employ neighboring photosite comparisons.

The equal-white-light gain values for a sensor's photosites are typically measured after correction for each photosite's dark median value has been applied. 'Flat field' imaging procedures can be used to measure these gain values.

Measuring the CMYG mixing ratios is more involved. Various methods can be employed. An illustrative method, detailed below, is suited to low cost, mass-scaled manufacturing, designed to apply at the millions of sensors per year unit volume level.

Four "color calibration sensors" are fabricated, each employing only one of the C, M, Y and G color resists. These sensors go through all steps required for making a final CFA based CMOS imaging sensor, except that at the CFA color resist process stage of manufacturing, only one stage of color resist coating is applied. However, the thickness of the color resist is proactively varied in different regions of the sensor, from thicknesses as thin as a few tenths of a micron (nominal), up sometimes to 1 or 2 microns in thickness. Spatial patterns such as sinusoids and squares, or photo-site level masking, can be applied. The resulting color calibration sensors will be used to characterize the sensor-global spectrometric properties of how the specific choices of C, M, Y and G all interact with the silicon-driving quantum efficiency (QE) sensitivity spectral profiles for this specific class of photosite size (pitch).

Why are there four calibration sensors, one each for the four C, M, Y and G? We don't want cross-mixing of any pigments. The full Beers-Lambert modelling of a single isolated color resist can be measured, in situ, within the same photosite structures of a final design/build. If cost constraints dictate, the color resist can be modeled according to a supplier's spectral curve data to yield data that is probably 90% as good, but preferable is to apply the color resists to the exact photosite structures being used, thinning those resist layers across some large range of thickness values, and then measuring digital number outputs.

Next is to run each of these color calibration sensors through a (preferably) monochromator-based Chromabath. As noted, "Chromabath" is a coined term from an earlier provisional filing. Once a designer has chosen a full effective spectral range for the image sensor array, such as 350 nm to 800 nm, then Chromabath is a procedure to bathe the full sensors in monochromatic light moving from one end of the spectral range to the other. In the case of the monochromator based Chromabath, using the four color calibration sensors, a lambda step size of 1 nanometer, giving 451 wavelength steps per acquired image, can be employed. Consistent with good practice, the illumination light field is assumed to be uniform (e.g., to within low single digit percentages; optimally below 1%). Likewise for the absolute irradiance values at all of the wavelengths between 350 and 800. Multiple measurement sessions can span hours collecting the data.

The result of such data collection will be Beer Lambert law-looking spectral curves covering the selected range of wavelengths. Fig. 2 illustrates, revealing the variation in spectral responses associated with the different thicknesses of different photosites on the color calibration sensors. These curves will of course be isolated to one-each of C, Y, M and G, and will manifest properties of the photosites, which typically include photo-site variational silicon response quantum efficiency effects. Again, a lower cost approach is to use modeling instead of measurement, but since measurement is a one-time pre-production laboratory step, the effort amortizes well across even low volume production.

With these pseudo-Beer-Lambert spectral curves for the four color calibration sensors in hand, we next take N different production samples of a CFA CMOS image sensor to undertake FuGaI training.

These N sample production sensors (where N can be, e.g., five) serve as proxies for the production run of sensors, and will serve as what we term Pigment-Mixing Truth Calibration Sensors (as distinguished from the single-resist Color Calibration Sensors). As with the color calibration sensors, we begin by measuring these sensors to determine median dark value and median flat-white-gain value for every photosite on every sensor.

We also determine the C, Y, M and G molar or thickness-equivalent concentration values for each photosite. This is done by performing Chromabath measurement on each sensor, just as with the Color Calibration Sensors. The aim is to determine the "thickness equivalent" concentration level (c, m, y and g) of all four color-resist-pigments C, Y, M and G, for each photosite. We sometimes term these the four truth vectors. A non-linear least-squares fitting for each photosite can use the following formula as a basis equation: $Photosite - Measured - Spectral - Curve = c * Cbl \left(c\right) + m * Mbl \left(m\right) + y * Ybl \left(y\right) + g * Gbl \left(g\right)$ (1)

Here, the lower case bl indicates that these are either the modelled (lower cost scenarios) or the empirically measured pseudo-Beer-Lambert curves for the respective pigments. "Pseudo" simply acknowledges that empiricism trumps theory.

For any given photosite within the baseline 3 by 3 CFA, there is a nominal thickness of its assigned color resist. This nominal value should roughly be the mean value of calibration measurements for that photosite-type across the full sensor. Then the other three values will be, typically, less than 10% of the value of this nominal value.

Based on monochromator measurement in the Chromabath process, and the non-linear least-squares fitting, we have thickness-equivalent pigment values for each photosite among our N Pigment Mixing Truth Calibration Sensors. We want comparable data for every sensor in our production run, but without such a protracted process. That's where FuGaI comes into play.

FuGaI, once again, is the acronym for Full Gamut Illuminator. An illustrative illuminator comprises ten or twelve LED narrow band emitters, each with a bandpass typically in the 20 to 50 nanometer Full Width Half Maximum range. The center wavelengths are chosen so that all but two are spaced across the visible spectrum of light, with the remaining two placed within the NIR spectrum. These LEDs are desirably tested to assure they are time-stable in their center wavelengths and in their brightnesses. Wavelength stability within single digit nanometers is desired. Brightness variations in the low single digits, or even under 1%, are desired.

From an illumination distance of, e.g., 40 cm, and with a frosted white covering on top of the LED illuminators, the individual LEDs of the FuGaI system are sequentially turned on to illuminate the N pigment mixing-truth calibration sensors, one at a time or all together. Many images per LED state are captured with the pigment mixing-truth calibration sensors, e.g., numbering in the hundreds or thousands. The median value of each "pixel" is recorded over these 100 to 1000 images per LED state.

"Pixel" and "Photosite" are used somewhat interchangeably. "Pixel" is sometimes favored when referring to digital numbers associated with photosites, while "photosite" is sometimes favored when discussing the physical properties of a photosensor site. Note that photosites produce raw digital numbers (DNs) and each photosite can be associated with calibration information with which the raw photosite DN may be adjusted. The resulting adjusted number, i.e., the digital number plus a calibration datum, may be referenced as DN+Cal. Hence, each pixel will produce DN values within a Cal context. The FuGaI Chromabath procedure serves to produce this Cal information for each pixel, as trained by the mixing-truth data attached to each of the N pigment mixing-truth sensors.

Each pigment mixing-truth sensor produced 12 images of median-DN values during the FuGaI Chromabath process. This yields, for each pixel in each of the N sample sensors, a 12-dimensional vector, which we term "R12," for real-12D. (Light-field non-uniformities of the FuGaI unit itself will affect the flat-white-gain value measurements but those non-uniformities will have less impact on the mixing-coefficients (c, y, m and g) that are to be measured by the 12-set of images.)

Each pixel in each pigment mixing-truth sensor also has an associated 4-dimensional vector, produced by the above-detailed least squares curve fitting process based on the 451-point monochromator Chromabath measurements ("R4," comprising the values c_truth, m_truth, y_truth and g_truth).

The task then becomes to establish a mapping that transforms values in this 12D vector (R12) space to values in this 4D vector space (R4). A consideration for such mapping problems is the so-called one to one mapping question, specifically applied to the mapping of R4 singular points back into R12 space: will two separate points in R4 space both map to a singular point in R12 space? Also of relevance is the related problem of common noise: if the R12 measurement points are too noisy, will there be unacceptable smearing of R4 solution values? Will there be too much error on trace measurements of cyan, magenta and yellow, for example, in an assigned-green pixel?

Empirical evidence suggests that these are merely theoretical concerns and that in practice, trace amounts of three non-assigned pigments can be measured as ratios against the assigned pigment. In numeric terms, let us take as one example a pixel that has been assigned cyan with a color resist nominal thickness of 0.5 microns. Can we really measure, using the FuGaI Chromabath process, thickness-equivalent values in the 10 to 100 nanometer ranges for magenta, yellow and green? Tests indicate the answer is yes.

This thickness-equivalent metric for the three non-assigned pigments is intuitively a good choice in describing the mixing of pigments. This does not technically describe the nanoscale physical realities of photosites, but it serves our purposes. In an exemplary embodiment, we employ this thickness equivalent calibration approach to yield thickness-equivalent metrics, measured with nanometer units and associated with the nominal thickness of the assigned color resist, measured in microns.

Turning to the concluding steps of the FuGaI Chromabath process applied to the pigment mixing-truth sensors, recall that the first embodiment comprises six pixel-types within the 3 by 3 CFA. Let us call these:
Layer 1 - M0.5 (magenta, 0.5 micron thickness)
Layer 2 - M1 (magenta, 1 micron thickness)
Layer 3 - G0.7 (green, 0.7 micron thickness)
Layer 4 - C1 (cyan, 1 micron thickness)
Layer 5 - C0.5 (cyan, 0.5 micron thickness)
Layer 6 - Y1 (yellow, 1 micron thickness)

Across all pixels of all N pigment mixing-truth sensors, we now empirically solve for the mapping functions between R12 FuGaI vectors and the R4 truth vectors to determine the trace amount mixing. Each of the six pixel types above needs its own mapping functions. In the Chromabath process, the flat-white gain values and the dark-median values may also be measured. These will be measured during the production-line use of the FuGaI Chromabath procedure, so we might as well do them here too.

One purpose of the FuGaI Chromabath process on the mixing-truth sensors is to calibrate the mixing ratio measurement capability of the FuGaI Chromabath process itself, to be utilized at mass-scaled production volume quantities. Applicant prefers FuGaI-based Chromabath testing of production sensors, rather than monochromator-based Chromabath testing, for reasons including cost, simplicity, scaled manufacturing, integration-considerations into existing sensor-test regimens, etc.

Solving for equation (1) across all pixels and all N sensors produces six 4 rows by 12 columns arrays of mapping function coefficients. These matrices can then be used to estimate the trace pigment mixing ratio for every pixel in each of the mass-produced sensors.

In particular, testing of each mass-produced sensor includes performing the FuGaI Chromabath process, yielding a R12 vector for each pixel. For each pixel of type X (Layers 1 through 6), this R12 vector measured during post-production testing is multiplied by the Xth 4 by 12 matrix, to thereby calculate that pixel's trace-pigment mixing ratio. Just as each individual pixel in contemporary imaging sensors has associated dark offset and gain parameters, so too can each pixel have its own associated pigment mixing ratios. These data are written to non-volatile memory on the sensor chip. While sometimes regarded as flaws in the manufacturing process, this 'slop' within the pixel-to-pixel manufacturing process is utilized to correct a variety of downstream processing steps, with demosaicing being one illustrative downstream step.

### Pixel-Wise Correction

This disclosure next turns to use of the pigment mixing ratio data, i.e., pixel-wise correction.

Such correction employs stored calibration data on the sensor chip. The detailed arrangement achieves efficient use of memory storage while providing enhanced imagery (e.g., contrast, color accuracy, color gamut, machine learning channel richness, etc.).

A 3 byte per pixel calibration storage scheme is used in one example. 4 bits of one byte are reserved for a pixel's dark median value, and 4 bits of the same byte are dedicated to a white gain correction value. These two stored values can indicate differential values, relative to a global mean for each one of the six pixel types (the layers, above). These values correspond to bins of a histogram representing positive and negative ranges of deviation about the global pixel-type means. (The six means, and data for each of the bins in the six histograms, are stored separately on the sensor chip.) 16 values are usually fine to cover a relatively tightly bound histogram of values.

The remaining two byes indicate pigment mixing values for a specific pixel of one of the six pixel-types. Here, too, a 4-bit histogram-about-the-global-mean algorithm may be used. Every trace-amount ratio has some global mean, and a histogram is used to describe how the population of individual pixels of that pixel-type varies about that mean. The particular 4-bit value indicates one of the histogram bins and indicates a corresponding calibration value that is accessed from a memory and applied to adjust the DN value. There are four such 4-bit values associated with a given pixel, one for the magenta trace-ratio, one for the cyan, one for green and one for yellow. (Here, and elsewhere, we reference four "trace" ratios. One of these colors, however, is the assigned photosite color, so is more than a "trace." All are treated similarly insofar as the histogram representation is concerned.) Different histograms are associated with different ones of the six layer types.

Naturally, the just-detailed arrangement is exemplary only. Different applications have different considerations, including cost, physical real-estate, complexity, power consumption, etc. 3 bytes per pixel is illustrative, as is the use of histograms that indicate differences from corresponding mean values. Using one of the three bytes for immediate offset/gain correction is suggested. The other 2 bytes, plus the offset/gain correct DNs, can be used in the demosaicing stages, which either use algebraic algorithms or AI/ML/CNN algorithms, to derive demosaiced color data for each pixel. The static 2 byte trace-ratio values will simply be static metadata additions to the otherwise normal algorithmic operations of demosaicing.

### First Exemplary Filter Set

In accordance with certain other aspects of the technology, a novel set of different filters are chosen for a color filter array (CFA) that is to form part of, and filter light admitted to pixels of, a photosensor array. As indicated, color filter arrays customarily comprise square cells of plural filters, which are repeatedly tiled with other such cells across the photosensor. In other arrangements, cells of two or more different filter patterns may be tiled in tessellated fashion. In some arrangements, each filter in a cell can have a spectral transmission function T (sometimes termed the spectral profile, or the transmission function) different than the other filters in the cell. In other arrangements, certain filter types may be repeated within a cell, such as the two greens within a 2 X 2 Bayer cell. Non-square cells are sometimes employed, including rectangular, triangular and hexagonal cells.

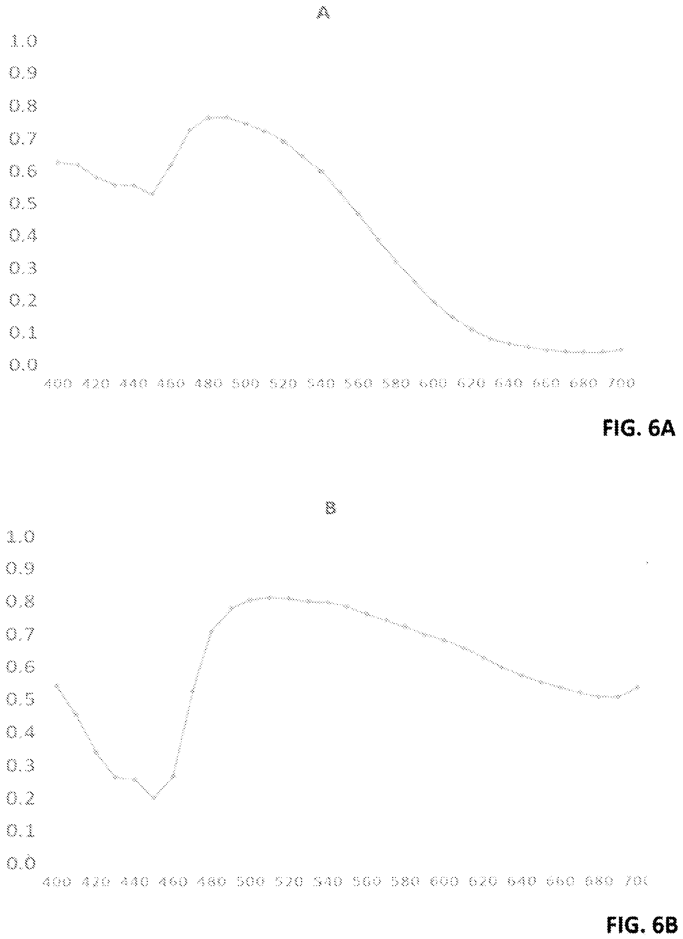

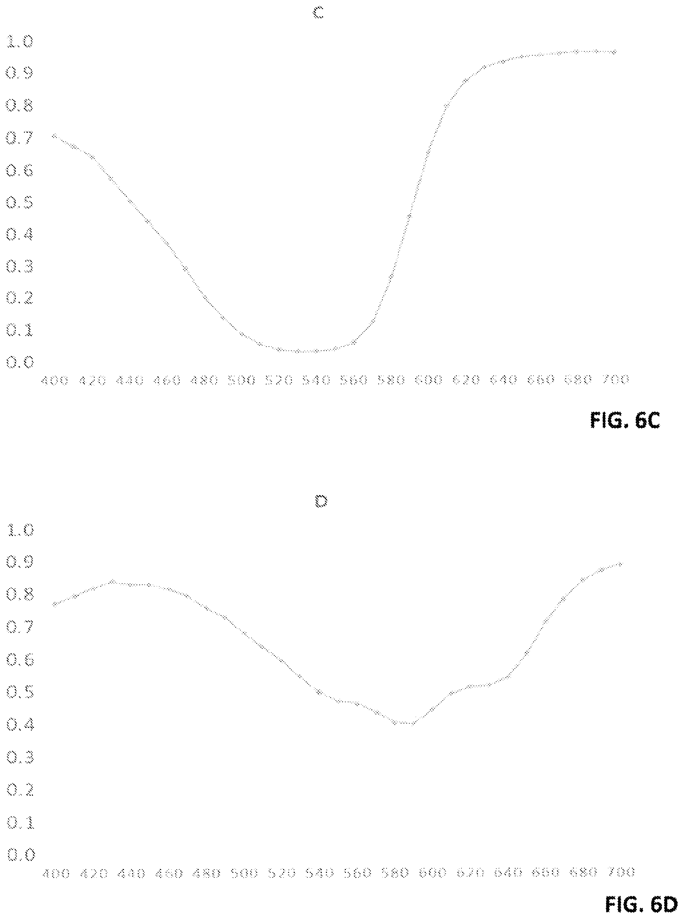

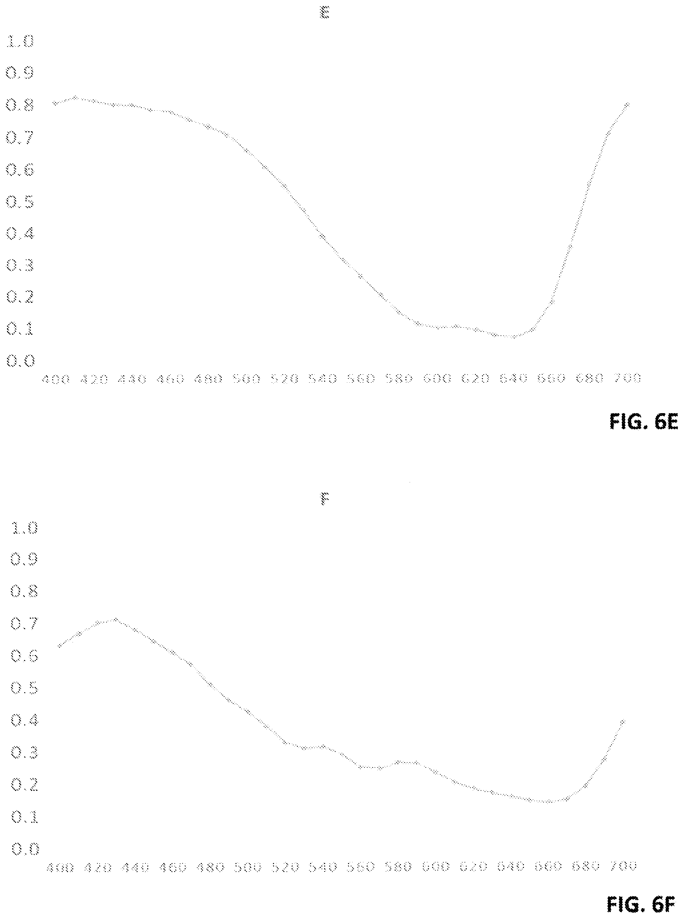

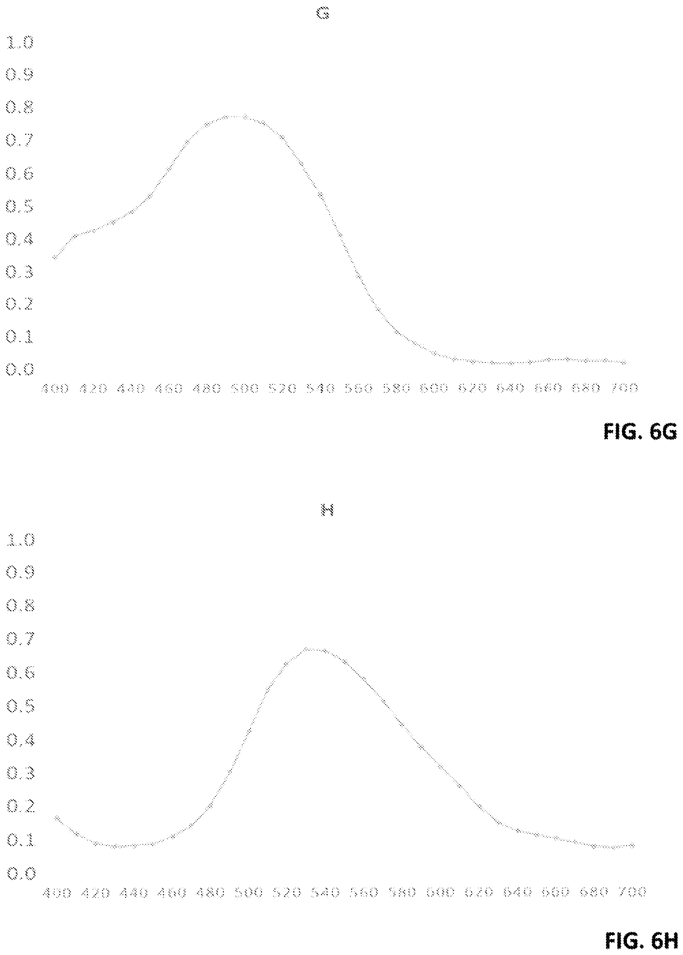

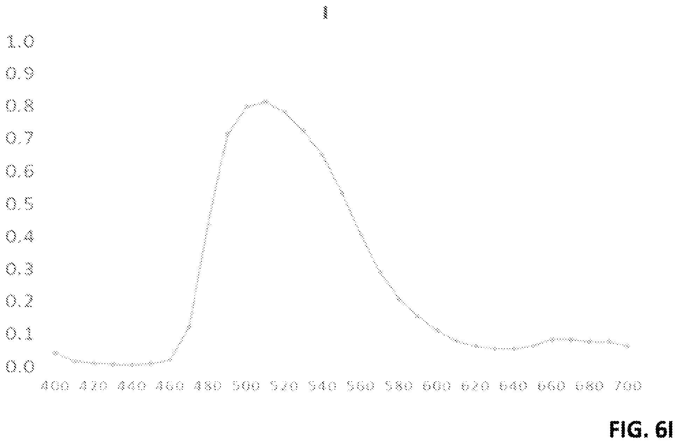

Fig. 5 shows a color filter cell embodiment with nine filters that are all different, identified as filters A, B, C, D, E, F, G, H and I. These may be chosen by a process such as is described in application 18/056,704, filed November 17, 2022, although other selection processes can be used. Transmission functions for filters A - I are shown in Figs. 6A-I. Tabular data detailing the filters' transmission functions at wavelengths spaced 10 nm apart is set forth in the following Table I:

**TABLE I**

| | A | B | C | D | E | F | G | H | I |
|---|---|---|---|---|---|---|---|---|---|
| 380 | .5500 | .7069 | .6444 | .7299 | .7707 | .5464 | .0877 | .2680 | .0823 |
| 390 | .5886 | .6174 | .6891 | .7480 | .7846 | .5811 | .2239 | .2263 | .0727 |
| 400 | .6288 | .5420 | .7063 | .7717 | .8075 | .6337 | .3451 | .1673 | .0426 |
| 410 | .6214 | .4504 | .6763 | .7945 | .8238 | .6699 | .4086 | .1178 | .0187 |
| 420 | .5814 | .3399 | .6437 | .8187 | .8132 | .7030 | .4264 | .0912 | .0117 |
| 430 | .5583 | .2649 | .5756 | .8391 | .8016 | .7134 | .4512 | .0817 | .0084 |
| 440 | .5556 | .2567 | .5056 | .8297 | .8007 | .6808 | .4836 | .0851 | .0071 |
| 450 | .5301 | .2031 | .4402 | .8293 | .7851 | .6458 | .5320 | .0887 | .0112 |
| 460 | .6189 | .2672 | .3704 | .8154 | .7791 | .6105 | .6150 | .1106 | .0220 |
| 470 | .7277 | .5235 | .2909 | .7954 | .7548 | .5723 | .6971 | .1433 | .1227 |
| 480 | .7653 | .7090 | .2047 | .7580 | .7337 | .5108 | .7487 | .2024 | .4393 |
| 490 | .7668 | .7797 | .1369 | .7299 | .7076 | .4615 | .7717 | .3036 | .7133 |
| 500 | .7473 | .8050 | .0875 | .6815 | .6611 | .4247 | .7708 | .4249 | .7985 |
| 510 | .7249 | .8128 | .0554 | .6377 | .6079 | .3794 | .7511 | .5502 | .8136 |
| 520 | .6932 | .8087 | .0389 | .5970 | .5493 | .3300 | .7086 | .6264 | .7840 |
| 530 | .6493 | .8012 | .0335 | .5471 | .4718 | .3118 | .6296 | .6684 | .7236 |
| 540 | .6008 | .7977 | .0342 | .4981 | .3891 | .3169 | .5359 | .6656 | .6490 |
| 550 | .5348 | .7851 | .0407 | .4715 | .3171 | .2922 | .4110 | .6331 | .5353 |
| 560 | .4656 | .7621 | .0607 | .4629 | .2625 | .2532 | .2849 | .5812 | .4059 |
| 570 | .3890 | .7431 | .1243 | .4366 | .2048 | .2482 | .1813 | .5142 | .2901 |
| 580 | .3190 | .7238 | .2649 | .4045 | .1495 | .2672 | .1135 | .4439 | .2071 |
| 590 | .2576 | .6998 | .4534 | .4004 | .1130 | .2636 | .0786 | .3778 | .1547 |
| 600 | .1948 | .6823 | .6557 | .4444 | .1016 | .2363 | .0493 | .3193 | .1114 |
| 610 | .1478 | .6594 | .7971 | .4938 | .1046 | .2063 | .0323 | .2595 | .0793 |
| 620 | .1104 | .6292 | .8745 | .5147 | .0948 | .1859 | .0246 | .1989 | .0643 |
| 630 | .0809 | .5995 | .9154 | .5187 | .0784 | .1737 | .0200 | .1511 | .0565 |
| 640 | .0639 | .5721 | .9346 | .5438 | .0706 | .1624 | .0189 | .1261 | .0555 |
| 650 | .0544 | .5518 | .9489 | .6175 | .0937 | .1494 | .0220 | .1146 | .0654 |
| 660 | .0458 | .5357 | .9548 | .7134 | .1827 | .1437 | .0300 | .1054 | .0842 |
| 670 | .0407 | .5192 | .9601 | .7847 | .3535 | .1534 | .0301 | .0925 | .0849 |
| 680 | .0390 | .5075 | .9638 | .8416 | .5496 | .1935 | .0262 | .0801 | .0771 |
| 690 | .0389 | .5063 | .9643 | .8731 | .7076 | .2748 | .0260 | .0757 | .0776 |
| 700 | .0473 | .5357 | .9622 | .8912 | .7968 | .3901 | .0204 | .0822 | .0644 |
| 710 | .0767 | .5943 | .9675 | .9047 | .8437 | .5165 | .0158 | .1111 | .0473 |
| 720 | .1468 | .6836 | .9746 | .9143 | .8696 | .6342 | .0180 | .1665 | .0480 |
| 730 | .2773 | .7696 | .9675 | .9066 | .8810 | .7235 | .0311 | .2625 | .0741 |
| 740 | .4385 | .8378 | .9690 | .9137 | .8950 | .7845 | .0795 | .3903 | .1515 |
| 750 | .5967 | .8852 | .9699 | .9182 | .8941 | .8297 | .2076 | .5262 | .3207 |
| 760 | .5500 | .7069 | .6444 | .7299 | .7707 | .5464 | .0877 | .2680 | .0823 |
| 770 | .5886 | .6174 | .6891 | .7480 | .7846 | .5811 | .2239 | .2263 | .0727 |
| 780 | .6288 | .5420 | .7063 | .7717 | .8075 | .6337 | .3451 | .1673 | .0426 |

This transmission function data was measured without near infrared or near ultraviolet filtering that is found in some embodiments.

It will be noted that the maximum transmission value in Table I is 0.9643, i.e., in Filter C, at 690 nm. To provide metrics that can be compared across data sets, it is sometimes helpful to normalize filter transmission values to the largest transmission value in the filter set. In the present instance, we divide each value in Table I by 0.9643 to yield the data in Table II. We term such data "group-normalized." The transmission value for Filter C at 690 nm is now 1.0, and all other data are proportionately larger. This group normalization is known to practitioners, where it is taught that the actual operation of a sensor and the use of these curves in, for example, color correction matrices, these normalizations revert to their non-normalized forms. Since most of the following discussion concerns wavelengths between 400 and 700 nm, we limit the table to this data too (where extensions of wavelengths below 400 or above 700 are omitted to simplify this section of the disclosure):

**TABLE II**

| | A | B | C | D | E | F | G | H | I |
|---|---|---|---|---|---|---|---|---|---|
| 400 | .6521 | .5620 | .7325 | .8003 | .8374 | .6571 | .3579 | .1735 | .0442 |
| 410 | .6445 | .4670 | .7014 | .8240 | .8544 | .6947 | .4237 | .1222 | .0194 |
| 420 | .6030 | .3525 | .6675 | .8490 | .8433 | .7290 | .4422 | .0945 | .0121 |
| 430 | .5790 | .2747 | .5969 | .8702 | .8313 | .7398 | .4680 | .0847 | .0087 |
| 440 | .5761 | .2662 | .5244 | .8604 | .8304 | .7060 | .5015 | .0882 | .0073 |
| 450 | .5497 | .2106 | .4565 | .8600 | .8142 | .6698 | .5517 | .0920 | .0116 |
| 460 | .6418 | .2771 | .3842 | .8456 | .8079 | .6331 | .6378 | .1147 | .0228 |
| 470 | .7546 | .5429 | .3017 | .8248 | .7827 | .5935 | .7230 | .1487 | .1273 |
| 480 | .7937 | .7352 | .2123 | .7861 | .7609 | .5297 | .7764 | .2099 | .4555 |
| 490 | .7952 | .8086 | .1420 | .7569 | .7338 | .4785 | .8003 | .3149 | .7397 |
| 500 | .7750 | .8349 | .0907 | .7067 | .6856 | .4404 | .7994 | .4406 | .8281 |
| 510 | .7518 | .8429 | .0575 | .6613 | .6304 | .3935 | .7789 | .5706 | .8437 |
| 520 | .7189 | .8387 | .0403 | .6191 | .5697 | .3423 | .7349 | .6496 | .8130 |
| 530 | .6733 | .8309 | .0347 | .5674 | .4893 | .3234 | .6529 | .6932 | .7504 |
| 540 | .6230 | .8272 | .0355 | .5165 | .4035 | .3287 | .5557 | .6902 | .6731 |
| 550 | .5546 | .8141 | .0422 | .4889 | .3289 | .3031 | .4262 | .6565 | .5551 |
| 560 | .4828 | .7904 | .0630 | .4801 | .2722 | .2625 | .2955 | .6027 | .4210 |
| 570 | .4034 | .7706 | .1289 | .4527 | .2124 | .2573 | .1880 | .5332 | .3009 |
| 580 | .3308 | .7507 | .2747 | .4195 | .1550 | .2771 | .1177 | .4603 | .2148 |
| 590 | .2671 | .7257 | .4702 | .4152 | .1171 | .2734 | .0815 | .3918 | .1604 |
| 600 | .2020 | .7075 | .6800 | .4609 | .1054 | .2451 | .0512 | .3311 | .1155 |
| 610 | .1533 | .6838 | .8266 | .5120 | .1085 | .2139 | .0335 | .2691 | .0823 |
| 620 | .1145 | .6525 | .9069 | .5337 | .0984 | .1928 | .0255 | .2062 | .0667 |
| 630 | .0839 | .6217 | .9494 | .5379 | .0813 | .1801 | .0208 | .1567 | .0586 |
| 640 | .0662 | .5933 | .9692 | .5640 | .0732 | .1685 | .0196 | .1308 | .0576 |
| 650 | .0564 | .5723 | .9840 | .6404 | .0972 | .1550 | .0228 | .1188 | .0678 |
| 660 | .0475 | .5555 | .9902 | .7398 | .1895 | .1490 | .0311 | .1093 | .0873 |
| 670 | .0422 | .5384 | .9957 | .8138 | .3666 | .1590 | .0312 | .0959 | .0881 |
| 680 | .0404 | .5263 | .9995 | .8728 | .5700 | .2006 | .0271 | .0830 | .0800 |
| 690 | .0403 | .5251 | 1.000 | .9055 | .7339 | .2850 | .0270 | .0785 | .0805 |
| 700 | .0490 | .5556 | .9978 | .9242 | .8264 | .4045 | .0212 | .0853 | .0668 |

The just-detailed filters are different, in their transmission functions, from filters commonly encountered in the prior art, i.e., red, green, blue, cyan, magenta and yellow filters. Fujifilm is one vendor of such prior art filters. Transmission functions for their 5000 series "Color Mosaic" line of red, green, and blue filters, and their 4000 series "Color Mosaic" line of cyan, magenta and yellow filters, are regarded as normative. Published curves were digitized, and the resulting transmission function data for these six filters are detailed in the following Table III. (As with the previous tables, this data is without infrared or ultraviolet filtering.)

**TABLE III**

| Wavelength | R | G | B | C | M | Y |
|---|---|---|---|---|---|---|
| 400 | 0.1600 | 0.0834 | 0.5978 | 0.6707 | 0.8365 | 0.0529 |
| 410 | 0.1112 | 0.0847 | 0.6850 | 0.7856 | 0.8436 | 0.0434 |
| 420 | 0.0774 | 0.0888 | 0.7140 | 0.8580 | 0.8385 | 0.0359 |
| 430 | 0.0557 | 0.0989 | 0.7716 | 0.9123 | 0.8298 | 0.0156 |
| 440 | 0.0437 | 0.1190 | 0.8231 | 0.9389 | 0.8093 | 0.0253 |
| 450 | 0.0311 | 0.1330 | 0.8358 | 0.9475 | 0.7715 | 0.0493 |
| 460 | 0.0269 | 0.1747 | 0.8103 | 0.9495 | 0.7238 | 0.0254 |
| 470 | 0.0278 | 0.2659 | 0.7694 | 0.9521 | 0.6672 | 0.0315 |
| 480 | 0.0309 | 0.3315 | 0.6957 | 0.9556 | 0.5889 | 0.1078 |
| 490 | 0.0269 | 0.3427 | 0.5781 | 0.9530 | 0.5048 | 0.3705 |
| 500 | 0.0258 | 0.4635 | 0.4443 | 0.9384 | 0.4327 | 0.6468 |
| 510 | 0.0299 | 0.6437 | 0.3114 | 0.9095 | 0.3581 | 0.7742 |
| 520 | 0.0505 | 0.7871 | 0.1993 | 0.8614 | 0.2382 | 0.8475 |
| 530 | 0.0660 | 0.8452 | 0.1366 | 0.7865 | 0.1268 | 0.8941 |
| 540 | 0.0365 | 0.8326 | 0.0998 | 0.6967 | 0.1002 | 0.9181 |
| 550 | 0.0175 | 0.7848 | 0.0637 | 0.5825 | 0.1231 | 0.9320 |
| 560 | 0.0148 | 0.7089 | 0.0356 | 0.4649 | 0.1105 | 0.9351 |
| 570 | 0.0206 | 0.6093 | 0.0229 | 0.3506 | 0.1254 | 0.9331 |
| 580 | 0.2971 | 0.4937 | 0.0182 | 0.2524 | 0.3223 | 0.9328 |
| 590 | 0.7863 | 0.3658 | 0.0148 | 0.1502 | 0.6260 | 0.9322 |
| 600 | 0.8635 | 0.2329 | 0.0114 | 0.0788 | 0.8088 | 0.9428 |
| 610 | 0.8983 | 0.1398 | 0.0108 | 0.0328 | 0.9051 | 0.9512 |
| 620 | 0.9272 | 0.0936 | 0.0120 | 0.0175 | 0.9475 | 0.9625 |
| 630 | 0.9501 | 0.0763 | 0.0168 | 0.0195 | 0.9694 | 0.9704 |
| 640 | 0.9659 | 0.0684 | 0.0249 | 0.0488 | 0.9862 | 0.9739 |
| 650 | 0.9750 | 0.0639 | 0.0384 | 0.1217 | 0.9969 | 0.9800 |
| 660 | 0.9763 | 0.0678 | 0.0544 | 0.2180 | 1.0000 | 0.9828 |
| 670 | 0.9722 | 0.0889 | 0.0659 | 0.2444 | 1.0000 | 0.9834 |
| 680 | 0.9653 | 0.1269 | 0.0720 | 0.2634 | 1.0000 | 0.9820 |
| 690 | 0.9602 | 0.1790 | 0.0767 | 0.3517 | 1.0000 | 0.9792 |
| 700 | 0.9508 | 0.2399 | 0.0833 | 0.4294 | 1.0000 | 0.9731 |

Any filter that has transmission function values comparable to those given in the "R" column of Table III, we regard as a conventional, or normal, red filter. "Comparable" here means that the two arrays of transmission values, from 400-700 nm, when each array is normalized to have a peak value of 1.0, have a mean-squared error between them of less than 0.05. We likewise define filters whose transmission function values are comparable to those given in the G, B, C, M and Y columns of Table III to be normal (conventional) green, blue, cyan, magenta and yellow filters.

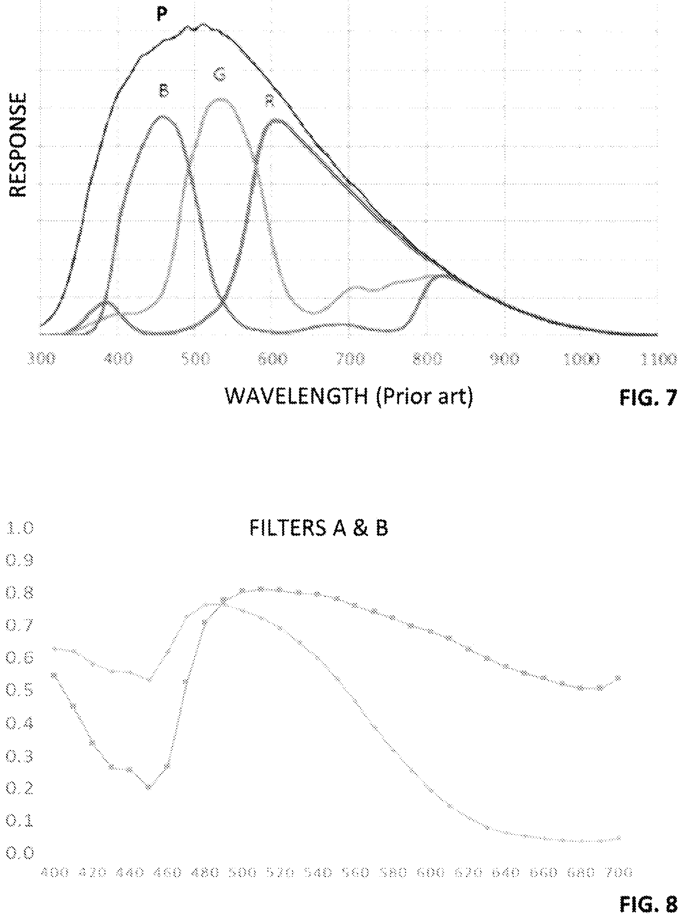

Again, the transmission functions being compared are pure filter transmission values, free of near infrared (NIR) or near ultraviolet (NUV) filtering, or silicon quantum efficiency shaping. Often curves are published depicting filter responses of a camera. Such curves, of course, are shaped by the spectral response of the camera sensor (usually silicon), and may also be shaped by NIR or NUV filtering. Fig. 7 (based on data published by Canon for its 35MMFHDXS family of camera sensors) illustrates the effect. The red, green and blue (R, G, B) filter curves are factored by the panchromatic (P) camera response curve, i.e., the silicon efficiency. Often the panchromatic curve is omitted in published data. A clue that color filters curves are factored by a panchromatic sensor response is that the green peak is higher than the red and/or blue peaks - due to the fall-off in silicon sensitivity at the red and blue ends of the visible spectrum. (The same caution applies to published cyan, magenta and yellow curves.)

Filters that are essentially flat across the 400-700 nm spectrum, i.e., varying less than +/- 3% of their mean transmission value over this spectrum, are regarded herein as normal (panchromatic) filters.

Color filter cells and arrays embodying aspects of the present technology can include normal red, green, blue, cyan, magenta, yellow and/or panchromatic filters. We term any filter that is not a normal red, green, blue, cyan, magenta, yellow or panchromatic filter a "non-normative" filter. Each of the filters described in Table I is a non-normative filter.

In one embodiment, some or all of the filters are chosen to be diverse. Diversity comes in many forms and can be characterized using many factors. Particular forms of diversity favored by applicant are detailed below.

### Dot Product

One factor by which diversity-of-spectral-responsivity-curves can be characterized is a dot product metric, also known as an inner product. A dot product metric is computed by multiplying corresponding pairs of transmission function values, taken from two filters, at each of multiple wavelengths, e.g., spaced 10 nm apart, and summing. Applicant prefers to compute the dot product metric at 10 nm intervals over the range of 400-700 nm, although other intervals and other ranges can be used. Group-normalized data, as in Table II, is used. In this example, the dot product metric between filters A and B is computed by summing the product of their respective transmission functions at 400 nm, with the product of their respective transmission functions at 410 nm, and so on, through 700 nm. That is: Dot Product Metric (A,B) = (.6521)(.5620) + (.6445)(.4670) + ... + (.0490)(.5556) = 11.2017.

Dot products often take the form of non-normalized dot products and normalized dot products. This disclosure discusses both; we use non-normalized dot products for the discussion immediately below.

Among nine filters, there are 36 different filter pairs, from which 36 dot product metrics can be computed. For the nine filters detailed in Table II, the 36 dot products are as shown in the following Table IV:

**TABLE IV**

| | |
|---|---|
| Dot Product (A,B) | 11.2017 |
| Dot Product (A,C) | 7.4138 |
| Dot Product (A,D) | 11.8953 |
| Dot Product (A,E) | 10.7040 |
| Dot Product (A,F) | 8.3633 |
| Dot Product (A,G) | 9.0906 |
| Dot Product (A,H) | 6.2516 |
| Dot Product (A,I) | 6.5677 |
| Dot Product (B,C) | 11.8575 |
| Dot Product (B,D) | 15.1875 |
| Dot Product (B,E) | 11.1637 |
| Dot Product (B,F) | 8.7811 |
| Dot Product (B,G) | 8.7356 |
| Dot Product (B,H) | 8.0841 |
| Dot Product (B,I) | 7.7657 |
| Dot Product (C,D) | 14.4975 |
| Dot Product (C,E) | 10.1914 |
| Dot Product (C,F) | 7.8913 |
| Dot Product (C,G) | 5.2827 |
| Dot Product (C,H) | 4.5230 |
| Dot Product (C,I) | 3.4899 |
| Dot Product (D,E) | 14.1320 |
| Dot Product (D,F) | 10.7395 |
| Dot Product (D,G) | 9.5199 |
| Dot Product (D,H) | 6.8433 |
| Dot Product (D,I) | 6.4599 |
| Dot Product (E,F) | 9.3118 |
| Dot Product (E,G) | 8.9080 |
| Dot Product (E,H) | 5.3791 |
| Dot Product (E,I) | 5.6475 |
| Dot Product (F,G) | 6.7284 |
| Dot Product (F,H) | 4.2840 |
| Dot Product (F,I) | 4.0955 |
| Dot Product (G,H) | 5.0106 |
| Dot Product (G,I) | 5.7712 |
| Dot Product (H,I) | 4.9302 |

In any given filter set, there will be some pairs of transmission functions that are more or less similar than other pairs of transmission functions. This is evident from the variation in dot products in Table IV. For example, these dot products range from a minimum value of 3.4899 to a maximum value of 15.1875. The maximum value is 4.35 times more than the minimum value. The average of all 36 dot products is 8.24; their standard deviation is 2.99.

Some examples comprise color filter cells characterized in that dot products computed between group-normalized transmission functions of all possible pairings of different filters in the cell, at 10 nm intervals from 400-700 nm, range from a minimum value, to a maximum value that is less than 5, or less than 4.5, times the minimum value.

Some examples comprise color filter cells characterized in that dot products computed between group-normalized transmission functions of all possible pairings of different filters in the cell, at 10 nm intervals from 400-700 nm, ranges from a minimum value, to a maximum value that is at least 3, at least 4, or at least 4.3 times the minimum value.

Some examples comprise color filter cells characterized in that a dot product computed between group-normalized transmission functions of two different filters in the cell, at 10 nm intervals from 400-700 nm, is less than 5, less than 4, or less than 3.5.

Some examples comprise color filter cells characterized in that a dot product computed between group-normalized transmission functions of two different filters in the cell, at 10 nm intervals from 400-700 nm, is at least 10, at least 12 or at least 15.

Some examples comprise color filter cells characterized in that a largest dot product computed between group-normalized transmission functions of all different filter pairings in the cell, at 10 nm intervals from 400-700 nm, is less than 17, less than 16 or less than 15.5.

Some examples comprise color filter cells characterized in that dot products computed between group-normalized transmission functions of all possible pairings of different filters in the cell, at 10 nm intervals from 400-700 nm, yield a set of values, and at least 10% of said values are less than 5.

Some examples comprise color filter cells characterized in that dot products computed between group-normalized transmission functions of all possible pairings of different filters in the cell, at 10 nm intervals from 400-700 nm, yield a set of values, and 20% or more, or 25% or more, of these values are less than 6.

Some examples comprise color filter cells characterized in that dot products computed between group-normalized transmission functions of all possible pairings of different filters in the cell, at 10 nm intervals from 400-700 nm, yield a set of values, and 40% or more of these values are less than 7.

Some examples comprise color filter cells characterized in that dot products computed between group-normalized transmission functions of all possible pairings of different filters in the cell, at 10 nm intervals from 400-700 nm, yield a set of values, and 20% or more, or 25% or more, of these values are at least 10.

Some examples comprise color filter cells characterized in that a set of dot products between group-normalized transmission functions of all different filters in the cell, at 10 nm intervals from 400-700 nm, has an average value of at least 6, at least 7, or at least than 8.

Some examples comprise color filter cells characterized in that a set of dot products between group-normalized transmission functions of all different filters in the cell, at 10 nm intervals from 400-700 nm, has an average value less than 10, less than 9, or less than 8.5.

Some examples comprise color filter cells characterized in that a set of dot products between group-normalized transmission functions of all different filters in the cell, at 10 nm intervals from 400-700 nm, has a standard deviation of at least 2.6, or of at least 2.9.

Some examples comprise color filter cells characterized in that a set of dot products between group-normalized transmission functions of all different filters in the cell, at 10 nm intervals from 400-700 nm, has a standard deviation less than 3.5, or less than 3.

Each of the just-detailed examples can be comprised partly or wholly of non-normative filters.

### Top-Code

Another metric that is useful in characterizing filter diversity is a so-called top-code. A top code is an array of numbers indicating which of two filters has the greater transmission value at each wavelength in a series of uniformly-increasing wavelengths. An exemplary top-code is a binary sequence, with a "1" indicating a first of the two filters has a greater transmission value at a particular wavelength, and a "0" indicating a second of the two filters has a greater transmission value at that wavelength. Again, we particularly consider the transmission function as sampled at 10 nm increments, between 400-700 nm.

Regarding the word 'code' and its variants such as 'coding', 'codebins', etc., this word forms an explicit connection between signal measurements represented by pixel data and classic 'coding theory'. Coding theory provides a helpful potent tool in dealing with what is often low-light, high noise measurement systems such as normal visible cameras being employed in very dark and dusk-like environments, including where the signal to noise ratio approaches 1 to 1 and even lower.

Referring to Table I, it is seen that filter A has a transmission value of .5500 at 380 nm and filter B has a transmission value of .7069. Thus, the first bit of the top-code(AB) starting at 380 nm is a "0." Filter A has a transmission value of .5886 at 390 nm and filter B has a transmission value of .6174, so the second bit of the top-code(AB) is also a "0." At 400 nm, Filter A switches to have a higher transmission function than filter B (i.e., .6288 vs .5420), so the third bit of the top-code(AB) is a "1." Continuing in this fashion through all 41 wavelength samples from 380 nm to 780 nm yields the complete top-code(A,B) for this range: $Top - code \left(A, B\right) = 00111111111000000000000000000000000000000$

Table V shows top-code values for all 36 pairings of the 9 filters in Table I, over the 380-780 nm wavelength range:

**TABLE V**

| | |
|---|---|
| (A,B) | 00111111111000000000000000000000000000000 |
| (A,C) | 00000011111111111111100000000000000000000 |
| (A,D) | 00000000001111111110000000000000000000000 |
| (A,E) | 00000000001111111111111111000000000000000 |
| (A,F) | 11000000111111111111100000000000000000000 |
| (A,G) | 11111110111000011111111111111111111111111 |
| (A,H) | 11111111111111100000000000000000000111111 |
| (A,I) | 11111111111100000011111111100000011111111 |
| (B,C) | 10000000011111111111111000000000000000000 |
| (B,D) | 00000000000111111111111111100000000000011 |
| (B,E) | 00000000000111111111111111111100000000111 |
| (B,F) | 11000000001111111111111111111111111111111 |
| (B,G) | 11110000000111111111111111111111111111111 |
| (B,H) | 11111111111111111111111111111111111111111 |
| (B,I) | 11111111111110111111111111111111111111111 |
| (C,D) | 00000000000000000000011111111111111111111 |
| (C,E) | 00000000000000000000111111111111111111111 |
| (C,F) | 11110000000000000000011111111111111111111 |
| (C,G) | 11111110000000000000111111111111111111111 |
| (C,H) | 11111111111000000000011111111111111111111 |
| (C,I) | 11111111110000000000111111111111111111111 |
| (D,E) | 00001111111111111111111111111111111111110 |
| (D,F) | 11111111111111111111111111111111111111111 |
| (D,G) | 11111111111000000111111111111111111111111 |
| (D,H) | 11111111111111000000011111111111111111111 |
| (D,I) | 11111111111100000011111111111111111111111 |
| (E,F) | 11111111111111111110000000001111111111111 |
| (E,G) | 11111111110000000001111111111111111111111 |
| (E,H) | 11111111111111000000000000001111111111111 |
| (E,I) | 11111111111000000000000111111111111111111 |
| (F,G) | 11111111000000000001111111111111111111111 |
| (F,H) | 11111111111100000000000001111111111111111 |
| (F,I) | 11111111111000000000111111111111111111111 |
| (G,H) | 00111111111111100000000000000000000000000 |
| (G,I) | 11111111111100000000000000000000000000000 |
| (H,I) | 11111111110000001111111111111110111111111 |

We can narrow the 380-780 nm spectral range of the top-codes of Table V by dropping bits at the beginning or end. For example, to produce top-codes for the spectral range 400-700 nm, we simply drop the first two bits, and the last eight bits, of each top code, changing the code lengths from 41 bits to 31 bits. Top-codes for the Table I filter set, from 400-700 nm, are shown in Table VI:

**TABLE VI**

| | |
|---|---|
| (A,B) | 1111111110000000000000000000000 |
| (A,C) | 0000111111111111111000000000000 |
| (A,D) | 0000000011111111100000000000000 |
| (A,E) | 0000000011111111111111110000000 |
| (A,F) | 0000001111111111111000000000000 |
| (A,G) | 1111101110000111111111111111111 |
| (A,H) | 1111111111111000000000000000000 |
| (A,I) | 1111111111000000111111111000000 |
| (B,C) | 0000000111111111111110000000000 |
| (B,D) | 0000000001111111111111111000000 |
| (B,E) | 0000000001111111111111111111000 |
| (B,F) | 0000000011111111111111111111111 |
| (B,G) | 1100000001111111111111111111111 |
| (B,H) | 1111111111111111111111111111111 |
| (B,I) | 1111111111101111111111111111111 |
| (C,D) | 0000000000000000000111111111111 |
| (C,E) | 0000000000000000001111111111111 |
| (C,F) | 1100000000000000000111111111111 |
| (C,G) | 1111100000000000001111111111111 |
| (C,H) | 1111111110000000000111111111111 |
| (C,I) | 1111111100000000001111111111111 |
| (D,E) | 0011111111111111111111111111111 |
| (D,F) | 1111111111111111111111111111111 |
| (D,G) | 1111111110000001111111111111111 |
| (D,H) | 1111111111110000000111111111111 |
| (D,I) | 1111111111000000111111111111111 |
| (E,F) | 1111111111111111100000000011111 |
| (E,G) | 1111111100000000011111111111111 |
| (E,H) | 1111111111110000000000000011111 |
| (E,I) | 1111111110000000000001111111111 |
| (F,G) | 1111110000000000011111111111111 |
| (F,H) | 1111111111000000000000011111111 |
| (F,I) | 1111111110000000001111111111111 |
| (G,H) | 1111111111111000000000000000000 |
| (G,I) | 1111111111000000000000000000000 |
| (H,I) | 1111111100000011111111111111101 |

### Crossing-Codes

Within any top-code string (a vector), a transition between "1" and "0" indicates that one of the two transmission function curves crosses the other. For example, in top-code(A,B) from Table VI, there is a transition from a "1" to a "0" at the tenth bit position, which corresponds to 490 nm. This indicates that the transmission function value of filter A drops below that of filter B somewhere between 480 and 490 nm. This can be seen in Fig. 8, which presents the transmission functions of filters A and B (shown individually in Figs. 6A and 6B), over the 400-700 nm range, in superimposed fashion. A transition from a "0" to a "1" signals that the first curve has risen above the second.

By stepping through the 31 bits of a top-code string, looking for transitions, we can derive a 30-bit string that signals curve crossings, which can be termed a crossing-code. For each successive pair of bits in the top-code string that have the same value ("1" or "0"), the crossing-code has a "0" value. When a transition occurs in the top-code string, the crossing-code has a "1" value.

Taking the 31-element top-code string (A,B) as an example, there is a single bit transition, from a "1" to a "0" at the tenth position. The corresponding 30-element crossing-code is thus all "0"s except a "1" at the ninth position, i.e.:
000000001000000000000000000000

Crossing-codes corresponding to the top-codes of Table VI are presented in Table VII:

**TABLE VII**

| | |
|---|---|
| (A,B) | 000000001000000000000000000000 |
| (A,C) | 000100000000000000100000000000 |
| (A,D) | 000000010000000010000000000000 |
| (A,E) | 000000010000000000000001000000 |
| (A,F) | 000001000000000000100000000000 |
| (A,G) | 000011001000100000000000000000 |
| (A,H) | 000000000000100000000000000000 |
| (A,I) | 000000000100000100000000100000 |
| (B,C) | 000000100000000000001000000000 |
| (B,D) | 000000001000000000000000100000 |
| (B,E) | 000000001000000000000000000100 |
| (B,F) | 000000010000000000000000000000 |
| (B,G) | 010000001000000000000000000000 |
| (B,H) | 000000000000000000000000000000 |
| (B,I) | 000000000011000000000000000000 |
| (C,D) | 000000000000000000100000000000 |
| (C,E) | 000000000000000001000000000000 |
| (C,F) | 010000000000000000100000000000 |
| (C,G) | 000010000000000001000000000000 |
| (C,H) | 000000001000000000100000000000 |
| (C,I) | 000000010000000001000000000000 |
| (D,E) | 010000000000000000000000000000 |
| (D,F) | 000000000000000000000000000000 |
| (D,G) | 000000001000001000000000000000 |
| (D,H) | 000000000001000000100000000000 |
| (D,I) | 000000000100000100000000000000 |
| (E,F) | 000000000000000010000000010000 |
| (E,G) | 000000010000000010000000000000 |
| (E,H) | 000000000001000000000000010000 |
| (E,I) | 000000001000000000001000000000 |
| (F,G) | 000001000000000010000000000000 |
| (F,H) | 000000000100000000000010000000 |
| (F,I) | 000000001000000001000000000000 |
| (G,H) | 000000000000100000000000000000 |
| (G,I) | 000000000100000000000000000000 |
| (H,I) | 000000010000010000000000000011 |

The number of "1"s in each string indicates the number of crossings of the two curves. For example, crossing-code (A,G) includes four "1"s, indicating these curves cross each other four times. So do curves H and I.

Some examples comprise color filter cells characterized in that plural pairs of filter spectral transmission curves, defined by samples at 10 nm intervals from 400-700 nm, cross each other at least four times.

Some examples comprise color filter cells characterized in that plural pairs of filter transmission curves, defined by samples at 10 nm intervals from 400-700 nm, cross each other exactly once, or exactly zero times.

As before, each of the just-detailed examples can be comprised partly or wholly of non-normative filters.

### Crossing-Code Histograms

By summing corresponding crossing-code bit position values for all 36 crossing-codes, we can determine the number of curve crossings in each wavelength band. For example, in the first bit position, all the values in all 36 cross-codes are "0." Thus, none of the filter transmission function curves crosses another in the 400-410 nm band. The 36 crossing codes have a total of three "1"s in the second bit position (410-420 nm), indicating crossings between three pairs of curves (namely the (B,G), (C,F) and (D,E) curve pairs). The full set of such data is shown in Table VIII:

**TABLE VIII**

| | |
|---|---|
| 400-410 | 0 |
| 410-420 | 3 |
| 420-430 | 0 |
| 430-440 | 1 |
| 440-450 | 2 |
| 450-460 | 3 |
| 460-470 | 1 |
| 470-480 | 6 |
| 480-490 | 9 |
| 490-500 | 4 |
| 500-510 | 1 |
| 510-520 | 3 |
| 520-530 | 3 |
| 530-540 | 1 |
| 540-550 | 1 |
| 550-560 | 2 |
| 560-570 | 4 |
| 570-580 | 4 |
| 580-590 | 6 |
| 590-600 | 0 |
| 600-610 | 2 |
| 610-620 | 0 |
| 620-630 | 1 |
| 630-640 | 1 |
| 640-650 | 2 |
| 650-660 | 2 |
| 660-670 | 0 |
| 670-680 | 1 |
| 680-690 | 1 |
| 690-700 | 1 |

This vector, or set, of data elements serves as a histogram of curve crossings, for the 30 wavelength bands. It can be termed a crossing-histogram. Among the set of data elements in this crossing-histogram, the average value is 2.17 and the standard deviation is 2.05. The crossing-histogram has no adjacent 10 nm wavelength bands for which the count of curve crossings is both zero. That is, within every 20 nm range identified in Table VIII, transmission function curves for at least one pair of filters cross each other.

Some examples comprise color filter cells including three or more different filters, each with an associated transmission curve, said filters being characterized in that a count of crossings between all pairs of said curves, in each of thirty 10 nm bands between 400-700 nm, yields a vector of 30 count values, the average value of which is at least 2.

Some examples comprise color filter cells including three or more different filters, each with an associated transmission curve, said filters being characterized in that a count of crossings between all pairs of said curves, in each of thirty 10 nm bands between 400-700 nm, yields a vector of 30 count values, the standard deviation of which is at least 2.

Some examples comprise color filter cells including three or more different filters, each with an associated transmission curve, said filters being characterized in that a count of crossings between all pairs of said curves, in each of thirty 10 nm bands between 400-700 nm, yields a vector of 30 count values, and one or more of said count values has a value of at least 6, or at least 8, or at least 9.

Some examples comprise color filter cells including three or more different filters, each with an associated transmission curve, said filters being characterized in that a count of crossings between all pairs of said curves, in each of thirty 10 nm bands between 400-700 nm, yields a vector of 30 count values, and no two consecutive count values in said vector are both equal to zero.

As before, each of the just-detailed examples can be comprised partly or wholly of non-normative filters.

### Hamming Distances

The difference between two crossing-codes can be indicated by a so-called Hamming distance between their bit strings. A Hamming distance between two strings of equal length is the number of positions at which the corresponding bits are different. Although Hamming distance is used in various disciplines, applicant is unaware of its use in connection with component filters of color filter arrays of color image sensors.

The Hamming distance between crossing-code (A,B) and crossing code (A,C) is determined by comparing their strings and counting the number of bit positions where they are different. From Table VII: $Crossing - code \left(A, B\right) = 000000001000000000000000000000$ $Crossing - code \left(A, C\right) = 000100000000000000100000000000$

It will be seen these two strings are different at three bit positions. So, the Hamming distance between crossing-code (A,B), and crossing-code (A,C) is 3.

Referring back to Table VII, the 9 different filters can be paired in 36 different ways to yield this set of 36 crossing-codes. That is, Filter A can be compared with 8 others (B-I), and Filter B can be compared with 7 others (C-I), and Filter C can be compared with 6 others (D-I), and so on, until Filter H can be compared with only 1 other (I). The number of such paired combinations between 9 items is sometimes termed 9-summatorial (i.e., 8+7+6...+1 = 36.)

In computing Hamming distances, the 36 crossing-codes of Table VII can be paired in 36-summatorial ways. That is, there are 630 Hamming distances between the 36 crossing-codes of Table VII. 630 values are too many to list here. Suffice it to say the values range from 0 to 8, with an average value of 3.29, and a standard deviation of 1.23.

There are actually three Hamming distances of 0 in the set of 630 values. Between crossing-codes [(A,D) and (E,G)]; between crossing-codes [(A,H) and (G,H)]; and between crossing-codes [(B,H) and (D,F)]. Inspection of Table VII shows each of these pairs of 30-bit crossing-code strings are identical. The latter of these pairings might be termed trivial - the two crossing-codes are all zeroes. The other two pairs, however, are non-trivial. In particular, the first pairing includes three "1"s in each crossing-code, and the second includes one "1" in each crossing code.

The Hamming distance of 8 is between crossing-code (A,G) and crossing-code (H,I). There are 2 Hamming distances of 7 among the 630 values.

Some examples comprise color filter cells characterized in that multiple Hamming distances between all possible crossing-codes defined between different filters in the cell have values of zero. One or more of these Hamming distances of zero can involve crossing-codes that are not all zero. At least one of these Hamming distances of zero can involve crossing-codes including at least three "1"s.

Some examples comprise color filter cells characterized in that multiple Hamming distances between all possible crossing-codes defined between different filters in the cell have values of 5 or more, or 7 or more.

Some examples comprise color filter cells characterized in that an average Hamming distance between all possible crossing-codes defined between different filters in the cell is at least 3.

Some examples comprise color filter cells characterized in that a standard deviation of all Hamming distances between all possible crossing-codes defined between different filters in the cell is at least 1.2.

Some examples comprise color filter cells characterized in that a standard deviation of all Hamming distances between all possible crossing-codes defined between different filters in the cell is less than 1.25.

As before, each of the just-detailed examples can be comprised partly or wholly of non-normative filters.

### Efficiency

Another metric that is relevant to filter diversity is efficiency. Efficiency of a filter, over a given spectrum, can be approximated as the average of transmission function values at uniform spacings across the spectrum. Taking as an example Filter "A" in Table I, the sum of the 31 transmission functions in the range of 400-700 nm (i.e., .6288 + .6214 + ... + .0473), when divided by 31, indicates an efficiency of 0.43, or 43%. The efficiencies of the nine filters "A"-"I" detailed in Table I are given in Table IX:

**TABLE IX**

| Filter | Efficiency |
|---|---|
| A | 0.4064 |
| B | 0.5927 |
| C | 0.5057 |
| D | 0.6566 |
| E | 0.4731 |
| F | 0.3729 |
| G | 0.3305 |
| H | 0.2736 |
| I | 0.2445 |

Some examples comprise color filter cells characterized in that the average efficiency across all non-normative filters in the cell is at least 40%. In some such embodiments the average efficiency of all non-normative filters is at least 50%, or at least 60%, or at least 70%.

The efficiencies of individual filters within a cell can vary substantially. In Table IX the efficiencies vary from less than 25% to more than 65%. That is, one filter has an efficiency that is more than 2.65 times the efficiency of a second filter in the cell.

Some examples comprise color filter cells characterized by including a first non-normative filter that has an efficiency at least 2.0 times, or at least 2.5 times, the efficiency of a second non-normative filter in the cell.

Some examples comprise color filter cells characterized in that at least a third of plural different non-normative filters in the cell have efficiencies of at least 50%.

There is something of a balancing act involving efficiency and diversity. High efficiency can be achieved by each of the filters having a transmission function that stays near 100%. This would yield an efficiency of near 100%, but would provide relatively little diversity. On the other hand, high diversity can be aided by filter curves that swing across the full range of possible values, sometimes running above 0.9, and sometimes dropping below 0.1. But these latter filters tend to have relatively less efficiency, reducing overall imager sensitivity.

Some examples comprise color filter cells characterized as including at least one non-normative filter having a group-normalized transmission function that stays above 0.4 in the 400-700 nm wavelength range.

Some examples comprise color filter cells characterized as including one or more non-normative filters having group-normalized transmission functions that stay above 0.2 in the 400-700 nm wavelength range.

Some examples comprise color filter cells characterized as including at least one filter having a group-normalized transmission function that stays below 0.7 from 400-700 nm.

Some examples comprise color filter cells characterized as including plural filters having group-normalized transmission functions that stay below 0.75 from 400-700 nm.

Some examples comprise color filter cells characterized as including three filters having group-normalized transmission functions that stay below 0.8 from 400-700 nm.

As before, each of the just-detailed examples can be comprised partly or wholly of non-normative filters.

### Correlation

Another metric that is useful in characterizing filter diversity is sample correlation coefficient. Given two arrays of n filter transmission function sample values, x and y (e.g., the 31 values for filters A and B detailed in Table I), the sample correlation coefficient r (hereafter simply "correlation") is computed as: $\frac{{\sum }_{i = 1}^{n} \left({x}_{i}-\overline{x}\right) \left({y}_{i}-\overline{y}\right)}{\sqrt{{\sum }_{i = 1}^{n} {\left({x}_{i}-\overline{x}\right)}^{2} {\sum }_{i = 1}^{n} {\left({y}_{i}-\overline{y}\right)}^{2}}}$

The correlations between different pairs of Filters A-I, over the 400-700 nm wavelength range, are detailed in Table X:

**TABLE X**

| FILTERS | CORRELATION |
|---|---|
| (A,B) | 0.6597 |
| (A,C) | 0.0256 |
| (A,D) | 0.6790 |
| (A,E) | 0.8012 |
| (A,F) | 0.8543 |
| (A,G) | 0.9668 |
| (A,H) | 0.6620 |
| (A,I) | 0.6941 |
| (B,C) | 0.4401 |
| (B,D) | 0.7340 |
| (B,E) | 0.5130 |
| (B,F) | 0.5511 |
| (B,G) | 0.5740 |
| (B,H) | 0.8462 |
| (B,I) | 0.7306 |
| (C,D) | 0.7112 |
| (C,E) | 0.3910 |
| (C,F) | 0.4082 |
| (C,G) | -0.0654 |
| (C,H) | -0.0278 |
| (C,I) | -0.1889 |
| (D,E) | 0.8797 |
| (D,F) | 0.8641 |
| (D,G) | 0.6229 |
| (D,H) | 0.4082 |
| (D,I) | 0.3549 |
| (E,F) | 0.9344 |
| (E,G) | 0.7814 |
| (E,H) | 0.3112 |
| (E,I) | 0.3735 |
| (F,G) | 0.7804 |
| (F,H) | 0.3697 |
| (F,I) | 0.3148 |
| (G,H) | 0.5950 |
| (G,I) | 0.7351 |
| (H,I) | 0.8609 |

Some examples comprise color filter cells characterized in that a correlation computed between transmission functions of two different filters in the cell, at least one of which is non-normative, at 10 nm intervals from 400-700 nm, is negative.

Some examples comprise color filter cells characterized in that a correlation computed between transmission functions of two different filters in the cell, at 10 nm intervals from 400-700 nm, is at least 0.8, at least 0.9 or at least 0.95.

Some examples comprise color filter cells characterized in that correlations computed between transmission functions of all possible pairings of different filters in the cell, at 10 nm intervals from 400-700 nm, yield a set of values, and at least a quarter of these values are at least 0.75. In another example, such condition holds for all possible pairings of different non-normative filters in the cell.

The average of the correlation values in Table X is 0.5596. The standard deviation is 0.2885. 11 of the 36 table entries have values within one standard deviation below the mean (i.e., between 0.2712 and 0.5596). 14 have values within one standard deviation above the mean (i.e., between 0.5596 and 0.8308).

Some examples comprise color filter cells characterized in that correlations computed between group-normalized transmission functions of all possible pairings of different filters in the cell, at 10 nm intervals from 400-700 nm, yield a set of values, and a first count of correlation values that are within one standard deviation above a mean of all values in the set, differs from a second count of correlation values that are within one standard deviation below the mean, by more than 25% of a smaller of the first and second counts.

### Transmission Curve Slopes, Extrema

Other metrics that are useful in characterizing filter diversity concern the shapes of local maxima and minima (extrema) in the transmission functions, as indicated by the slopes of the transmission curves leading into and out of such extrema. As a general principle, slopes in individual spectral responsivity functions give rise to discrimination of color/spectra in higher dimensional spectral data space, such as the data space of 9-dimensions in a 3x3, nine channel sensor. Each value derived by the sensor defines one dimension in that 9-dimensional space. Thus, when one of the data values of a pixel changes rapidly as one changes the spectral content of what it is sensing, this gives rise to a slope in this 9-dimensional space as well. When one pixel is moving in one direction in this 9-dimensional space, and another pixel is moving in the opposite direction given the same movement in sensed-spectra, the result is spectral discrimination produced by this pair of pixels. Thus, 'opposite slopes' of pairwise pixels also becomes a useful diversification metric.

The qualifier "local" indicates a spectral transmission function extremum within a threshold-sized neighborhood of wavelengths. An exemplary neighborhood spans 60 nm, i.e., 30 nm plus and minus from a central wavelength. To make this clear, we sometimes refer to a local maximum or minimum as, e.g., a 60 nm-span local maximum or minimum.

To avoid small noise artifacts in measured transmission functions being mistaken as local maxima, in the following discussion we regard a feature in a filter's transmission function curve to be a local maximum only if its group-normalized value is 0.05 higher than another transmission function value within a 60 nm neighborhood centered on the feature. Similarly for a minimum - it must have a value that is 0.05 lower than another transmission function value within a 60 nm neighborhood. If the transmission function is at a high or low value at either end of the curve (as is the case, e.g., at the left edge of Fig. 6A), we don't know what lies beyond, so we don't term it a local maxima or minima for purposes of the present discussion.

We regard a local maximum as "broad" if its transmission function drops less than 25%, from its maximum value, within a 40 nm spectrum centered on the maximum wavelength (sampled at 10 nm intervals). That is, the maximum is broad-topped. Relatedly for notches; we regard a notch as broad if its transmission function value at the bottom of the notch is less than 25% beneath the largest transmission function value within a 40 nm spectrum centered on the notch wavelength.

The opposite of a broad-extrema is a narrow-extrema, which again applies to both local maxima and local minima. That is, we regard a local maximum as "narrow" if its transmission function drops more than 25%, from its uppermost value (at 10 nm intervals), within a 40 nm spectrum centered on the wavelength of the maximum. That is, the maximum is narrow-topped. Relatedly for local minima; we regard a minimum as narrow if its transmission function value at the bottom is more than 25% beneath the largest value within a 40 nm spectrum centered on the notch wavelength.

Table I, and the curves of Figs. 6A-6I, give examples. A broad local maximum is found at 490 nm in Filter A. Its maximum drop from its top value, within +/-20 nm of the top wavelength, is just 5.5% (i.e., from .767 at the top to .725 at 470 nm). There are a total of seven broad local maxima among the nine Filters A-I. There is no narrow local maximum among these filters.

A broad local minimum is found at 590 nm in Filter D (Fig. 6D). Its notch is just 19% below the largest value found within 20 nm (i.e., the transmission function at 590 nm is 0.400, and the largest value in the 40 nm window is 0.493 at 610 nm). This is the only broad local minimum in the detailed set of nine filters. Other transmission functions that, at first glance, appear broad, do not technically fall within the given definition because a steep skirt is within a 40 nm centered window and raises the transmission function value high enough that the minima is more than 25% lower. See, e.g., the minimum at 640 nm in Fig. 6E. This is not a broad notch under the given definition because its value (.07060) is more than 25% below the .1827 value found at 660 nm.

The foregoing highlights the fact that the defined narrow/broad extrema distinction, in large part, concerns the slope of the filter curve near the extrema. A 60 nm-span extremum that is adjacent a steep slope is regarded as a narrow extremum, while a 60 nm-span extremum that is adjacent only gradual slopes is regarded as a broad extremum.

A narrow local minimum is found at 450 nm in Filter B. Its notch is 61.2% lower than another transmission function value within a centered 40 nm window (i.e., .203 vs .524). There are seven narrow local minima in the detailed set of filters (including the just-discussed minimum in Fig. 6E).

Some examples comprise color filter cells characterized in that a count of narrow 60 nm-span local minima exceeds a count of narrow 60 nm-span local maxima. Some such embodiments are characterized in that the count of narrow 60 nm-span local minima is at least 150%, at least 200%, at least 300% or at least 400% of the count of 60 nm-span local narrow maxima.

Some examples comprise color filter cells characterized in that a count of narrow 60 nm-span local minima exceeds a count of broad 60 nm-span local minima. Some such embodiments are characterized in that the count of narrow 60 nm-span local minima is at least 150%, at least 200%, at least 300% or at least 400% of the count of broad 60 nm-span local minima. Some such embodiments are characterized in that the count of narrow 60 nm-span local minima is at least seven times the count of broad 60 nm-span local minima.

Some examples comprise color filter cells characterized in that a count of broad 60 nm-span local maxima exceeds a count of narrow 60 nm-span local maxima. Some such embodiments are characterized in that the count of broad 60 nm-span local maxima is at least 150%, at least 200%, at least 300% or at least 400% of the count of narrow 60 nm-span local maxima.

Some examples comprise color filter cells characterized in that a count of broad 60 nm-span local maxima exceeds a count of broad 60 nm-span local minima. Some such embodiments are characterized in that the count of broad 60 nm-span local maxima is at least 150%, at least 200%, at least 300% or at least 400% of the count of broad 60 nm-span local minima. Some such embodiments are characterized in that the count of broad 60 nm-span local maxima is at least seven times the count of broad 60 nm-span local minima.

In some other examples, none of the criteria of the preceding four paragraphs is met.

Some examples comprise color filter cells characterized in that one or more non-normative filters in the cell comprises a 60 nm-span local maximum between 430 and 670 nm, and is broad-topped (i.e., with a transmission function drop of 25% or less from the 60 nm-span local maximum over +/- 20 nm from the 60 nm-span local maximum.

Some examples comprise color filter cells characterized in that one or more non-normative filters in the cell include a 60 nm-span local maximum between 430 and 670 nm, and most of said N filters are broad-topped.

Some examples comprise color filter cells characterized in that a plurality of non-normative filters in the cell include a 60 nm-span local maximum between 430 and 670 nm, and all of said plurality of filters have a transmission function drop of less than 50% relative to transmission value at the local maximum, over +/- 20 nm from the maximum).

Some examples comprise color filter cells characterized in that one or more non-normative filters in the cell have a transmission function that includes exactly one 60 nm-span local maximum.

Some examples comprise color filter cells characterized in that one or more non-normative filters in the cell have a transmission function that includes no 60 nm-span local maximum.

Some examples comprise color filter cells characterized in that one or more non-normative filters in the cell has a transmission function that includes exactly one 60 nm-span local minimum.

Some examples comprise color filter cells characterized in that one or more non-normative filters in the cell has a transmission function that includes no 60 nm-span local minimum.

Some examples comprise color filter cells characterized in that one or more non-normative filters in the cell has a transmission function that includes exactly one 60 nm-span local minimum and no 60 nm-span local maximum.

Some examples comprise color filter cells characterized in that one or more non-normative filters in the cell has a transmission function that includes exactly one 60 nm-span local maximum and no 60 nm-span local minimum.

Some examples comprise color filter cells characterized in that one or more non-normative filters in the cell has a transmission function that includes exactly one 60 nm-span local maximum and one 60 nm-span local minimum.

Some examples comprise color filter cells with plural different non-normative filters, characterized in that a count of broad maxima among said non-normative filters is greater than a count of broad minima among said non-normative filters.

Some examples comprise color filter cells with plural different non-normative filters, characterized in that a count of narrow minima among said non-normative filters is greater than a count of narrow maxima among said non-normative filters.

As noted, the slopes of the filter curves that connect to extrema can vary. Diversity can be aided by diversity in the slopes of the transmission curves.

We define the slope of a curve as the change in group-normalized transmission over a span of 10 nm (i.e., from 400 to 410 nm, 410 to 420 nm, etc.). Although determined over a 10 nm interval, the slope is expressed in units of per-nanometer. For example, between 690 and 700 nm, the group-normalized transmission value of Filter A changes from .0403 to .0490, or a difference of .0087 over a span of 10 nm. It thus has a slope of .00087/nm. Slopes can be positive or negative, depending on whether a curve ascends or descends with increasing wavelength.

Table XI gives the slopes of Filters "A" - "I" described in Table II:

**TABLE XI**

| SLOPES | A | B | C | D | E | F | G | H | I |
|---|---|---|---|---|---|---|---|---|---|
| 400-410 | -.0008 | -.0095 | -.0031 | .0024 | .0017 | .0038 | .0066 | -.0051 | -.0025 |
| 410-420 | -.0041 | -.0115 | -.0034 | .0025 | -.0011 | .0034 | .0019 | -.0028 | -.0007 |
| 420-430 | -.0024 | -.0078 | -.0071 | .0021 | -.0012 | .0011 | .0026 | -.0010 | -.0003 |
| 430-440 | -.0003 | -.0009 | -.0073 | -.0010 | -.0001 | -.0034 | .0034 | .0004 | -.0001 |
| 440-450 | -.0026 | -.0056 | -.0068 | .0000 | -.0016 | -.0036 | .0050 | .0004 | .0004 |
| 450-460 | .0092 | .0066 | -.0072 | -.0014 | -.0006 | -.0037 | .0086 | .0023 | .0011 |
| 460-470 | .0113 | .0266 | -.0082 | -.0021 | -.0025 | -.0040 | .0085 | .0034 | .0104 |
| 470-480 | .0039 | .0192 | -.0089 | -.0039 | -.0022 | -.0064 | .0053 | .0061 | .0328 |
| 480-490 | .0001 | .0073 | -.0070 | -.0029 | -.0027 | -.0051 | .0024 | .0105 | .0284 |
| 490-500 | -.0020 | .0026 | -.0051 | -.0050 | -.0048 | -.0038 | -.0001 | .0126 | .0088 |
| 500-510 | -.0023 | .0008 | -.0033 | -.0045 | -.0055 | -.0047 | -.0020 | .0130 | .0016 |
| 510-520 | -.0033 | -.0004 | -.0017 | -.0042 | -.0061 | -.0051 | -.0044 | .0079 | -.0031 |
| 520-530 | -.0046 | -.0008 | -.0006 | -.0052 | -.0080 | -.0019 | -.0082 | .0044 | -.0063 |
| 530-540 | -.0050 | -.0004 | .0001 | -.0051 | -.0086 | .0005 | -.0097 | -.0003 | -.0077 |
| 540-550 | -.0068 | -.0013 | .0007 | -.0028 | -.0075 | -.0026 | -.0129 | -.0034 | -.0118 |
| 550-560 | -.0072 | -.0024 | .0021 | -.0009 | -.0057 | -.0041 | -.0131 | -.0054 | -.0134 |
| 560-570 | -.0079 | -.0020 | .0066 | -.0027 | -.0060 | -.0005 | -.0107 | -.0069 | -.0120 |
| 570-580 | -.0073 | -.0020 | .0146 | -.0033 | -.0057 | .0020 | -.0070 | -.0073 | -.0086 |
| 580-590 | -.0064 | -.0025 | .0196 | -.0004 | -.0038 | -.0004 | -.0036 | -.0069 | -.0054 |
| 590-600 | -.0065 | -.0018 | .0210 | .0046 | -.0012 | -.0028 | -.0030 | -.0061 | -.0045 |
| 600-610 | -.0049 | -.0024 | .0147 | .0051 | .0003 | -.0031 | -.0018 | -.0062 | -.0033 |
| 610-620 | -.0039 | -.0031 | .0080 | .0022 | -.0010 | -.0021 | -.0008 | -.0063 | -.0016 |
| 620-630 | -.0031 | -.0031 | .0042 | .0004 | -.0017 | -.0013 | -.0005 | -.0050 | -.0008 |
| 630-640 | -.0018 | -.0028 | .0020 | .0026 | -.0008 | -.0012 | -.0001 | -.0026 | -.0001 |
| 640-650 | -.0010 | -.0021 | .0015 | .0076 | .0024 | -.0013 | .0003 | -.0012 | .0010 |
| 650-660 | -.0009 | -.0017 | .0006 | .0099 | .0092 | -.0006 | .0008 | -.0010 | .0020 |
| 660-670 | -.0005 | -.0017 | .0006 | .0074 | .0177 | .0010 | .0000 | -.0013 | .0001 |
| 670-680 | -.0002 | -.0012 | .0004 | .0059 | .0203 | .0042 | -.0004 | -.0013 | -.0008 |
| 680-690 | .0000 | -.0001 | .0001 | .0033 | .0164 | .0084 | .0000 | -.0005 | .0001 |
| 690-700 | .0009 | .0030 | -.0002 | .0019 | .0093 | .0120 | -.0006 | .0007 | -.0014 |

Some examples comprise color filter cells including at least one non-normative filter, characterized in that slopes of all group-normalized filter transmission functions, when computed over 10 nm intervals between 400-700 nm, yield a set of values, and at least 60% of the values are negative.

The filter curves can also be characterized, in part, by absolute values of the slopes.

Some examples comprise color filter cells including at least one non-normative filter, characterized in that the absolute value slopes of all group-normalized filter transmission functions of non-normative filters, when computed over 10 nm intervals between 400-700 nm, yield a set of values, and at least 50% of the values are less than 0.01/nm or less than 0.005/nm.

Some examples comprise color filter cells including at least one non-normative filter, characterized in that the absolute value slopes of all group-normalized filter transmission functions of non-normative filters, when computed over 10 nm intervals between 400-700 nm, yield a set of values, and at least 20% of the values are less than 0.001/nm.

In characterizing diversity of a filter set, it is sometimes useful to categorize the state of a transmission curve in a particular region into one of three classifications: (1) in a neighborhood of a peak, (2) in a neighborhood of a valley, or (3) in-between neighborhoods.

Peaks and valleys can be the 60 nm-span local maxima and minima as defined earlier. The neighborhood of a peak can comprise those points (sampled at 10 nm intervals) whose transmission values are within 0.15 of the local maximum value. The neighborhood of a valley can comprise those points (sampled at 10 nm intervals) whose transmission values are within 0.15 of the local minimum value.

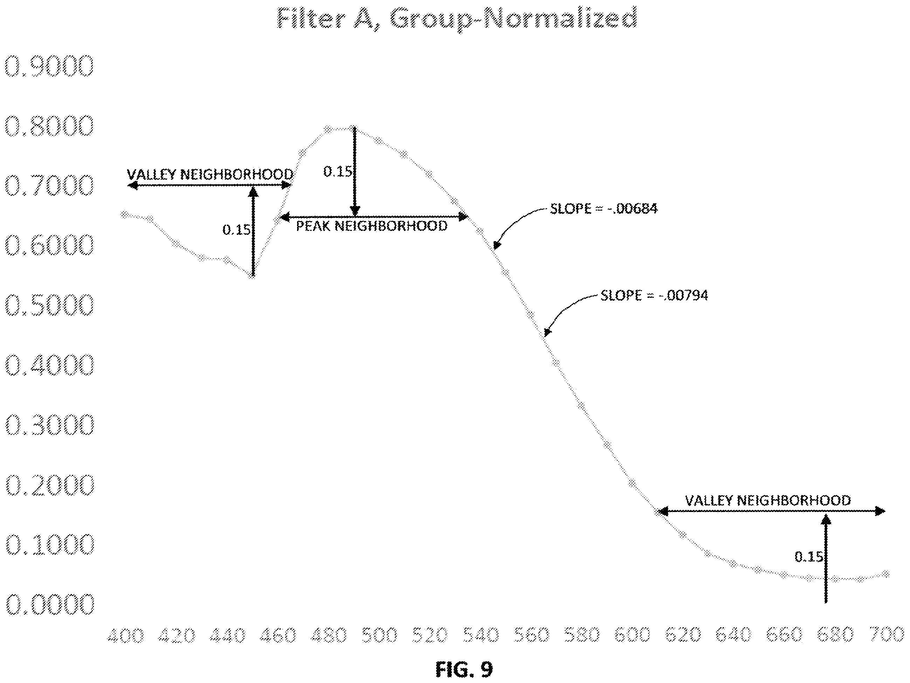

Fig. 9 shows the transmission function curve for filter A, after group-normalization. (Comparison to Fig. 6A shows the same curve shape, but the values in Fig. 9 have been scaled so that one filter in the set, in this case filter C, reaches a peak value of 1.0.) There is a valley at 450 nm, having a value of 0.5497, per Table II. An associated valley neighborhood includes the Filter A transmission function values at 400, 410, 420, 430, 440, 450 and 460 nm, because each of these values is within 0.15 of .5497.

Similarly, there is a peak at 490 nm, having a value of .7952. An associated peak neighborhood includes the Filter A transmission function values at 470, 480, 490, 500, 510, 520 and 530 nm, because their values are each within 0.15 of .7952. As may be appreciated, peak and valley neighborhoods may in some instances overlap.

Recall that a 60 nm-span local extrema is defined by reference to a 60 nm-wide neighborhood, i.e., plus and minus 30 nm from a center wavelength. Since transmission function data beyond the range 400-700 nm is sometimes unavailable, local extrema are typically defined starting at 430 nm and ending at 670 nm.

To the right side of Fig. 9 there is a second valley and a second valley neighborhood. The filter curve is shown to have transmission function local minimum value of .0403 at 690 nm. It is unknown whether this value fits the definition of a 60 nm-span local minimum (i.e., a valley) because it is unknown if the curve goes still lower, e.g., at 710 nm or 720 nm. Nonetheless, 620, 630, 640, 650, 660, 670, 680, 690 and 700 nm can all be identified as falling within a valley neighborhood, because all have group-normalized values below 0.15. That is, regardless of the transmission function value at 710 nm or 720 nm, it is known that such values will be at least 0, so the just-named wavelengths, with values of 0.15 or below, will necessarily be within 0.15 of the minimum transmission value. Thus, valley neighborhoods can sometimes be identified without being able to identify a particular valley (i.e., a 60 nm-span minimum). The same applies for peak neighborhoods. That is, any transmission function sample having a group-normalized value of 0.85 or above is necessarily within a peak neighborhood.

Applying these definitions of peak and valley neighborhoods to the group-adjusted filter transmission data of Table II, we can identify which filter functions are at which type of neighborhood at which wavelengths. This information is expressed in Table XII by the "MAX" and "MIN" notations:

**TABLE XII**

| | A | B | C | D | E | F | G | H | I |
|---|---|---|---|---|---|---|---|---|---|
| 430 | MIN | MIN | | MAX | | MAX | | MIN | MIN |
| 440 | MIN | MIN | | MAX | | MAX | | MIN | MIN |
| 450 | MIN | MIN | | MAX | | MAX | | MIN | MIN |
| 460 | MIN | MIN | | MAX | | MAX | MAX | MIN | MIN |
| 470 | MAX | | | MAX | | MAX | MAX | MIN | MIN |
| 480 | MAX | MAX | | MAX | | | MAX | MIN | |
| 490 | MAX | MAX | MIN | MAX | | | MAX | | MAX |
| 500 | MAX | MAX | MIN | MAX | | | MAX | | MAX |
| 510 | MAX | MAX | MIN | | | | MAX | MAX | MAX |
| 520 | MAX | MAX | MIN | | | | MAX | MAX | MAX |
| 530 | MAX | MAX | MIN | | | | MAX | MAX | MAX |
| 540 | MAX | MAX | MIN | MIN | | | | MAX | MAX |
| 550 | | MAX | MIN | MIN | | | | MAX | |
| 560 | | MAX | MIN | MIN | | MIN | | MAX | |
| 570 | | MAX | MIN | MIN | MIN | MIN | | MAX | |
| 580 | | MAX | | MIN | MIN | MIN | MIN | | |
| 590 | | MAX | | MIN | MIN | MIN | MIN | | |
| 600 | | MAX | | MIN | MIN | MIN | MIN | | MIN |
| 610 | | MAX | | MIN | MIN | MIN | MIN | | MIN |
| 620 | MIN | | MAX | MIN | MIN | MIN | MIN | | MIN |
| 630 | MIN | | MAX | MIN | MIN | MIN | MIN | | MIN |
| 640 | MIN | | MAX | | MIN | MIN | MIN | MIN | MIN |
| 650 | MIN | | MAX | | MIN | MIN | MIN | MIN | MIN |
| 660 | MIN | | MAX | MAX | MIN | MIN | MIN | MIN | MIN |
| 670 | MIN | | MAX | MAX | | MIN | MIN | MIN | MIN |

The blank areas in the above table correspond to regions of the filter curves that are neither near peaks nor valleys. ("Near," as used herein, means within 0.15, based on group-normalized filter transmission values.) As noted, these regions in-between peak neighborhoods and valley neighborhoods comprises the third class of transmission function regions. In these intermediate regions, each "third class" 10 nm wavelength span is characterized by a slope value which, as detailed in Table XI, can be positive or negative.

In one nine-filter example that includes more than three different filters, at each of at least 16 of the 24 10 nm wavelength bands between 430 and 670 nm, a first group of 1-5 filters are all at or near local extrema, a second group of 1-5 filters all have positive slopes, and a third group of 1-5 filters all have negative slopes.

In the second and third groups, the magnitudes of the slopes desirably include a variety of values, e.g., commonly in the range of 0.001/nm to 0.1/nm. For example, in a band between 470-480 nm, filters in the second group have slopes of 0.019/nm and .033/nm (i.e., Filters B and I), and filters in the third group have slopes of -0.0022/nm, -0.0064 and -.0089/nm (i.e., Filters E, F and C). As will be appreciated, different of the nine filters fall into different of the groups in different wavelength bands.

Inspection of Tables XI and XII reveals that among the 9 filters and 25 wavelengths sampled at 10 nm intervals from 430-670 nm (i.e., 9*25 or 225 filter-wavelengths), there are 88 filter-wavelengths that are in valley neighborhoods and 64 filter-wavelengths that are in peak neighborhoods. The remaining 73 filter-wavelengths (i.e., the vacant areas in Table XII) define endpoints of the third class 10 nm spans having positive or negative slopes. (Some of these spans start at filter-wavelengths that are the last member of a peak or valley neighborhood.) In particular, there are 28 of these third class spans that have positive slopes (ranging from .0005/nm to .0837/nm), with more than a third of this number having values below .01 and more than a third of this number having values above .01. There are 71 of these third class spans that have negative slopes (ranging from -.00009 to -.0134), with more than a third of this number having values above -.0005 and more than a third of this number having values below -.0005.

Inspection further shows that, for each of the 25 sampled filter values from 430-670 nm, there is at least one filter whose transmission value is in a peak neighborhood. Similarly, for each of the 25 sampled filter values, there is at least one filter whose transmission value is in a valley neighborhood. (Actually, for each of the 25 sampled filter values, there are at least four filters functions that are in extrema neighborhoods, with one span, i.e., 660 nm, having eight filter functions that are in extrema neighborhoods.) For each of the 25 sampled filter values there is also at least one filter that is neither in a peak nor valley neighborhood, but rather is in the "third class." (At one wavelength, i.e., 550 nm, there are five filter functions that are in this third class.)

Some examples of the technology comprise a color filter cell including N different filters, where N may be three or more, four or more, nine or more, or 16 or more filters, and including one or more non-normative filters. The filters are each characterized by a group-normalized transmission function comprising values sampled at wavelength intervals of 10 nm from 400-700 nm, where certain of the sampled values are within 0.15 of a 60 nm-span local maximum for a respective filter and are termed members of peak neighborhoods, and certain of the sampled values are within 0.15 of a 60 nm-span local minimum for a respective filter and are termed members of valley neighborhoods. Certain of the filter functions, for the 24 different 10 nm wavelength spans extending between 430-670 nm, include 10 nm spans that are neither wholly within peak nor valley neighborhoods. Certain of said 10 nm spans have positive slope values with increasing wavelengths and certain of said 10 nm spans have negative slope values with increasing wavelengths. These examples are characterized in that:
for each of the 25 wavelengths sampled at 10 nm intervals from 430-670 nm, there is at least one filter whose transmission function is within a peak neighborhood, and/or
for each of the 25 wavelengths sampled at 10 nm intervals from 430-670 nm, there is at least one filter whose transmission function is within a valley neighborhood, and/or
for each of at least 20 of the 24 different 10 nm spans between 430 nm and 670 nm, there is at least one filter whose transmission function is neither wholly within a peak nor valley neighborhood, and instead has a negative slope value, and/or
for each of the 24 different 10 nm spans between 430 nm and 670 nm, there is at least one filter whose transmission function is neither wholly within a peak nor valley neighborhood, and instead has a negative slope value, and/or
across the N different filters, each having a transmission function value sampled at 10 nm intervals from 430-670 nm, thereby defining 25N filter-wavelengths, at least 25% of the 25N filter-wavelengths is neither within a peak nor valley neighborhood, and/or
at least 65% of the 25N filter-wavelengths is within a peak neighborhood or a valley neighborhood, and/or
one or more of said positive slopes has a value less than .001/nm., and/or
one or more of said positive slopes has a value of at least .05/nm, and/or
a third or more of said positive slopes have values less than .01/nm., and/or
a third or more of said positive slopes have values of at least than .01/nm., and/or
one or more of said negative slopes has a value between -.0001/nm and zero., and/or
one or more of said negative slopes has a value between -.01/nm and -.1/nm., and/or
a third or more of said negative slopes have values between -.005/nm and zero., and/or
a third or more of said negative slopes have values between -.005/nm and -.1/nm.

The filters detailed in Table I were readily available and were used for proof-of-concept testing. In actual practice, filters with more complex transmission curves may be used. A curve in the shape of a "M" - like a double-humped camel - is one example of a more complex filter transmission curve. Such curve ascends from a low value in the blue or ultraviolet spectrum, to a first peak at a first wavelength, then descends to a valley before ascending up to a second peak at a second wavelength, and finally descending again in the infrared or red spectrum. Another exemplary curve is in the shape of a "W" - starting at one value in the blue or ultraviolet, then descending to a first valley, then rising to a peak, then descending to a second valley, before rising again towards infrared or red wavelengths.

In one example that employs a non-normative filter with an M-shaped transmission function, the two local peaks have respective transmission values that are within 0.25 of each other.

In other examples, one or more filter curves are still more complex - including three 60 nm-span local maxima or minima (e.g., a three-humped camel).

While complex transmission functions bring benefits, applicant has found that too-complex transmission functions can bring liabilities. For example, if one or more filters in a color filter cell, of N different filters, has a relatively large number of local maxima and minima (as defined earlier), then metameric effects become more common. Such metameric effects can interfere with accurate color measurements. Applicant has found that such issues arise when the combined count of local minima and maxima in a filter's transmission function has a value of (N-2) or more. This is the "relatively large number" just-referenced. So in a color filter cell of nine different filters, this issue becomes a concern when one or more filters has seven or more local extrema. In a color filter cell of six different filters, this issue becomes a concern when one or more of the filters has four or more local extrema. Etc. Accordingly, while not essential, in a color filter cell of N different filters, applicant commonly employs filters that each has N-3 or fewer local extrema.

The curves given in Figs. 6A-6I and detailed in Table I are for dyed polyester filters, commercially-available from Rosco Laboratories. In particular, the filters are:
4390 CalColor 90 cyan
3304 Tough Plusgreen
343 Neon Pink
55 Lilac
65 Daylight blue
365 Tharon Delft blue
370 Italian blue
386 Leaf green
389 Chroma green

Implementations on photosensors can employ dyed polyester filters, but the pixels would commonly be relatively large. Photosensor arrays more commonly use pigmented filters. Filters based on interference filters, dichroics and quantum dots (nanoparticles) can also be used. Some embodiments are implemented by mixing pigment powders/pastes, or nanoparticles, in a (negative) photoresist carrier. Different pigments and nanoparticles absorb at different wavelengths, causing notches in the resultant transmission spectrum. The greater the concentrations, the deeper the notches.

### Second Exemplary Filter Set

One of applicant's aims in selecting filters is to yield a filter set whose diversity yields an optimized modulation transfer function (MTF) as compared with alternatives. This led to development of the first set of filters discussed above. It also led to a second set of nine filters detailed below. Again, these nine filters were selected from the Rosco catalog:
AA: Deep Straw (#15)
BB: True Pink (#337)
CC: Cal30 green (#4430)
DD: Turquoise (#92)
EE: GalloGold (#316)
FF: Cal60 Pink (#4860)
GG: GaslightGrn (#388)
HH: Cal60 cyan (#4360)
II: Azure blue (#72)

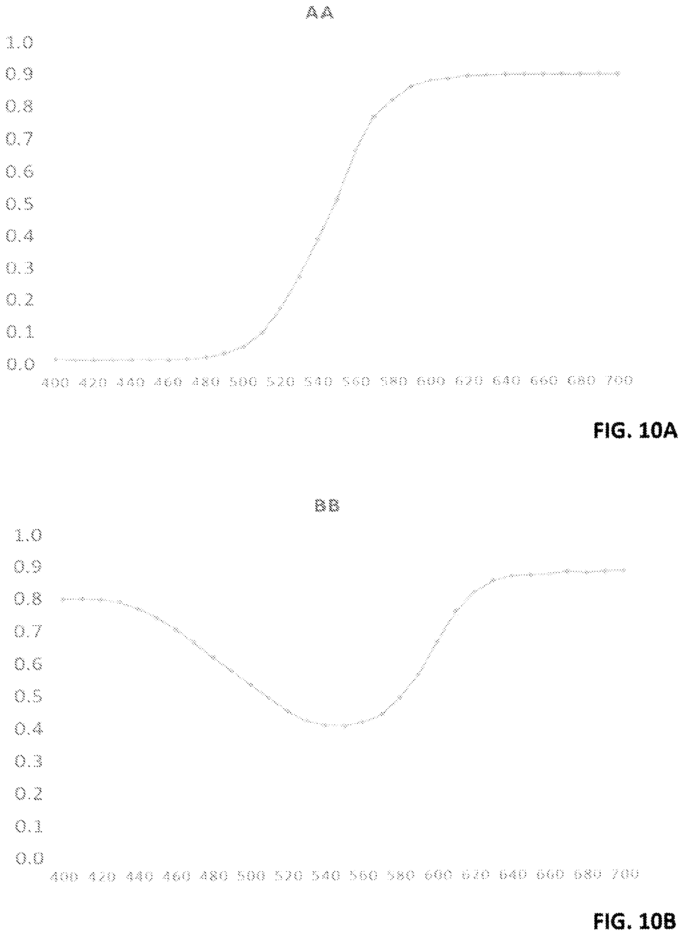

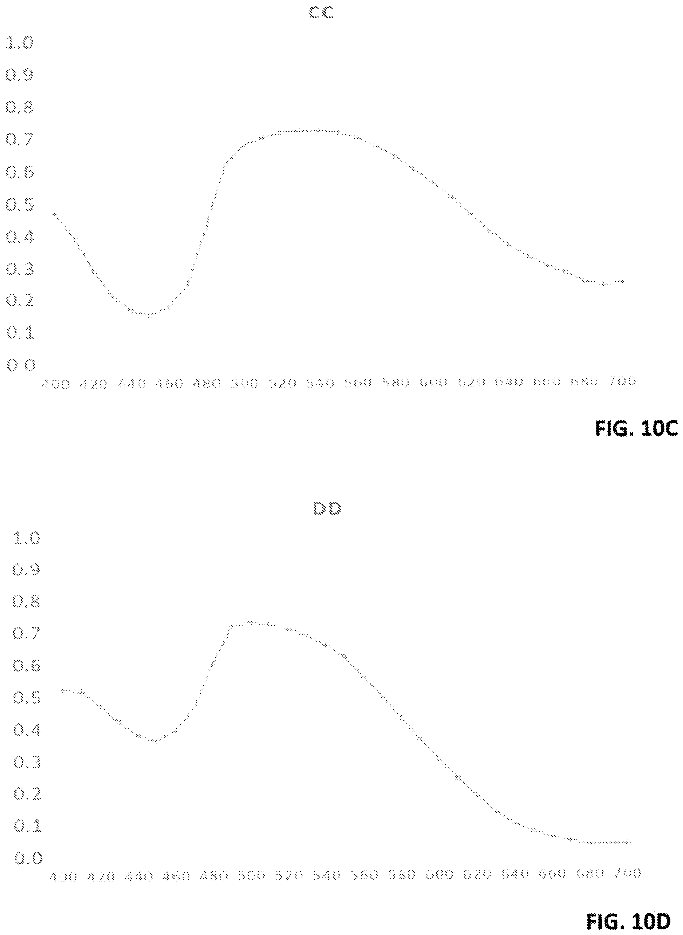

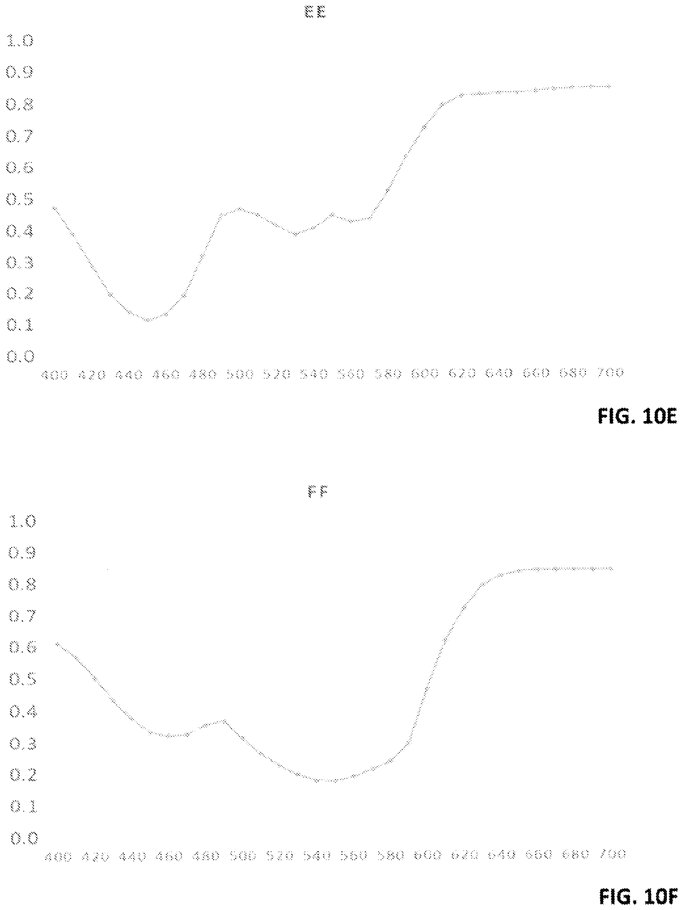

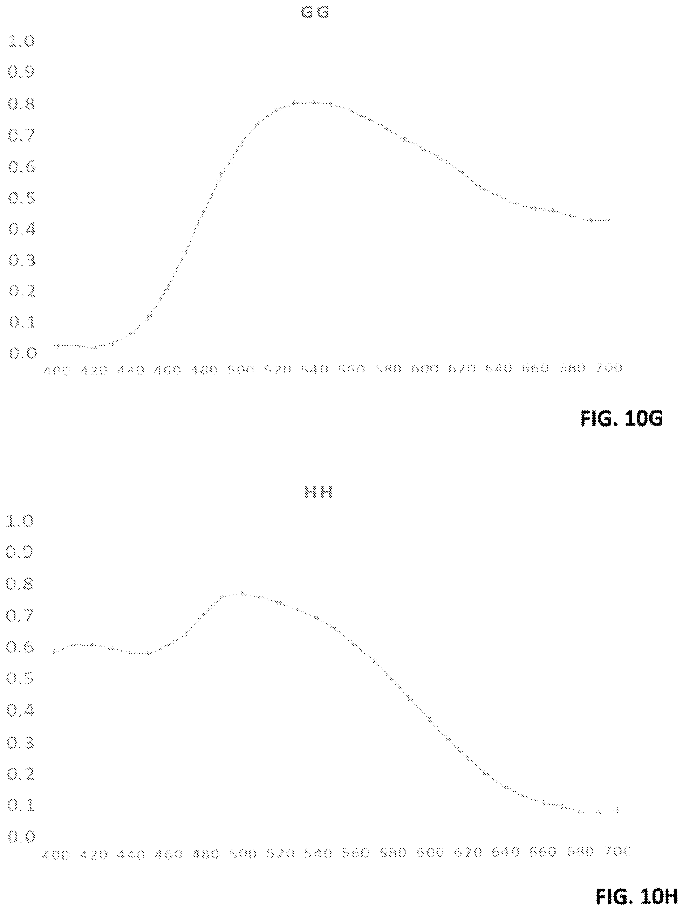

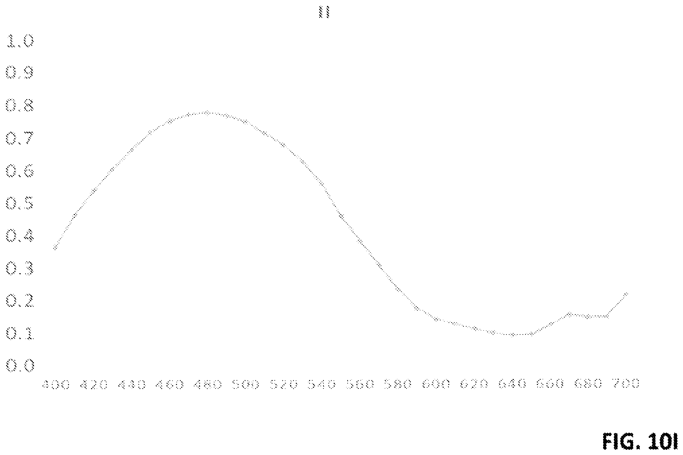

Transmission data for this second filter set is charted in Figs. 10A-10I and is detailed in Table XIII:

**TABLE XIII**

| WL | AA | BB | CC | DD | EE | FF | GG | HH | II |
|---|---|---|---|---|---|---|---|---|---|
| 380 | .0594 | .7807 | .5114 | .4553 | .5474 | .5942 | .0894 | .4905 | .2207 |
| 390 | .0286 | .7943 | .5153 | .5020 | .5377 | .6285 | .0503 | .5440 | .2743 |
| 400 | .0166 | .7999 | .4674 | .5229 | .4735 | .6104 | .0253 | .5853 | .3641 |
| 410 | .0138 | .7999 | .3938 | .5164 | .3883 | .5673 | .0235 | .6072 | .4640 |
| 420 | .0138 | .7972 | .2927 | .4722 | .2885 | .5008 | .0183 | .6060 | .5406 |
| 430 | .0138 | .7898 | .2116 | .4228 | .1962 | .4321 | .0312 | .5962 | .6057 |
| 440 | .0138 | .7684 | .1664 | .3802 | .1387 | .3735 | .0620 | .5826 | .6675 |
| 450 | .0138 | .7418 | .1516 | .3624 | .1139 | .3338 | .1151 | .5785 | .7189 |
| 460 | .0138 | .7053 | .1765 | .3959 | .1329 | .3229 | .2095 | .6018 | .7531 |
| 470 | .0151 | .6641 | .2517 | .4653 | .1931 | .3280 | .3235 | .6416 | .7725 |
| 480 | .0193 | .6188 | .4280 | .6021 | .3200 | .3555 | .4510 | .7034 | .7780 |
| 490 | .0325 | .5750 | .6200 | .7175 | .4469 | .3684 | .5727 | .7605 | .7698 |
| 500 | .0537 | .5325 | .6804 | .7320 | .4678 | .3139 | .6671 | .7681 | .7504 |
| 510 | .0956 | .4911 | .7030 | .7265 | .4487 | .2645 | .7358 | .7545 | .7154 |
| 520 | .1710 | .4512 | .7192 | .7131 | .4149 | .2267 | .7776 | .7380 | .6806 |
| 530 | .2698 | .4203 | .7227 | .6902 | .3879 | .1984 | .7981 | .7155 | .6315 |
| 540 | .3871 | .4068 | .7254 | .6607 | .4073 | .1812 | .8022 | .6899 | .5599 |
| 550 | .5108 | .4047 | .7188 | .6240 | .4464 | .1798 | .7951 | .6528 | .4598 |
| 560 | .6594 | .4168 | .7019 | .5628 | .4269 | .1921 | .7745 | .6034 | .3838 |
| 570 | .7656 | .4404 | .6766 | .4988 | .4358 | .2146 | .7465 | .5501 | .3076 |
| 580 | .8162 | .4938 | .6448 | .4333 | .5229 | .2393 | .7141 | .4908 | .2362 |
| 590 | .8575 | .5626 | .6048 | .3671 | .6323 | .2969 | .6813 | .4260 | .1759 |
| 600 | .8771 | .6638 | .5643 | .3023 | .7255 | .4666 | .6504 | .3631 | .1448 |
| 610 | .8830 | .7578 | .5164 | .2433 | .7967 | .6182 | .6181 | .3004 | .1291 |
| 620 | .8913 | .8163 | .4646 | .1887 | .8255 | .7206 | .5747 | .2422 | .1132 |
| 630 | .8927 | .8520 | .4116 | .1375 | .8285 | .7933 | .5278 | .1903 | .1007 |
| 640 | .8942 | .8657 | .3687 | .1018 | .8324 | .8237 | .4977 | .1498 | .0938 |
| 650 | .8941 | .8685 | .3322 | .0784 | .8339 | .8385 | .4703 | .1192 | .0962 |
| 660 | .8941 | .8726 | .3043 | .0607 | .8381 | .8420 | .4563 | .0990 | .1267 |
| 670 | .8941 | .8808 | .2833 | .0510 | .8447 | .8420 | .4488 | .0865 | .1571 |
| 680 | .8941 | .8768 | .2530 | .0378 | .8479 | .8420 | .4308 | .0708 | .1504 |
| 690 | .8941 | .8809 | .2438 | .0399 | .8501 | .8420 | .4147 | .0702 | .1512 |
| 700 | .8941 | .8829 | .2509 | .0399 | .8501 | .8420 | .4143 | .0727 | .2187 |
| 710 | .8941 | .8831 | .2838 | .0602 | .8501 | .8420 | .4315 | .0984 | .2900 |
| 720 | .8942 | .8828 | .3745 | .1039 | .8521 | .8420 | .4806 | .1686 | .2980 |
| 730 | .8913 | .8809 | .4770 | .2086 | .8523 | .8420 | .5436 | .2701 | .3025 |
| 740 | .8913 | .8847 | .5817 | .3505 | .8545 | .8420 | .6189 | .4058 | .3582 |
| 750 | .8927 | .8809 | .6802 | .4979 | .8525 | .8406 | .6978 | .5511 | .4227 |

When group-normalized, as described earlier, this second filter set has transmission functions in the wavelength range 400-700 nm as detailed in Table XIV:

**TABLE XIV**

| WL | AA | BB | CC | DD | EE | FF | GG | HH | II |
|---|---|---|---|---|---|---|---|---|---|
| 400 | .0186 | .8946 | .5227 | .5847 | .5295 | .6826 | .0283 | .6546 | .4072 |
| 410 | .0154 | .8946 | .4404 | .5775 | .4342 | .6344 | .0263 | .6791 | .5189 |
| 420 | .0154 | .8915 | .3274 | .5281 | .3226 | .5601 | .0205 | .6777 | .6046 |
| 430 | .0154 | .8832 | .2366 | .4728 | .2194 | .4832 | .0349 | .6667 | .6774 |
| 440 | .0154 | .8593 | .1861 | .4251 | .1551 | .4177 | .0694 | .6516 | .7465 |
| 450 | .0154 | .8295 | .1696 | .4053 | .1274 | .3733 | .1287 | .6469 | .8040 |
| 460 | .0154 | .7887 | .1974 | .4427 | .1486 | .3611 | .2343 | .6730 | .8422 |
| 470 | .0169 | .7427 | .2814 | .5204 | .2160 | .3668 | .3618 | .7175 | .8639 |
| 480 | .0215 | .6921 | .4786 | .6733 | .3578 | .3976 | .5043 | .7866 | .8700 |
| 490 | .0364 | .6430 | .6934 | .8023 | .4998 | .4119 | .6404 | .8505 | .8609 |
| 500 | .0600 | .5955 | .7609 | .8187 | .5231 | .3511 | .7460 | .8590 | .8392 |
| 510 | .1069 | .5492 | .7862 | .8124 | .5018 | .2958 | .8229 | .8437 | .8000 |
| 520 | .1913 | .5045 | .8043 | .7974 | .4639 | .2535 | .8697 | .8253 | .7612 |
| 530 | .3017 | .4701 | .8082 | .7718 | .4338 | .2218 | .8926 | .8001 | .7062 |
| 540 | .4329 | .4549 | .8112 | .7389 | .4555 | .2026 | .8971 | .7715 | .6261 |
| 550 | .5713 | .4526 | .8039 | .6978 | .4992 | .2011 | .8891 | .7300 | .5142 |
| 560 | .7375 | .4661 | .7850 | .6294 | .4774 | .2149 | .8661 | .6748 | .4292 |
| 570 | .8562 | .4925 | .7566 | .5578 | .4874 | .2400 | .8348 | .6152 | .3440 |
| 580 | .9128 | .5522 | .7211 | .4845 | .5847 | .2676 | .7986 | .5489 | .2642 |
| 590 | .9590 | .6292 | .6764 | .4106 | .7071 | .3320 | .7619 | .4764 | .1967 |
| 600 | .9809 | .7423 | .6311 | .3381 | .8113 | .5218 | .7274 | .4060 | .1619 |
| 610 | .9875 | .8474 | .5775 | .2720 | .8910 | .6913 | .6913 | .3360 | .1444 |
| 620 | .9968 | .9129 | .5196 | .2110 | .9232 | .8058 | .6427 | .2708 | .1266 |
| 630 | .9983 | .9528 | .4602 | .1538 | .9265 | .8872 | .5903 | .2128 | .1126 |
| 640 | 1.0000 | .9682 | .4123 | .1139 | .9309 | .9212 | .5566 | .1676 | .1049 |
| 650 | .9999 | .9713 | .3715 | .0877 | .9326 | .9377 | .5260 | .1333 | .1076 |
| 660 | .9999 | .9759 | .3403 | .0679 | .9372 | .9416 | .5103 | .1107 | .1417 |
| 670 | .9999 | .9850 | .3168 | .0570 | .9446 | .9416 | .5018 | .0968 | .1756 |
| 680 | .9999 | .9805 | .2829 | .0423 | .9482 | .9416 | .4818 | .0791 | .1682 |
| 690 | .9999 | .9851 | .2727 | .0446 | .9507 | .9416 | .4637 | .0785 | .1691 |
| 700 | .9999 | .9874 | .2806 | .0447 | .9507 | .9416 | .4633 | .0813 | .2446 |

Many features characterizing this second filter set are similar to or the same as features of the first filter set. Some features characterizing this second filter set are discussed below. Other features can be straight-forwardly be determined from the provided data, in the manners taught earlier.

Dot products among the nine different filters of the second set range from a minimum of 6.33 to a maximum of 17.14. The maximum value is 2.7 times the minimum value. The average of the 36 dot product values is 11.11 and the standard deviation is 2.72. The full set of dot products is shown in Table XV:

**TABLE XV**

| FILTERS | DOT PRODUCT |
|---|---|
| Dot Product (AA,BB) | 16.1205 |
| Dot Product (AA,CC) | 11.0652 |
| Dot Product (AA,DD) | 7.2126 |
| Dot Product (AA,EE) | 15.8466 |
| Dot Product (AA,FF) | 13.6452 |
| Dot Product (AA,GG) | 13.2595 |
| Dot Product (AA,HH) | 7.9533 |
| Dot Product (AA,II) | 6.3331 |
| Dot Product (BB,CC) | 13.1491 |
| Dot Product (BB,DD) | 11.2292 |
| Dot Product (BB,EE) | 17.1439 |
| Dot Product (BB,FF) | 16.5879 |
| Dot Product (BB,GG) | 13.8320 |
| Dot Product (BB,HH) | 13.2656 |
| Dot Product (BB,II) | 12.1257 |
| Dot Product (CC,DD) | 9.9055 |
| Dot Product (CC,EE) | 11.3671 |
| Dot Product (CC,FF) | 9.3892 |
| Dot Product (CC,GG) | 11.9867 |
| Dot Product (CC,HH) | 10.8856 |
| Dot Product (CC,II) | 9.1545 |
| Dot Product (DD,EE) | 8.4494 |
| Dot Product (DD,FF) | 7.3433 |
| Dot Product (DD,GG) | 9.7770 |
| Dot Product (DD,HH) | 11.0129 |
| Dot Product (DD,II) | 9.7922 |
| Dot Product (EE,FF) | 13.8435 |
| Dot Product (EE,GG) | 12.7739 |
| Dot Product (EE,HH) | 9.5528 |
| Dot Product (EE,II) | 8.1884 |
| Dot Product (FF,GG) | 10.2349 |
| Dot Product (FF,HH) | 8.5946 |
| Dot Product (FF,II) | 7.8785 |
| Dot Product (GG,HH) | 10.7138 |
| Dot Product (GG,II) | 9.0641 |
| Dot Product (HH,II) | 11.2584 |

Some examples comprise a color filter cell comprised wholly or partly of non-normative filters, characterized in that dot products computed between group-normalized transmission functions of all possible pairings of different filters in the cell, at 10 nm intervals from 400-700 nm, ranges from a minimum value, to a maximum value that is less than 3, or less than 2.75, times the minimum value.

Some examples comprise a color filter cell comprised wholly or partly of non-normative filters, characterized in that dot products computed between group-normalized transmission functions of all possible pairings of different filters in the cell, at 10 nm intervals from 400-700 nm, ranges from a minimum value, to a maximum value that is at least 2, or at least 2.5, times the minimum value.

Some examples comprise a color filter cell comprised partly or wholly of non-normative filters, characterized in that a dot product computed between group-normalized transmission functions of two different filters in the cell, at 10 nm intervals from 400-700 nm, is less than 7, or less than 6.5.

Some examples comprise a color filter cell comprised partly or wholly of non-normative filters, characterized in that a dot product computed between group-normalized transmission functions of two different filters in the cell, at 10 nm intervals from 400-700 nm, is at least 14, at least 16, or at least 17.

Some examples comprise a color filter cell comprised partly or wholly of non-normative filters, characterized in that dot products computed between group-normalized transmission functions of all possible pairings of different filters in the cell, at 10 nm intervals from 400-700 nm, yield a set of values, and an average of said set of values is at least 9, at least 10, or at least 11.

Some examples comprise a color filter cell comprised partly or wholly of non-normative filters, characterized in that dot products computed between group-normalized transmission functions of all possible pairings of different filters in the cell, at 10 nm intervals from 400-700 nm, yield a set of values, and an average of said set of values is less than 13, less than 12, or less than 11.5.

Some examples comprise a color filter cell comprised partly or wholly of non-normative filters, characterized in that a set of dot products between group-normalized transmission functions of all different filters in the cell, at 10 nm intervals from 400-700 nm, has a standard deviation at least 2, or at least 2.5.

Some examples comprise a color filter cell comprised partly or wholly of non-normative filters, characterized in that a set of dot products between group-normalized transmission functions of all different filters in the cell, at 10 nm intervals from 400-700 nm, has a standard deviation less than 2.75, or less than 3.

Some examples comprise a color filter cell comprised partly or wholly of non-normative filters, characterized in that dot products computed between group-normalized transmission functions of all possible pairings of different filters in the cell, at 10 nm intervals from 400-700 nm, yield a set of values, and at least 20% of said values are less than 9.

Some examples comprise a color filter cell comprised partly or wholly of non-normative filters, characterized in that dot products computed between group-normalized transmission functions of all possible pairings of different filters in the cell, at 10 nm intervals from 400-700 nm, yield a set of values, and at least 10% of said values are at least 15.

Top-codes, crossing-codes and a crossing histogram for the second filter set can be determined in the manners detailed earlier. The crossing histogram for the second filter set is shown in Table XVI:

**TABLE XVI**

| | |
|---|---|
| 400-410 | 4 |
| 410-420 | 2 |
| 420-430 | 1 |
| 430-440 | 1 |
| 440-450 | 1 |
| 450-460 | 2 |
| 460-470 | 0 |
| 470-480 | 3 |
| 480-490 | 4 |
| 490-500 | 2 |
| 500-510 | 4 |
| 510-520 | 3 |
| 520-530 | 2 |
| 530-540 | 1 |
| 540-550 | 3 |
| 550-560 | 4 |
| 560-570 | 3 |
| 570-580 | 6 |
| 580-590 | 1 |
| 590-600 | 5 |
| 600-610 | 2 |
| 610-620 | 0 |
| 620-630 | 1 |
| 630-640 | 0 |
| 640-650 | 2 |
| 650-660 | 1 |
| 660-670 | 1 |
| 670-680 | 0 |
| 680-690 | 0 |
| 690-700 | 0 |

The average value in this histogram is 1.97 and the standard deviation is 1.60.

Some examples comprise a color filter cell including three or more different filters, each with an associated transmission curve, said filters being comprised wholly or partly of non-normative filters, characterized in that a count of crossings between all pairs of said curves, in each of thirty 10 nm bands between 400-700 nm, yields a vector of 30 count values, the average value of which is less than 2.

Some examples comprise a color filter cell including three or more different filters, each with an associated transmission curve, said filters being comprised wholly or partly of non-normative filters, characterized in that a count of crossings between all pairs of said curves, in each of thirty 10 nm bands between 400-700 nm, yields a vector of 30 count values, the standard deviation of which is less than 1.7.

As discussed earlier, the difference between two crossing-codes can be indicated by a Hamming distance. As with the first filter set (Table I), the 36 crossing-codes associated with the second filter set can be paired in 630 ways. In the case of the second filter set, the Hamming distances range from 0 to 7, with an average value of 3.065 and a standard deviation of 1.24. There are 11 Hamming distances of 0 in the set of 630 values. There are 4 with a Hamming distance of 7.

Some examples comprise a color filter cell characterized in that an average Hamming distance between all possible crossing-codes defined between different filters in the cell is less than 3.1.

The efficiencies of the filters of the second set can be computed as detailed above. Results are shown in Table XVII:

**TABLE XVII**

| | |
|---|---|
| AA | 47.0% |
| BB | 68.1% |
| CC | 45.3% |
| DD | 39.2% |
| EE | 52.8% |
| FF | 48.3% |
| GG | 47.8% |
| HH | 46.5% |
| II | 41.3% |

As can be seen, the efficiencies of filters in this second set, over the 400-700 nm range, varies from under 40% to nearly 70%. The average is 48.5%.

Some examples comprise a color filter cell characterized in that at least 85% of plural different non-normative filters in the cell have efficiencies of at least 40%.

Some examples comprise a color filter cell characterized in that at least one non-normative filter in the cell has an efficiency exceeding 66%.

Some examples comprise a color filter cell, comprised partly or wholly of non-normative filters, characterized in that an average efficiency computed over all different filters in the cell exceeds 48%.

Diversity of the second filter set can also be characterized, in part, by its narrow and broad 60 nm-span extrema. There are nine 60 nm-span minima, of which six are broad and three are narrow. (The latter are at 450 nm in Filter CC, at 450 nm in Filter EE, and at 640 nm in Filter II.) There are six 60 nm-span maxima, of which four are broad and two are narrow. (The latter are at 490 nm in Filter FF and at 500 nm in Filter EE.)

Some examples comprise a color filter cell with one or more non-normative filters, characterized in that a count of broad 60 nm-span local minima exceeds a count of narrow 60 nm-span local minima. Some such examples are characterized in that the count of broad 60 nm-span local minima is at least 150% or at least 200%of the count of narrow 60 nm-span local minima.

Some examples comprise a color filter cell with one or more non-normative filters, characterized in that a count of broad 60 nm-span local minima exceeds a count of broad 60 nm-span local maxima. Some such examples are characterized in that the count of broad 60 nm-span local minima is at least 150%of the count of broad 60 nm-span local maxima.

Some examples comprise a color filter cell with one or more non-normative filters, characterized in that a count of filters having broad 60 nm-span extrema exceeds a count of filters having narrow 60 nm-span extrema. Some such examples are characterized in that the count of broad 60 nm-span local extrema is at least 150% or at least 200% of the count of narrow 60 nm-span local extrema.

### Third Exemplary Filter Set

Transmission data for a third filter set in the wavelength range 400-700 nm is detailed in Table XVIII:

**TABLE XVIII**

| WL | AAA | BBB | CCC | DDD | EEE | FFF | GGG | HHH | III |
|---|---|---|---|---|---|---|---|---|---|
| 400 | 0.6722 | 0.1273 | 0.5686 | 0.8358 | 0.1158 | 0.4482 | 0.7432 | 0.6569 | 0.1516 |
| 410 | 0.6532 | 0.0854 | 0.6198 | 0.8295 | 0.0884 | 0.3525 | 0.7431 | 0.6504 | 0.1168 |
| 420 | 0.6106 | 0.0670 | 0.6637 | 0.8180 | 0.0722 | 0.2701 | 0.7361 | 0.6341 | 0.0999 |
| 430 | 0.5538 | 0.0579 | 0.7050 | 0.8020 | 0.0627 | 0.2106 | 0.7295 | 0.6179 | 0.1009 |
| 440 | 0.4896 | 0.0523 | 0.7434 | 0.7823 | 0.0573 | 0.1748 | 0.7232 | 0.6053 | 0.1133 |
| 450 | 0.4197 | 0.0501 | 0.7711 | 0.7571 | 0.0548 | 0.1950 | 0.7259 | 0.6218 | 0.1457 |
| 460 | 0.3448 | 0.0799 | 0.7839 | 0.7249 | 0.0547 | 0.2978 | 0.7427 | 0.6688 | 0.1939 |
| 470 | 0.2680 | 0.1797 | 0.7841 | 0.6855 | 0.0571 | 0.4561 | 0.7695 | 0.7326 | 0.2833 |
| 480 | 0.1936 | 0.3381 | 0.7740 | 0.6375 | 0.0644 | 0.5988 | 0.7940 | 0.7777 | 0.3610 |
| 490 | 0.1301 | 0.5090 | 0.7533 | 0.5840 | 0.0823 | 0.6739 | 0.8013 | 0.7871 | 0.4088 |
| 500 | 0.0839 | 0.6363 | 0.7219 | 0.5314 | 0.1193 | 0.7066 | 0.7983 | 0.7788 | 0.4615 |
| 510 | 0.0549 | 0.7167 | 0.6777 | 0.4851 | 0.1832 | 0.7231 | 0.7891 | 0.7602 | 0.5242 |
| 520 | 0.0396 | 0.7680 | 0.6195 | 0.4503 | 0.2741 | 0.7321 | 0.7764 | 0.7343 | 0.5904 |
| 530 | 0.0334 | 0.8020 | 0.5478 | 0.4283 | 0.3854 | 0.7357 | 0.7606 | 0.7010 | 0.6802 |
| 540 | 0.0341 | 0.8252 | 0.4716 | 0.4248 | 0.5075 | 0.7326 | 0.7417 | 0.6611 | 0.7742 |
| 550 | 0.0441 | 0.8395 | 0.3958 | 0.4435 | 0.6291 | 0.7168 | 0.7166 | 0.6123 | 0.8408 |
| 560 | 0.0773 | 0.8481 | 0.3212 | 0.4853 | 0.7353 | 0.6871 | 0.6868 | 0.5559 | 0.8723 |
| 570 | 0.1585 | 0.8516 | 0.2487 | 0.5431 | 0.8105 | 0.6467 | 0.6521 | 0.4931 | 0.8654 |
| 580 | 0.3005 | 0.8551 | 0.1898 | 0.6144 | 0.8549 | 0.6014 | 0.6147 | 0.4286 | 0.8577 |
| 590 | 0.4786 | 0.8574 | 0.1532 | 0.6928 | 0.8759 | 0.5515 | 0.5723 | 0.3635 | 0.8615 |
| 600 | 0.6458 | 0.8593 | 0.1342 | 0.7685 | 0.8853 | 0.4978 | 0.5245 | 0.2996 | 0.8692 |
| 610 | 0.7645 | 0.8601 | 0.1219 | 0.8271 | 0.8888 | 0.4419 | 0.4736 | 0.2403 | 0.8772 |
| 620 | 0.8327 | 0.8609 | 0.1103 | 0.8629 | 0.8906 | 0.3888 | 0.4247 | 0.1897 | 0.8740 |
| 630 | 0.8658 | 0.8622 | 0.1063 | 0.8802 | 0.8923 | 0.3437 | 0.3831 | 0.1512 | 0.8680 |
| 640 | 0.8804 | 0.8627 | 0.1213 | 0.8873 | 0.8928 | 0.3081 | 0.3500 | 0.1240 | 0.8723 |
| 650 | 0.8874 | 0.8634 | 0.1557 | 0.8912 | 0.8935 | 0.2807 | 0.3239 | 0.1050 | 0.8714 |
| 660 | 0.8912 | 0.8641 | 0.1846 | 0.8938 | 0.8942 | 0.2583 | 0.3025 | 0.0909 | 0.8711 |
| 670 | 0.8933 | 0.8645 | 0.2038 | 0.8955 | 0.8947 | 0.2407 | 0.2862 | 0.0810 | 0.8707 |
| 680 | 0.8946 | 0.8651 | 0.2316 | 0.8964 | 0.8950 | 0.2328 | 0.2808 | 0.0779 | 0.8702 |
| 690 | 0.8952 | 0.8653 | 0.2735 | 0.8967 | 0.8949 | 0.2440 | 0.2956 | 0.0877 | 0.8710 |
| 700 | 0.8958 | 0.8657 | 0.3152 | 0.8968 | 0.8948 | 0.2855 | 0.3403 | 0.1212 | 0.8797 |

When group-normalized, as described earlier, this third filter set has transmission functions as detailed in Table XIX:

**TABLE XIX**

| WL | AAA | BBB | CCC | DDD | EEE | FFF | GGG | HHH | III |
|---|---|---|---|---|---|---|---|---|---|
| 400 | 0.7495 | 0.1419 | 0.6340 | 0.9319 | 0.1292 | 0.4998 | 0.8287 | 0.7325 | 0.1690 |
| 410 | 0.7283 | 0.0952 | 0.6911 | 0.9249 | 0.0985 | 0.3930 | 0.8286 | 0.7252 | 0.1303 |
| 420 | 0.6809 | 0.0747 | 0.7400 | 0.9120 | 0.0805 | 0.3012 | 0.8208 | 0.7071 | 0.1114 |
| 430 | 0.6175 | 0.0646 | 0.7861 | 0.8942 | 0.0699 | 0.2348 | 0.8134 | 0.6890 | 0.1125 |
| 440 | 0.5459 | 0.0583 | 0.8290 | 0.8723 | 0.0639 | 0.1949 | 0.8064 | 0.6749 | 0.1263 |
| 450 | 0.4680 | 0.0559 | 0.8597 | 0.8442 | 0.0610 | 0.2174 | 0.8094 | 0.6933 | 0.1624 |
| 460 | 0.3844 | 0.0891 | 0.8741 | 0.8083 | 0.0610 | 0.3320 | 0.8281 | 0.7458 | 0.2162 |
| 470 | 0.2989 | 0.2004 | 0.8743 | 0.7644 | 0.0637 | 0.5085 | 0.8581 | 0.8169 | 0.3159 |
| 480 | 0.2158 | 0.3770 | 0.8630 | 0.7108 | 0.0719 | 0.6676 | 0.8854 | 0.8671 | 0.4025 |
| 490 | 0.1450 | 0.5675 | 0.8400 | 0.6511 | 0.0917 | 0.7514 | 0.8935 | 0.8777 | 0.4558 |
| 500 | 0.0935 | 0.7095 | 0.8050 | 0.5926 | 0.1331 | 0.7879 | 0.8901 | 0.8684 | 0.5146 |
| 510 | 0.0612 | 0.7991 | 0.7557 | 0.5409 | 0.2043 | 0.8062 | 0.8798 | 0.8477 | 0.5845 |
| 520 | 0.0441 | 0.8563 | 0.6908 | 0.5021 | 0.3056 | 0.8163 | 0.8657 | 0.8187 | 0.6583 |
| 530 | 0.0372 | 0.8942 | 0.6108 | 0.4776 | 0.4297 | 0.8203 | 0.8481 | 0.7816 | 0.7584 |
| 540 | 0.0380 | 0.9202 | 0.5258 | 0.4736 | 0.5659 | 0.8169 | 0.8270 | 0.7372 | 0.8633 |
| 550 | 0.0492 | 0.9361 | 0.4413 | 0.4945 | 0.7015 | 0.7993 | 0.7990 | 0.6828 | 0.9375 |
| 560 | 0.0861 | 0.9456 | 0.3582 | 0.5411 | 0.8199 | 0.7662 | 0.7657 | 0.6198 | 0.9727 |
| 570 | 0.1767 | 0.9496 | 0.2773 | 0.6056 | 0.9038 | 0.7211 | 0.7271 | 0.5499 | 0.9650 |
| 580 | 0.3351 | 0.9535 | 0.2116 | 0.6851 | 0.9532 | 0.6705 | 0.6854 | 0.4778 | 0.9564 |
| 590 | 0.5337 | 0.9561 | 0.1708 | 0.7725 | 0.9766 | 0.6150 | 0.6381 | 0.4053 | 0.9605 |
| 600 | 0.7201 | 0.9582 | 0.1496 | 0.8568 | 0.9871 | 0.5551 | 0.5848 | 0.3341 | 0.9691 |
| 610 | 0.8524 | 0.9591 | 0.1359 | 0.9223 | 0.9911 | 0.4928 | 0.5280 | 0.2679 | 0.9781 |
| 620 | 0.9285 | 0.9599 | 0.1230 | 0.9622 | 0.9931 | 0.4335 | 0.4736 | 0.2115 | 0.9745 |
| 630 | 0.9654 | 0.9614 | 0.1185 | 0.9814 | 0.9949 | 0.3832 | 0.4272 | 0.1686 | 0.9678 |
| 640 | 0.9816 | 0.9619 | 0.1352 | 0.9894 | 0.9955 | 0.3435 | 0.3902 | 0.1383 | 0.9726 |
| 650 | 0.9895 | 0.9627 | 0.1736 | 0.9937 | 0.9963 | 0.3129 | 0.3612 | 0.1171 | 0.9716 |
| 660 | 0.9938 | 0.9635 | 0.2058 | 0.9966 | 0.9971 | 0.2880 | 0.3373 | 0.1014 | 0.9713 |
| 670 | 0.9960 | 0.9640 | 0.2273 | 0.9985 | 0.9976 | 0.2684 | 0.3191 | 0.0903 | 0.9708 |
| 680 | 0.9975 | 0.9646 | 0.2582 | 0.9995 | 0.9980 | 0.2596 | 0.3131 | 0.0868 | 0.9703 |
| 690 | 0.9982 | 0.9649 | 0.3050 | 0.9998 | 0.9978 | 0.2720 | 0.3296 | 0.0978 | 0.9712 |
| 700 | 0.9988 | 0.9653 | 0.3514 | 1.0000 | 0.9978 | 0.3184 | 0.3794 | 0.1352 | 0.9809 |

The filters of this third set are again dye filters, primarily from Rosco. The exception is the last, Filter III, which is from Lee Filters USA:
- AAA:: Neon Pink (#343)
- BBB:: Cal90 yellow (#4590)
- CCC:: Azure blue (#72)
- DDD:: True Pink (#337)
- EEE:: Deep Straw (#15)
- FFF:: Cal30 green (#4430)
- GGG:: Cal30 cyan (#4330)
- HHH:: Cal60 cyan (#4360)
- III:: Medium Amber (Lee #20)

Five of these filters are in common with the second set, discussed above. Whereas the tabular data for the second set (Table XIII) was scanned from printed datasheets, the tabular data for the third set (Table XVIII) was measured with a spectrometer. Some variation will be noted.

Many features characterizing this third filter set are similar to or the same as features of the first and/or second filter sets. Some features characterizing this third filter set are discussed below. Other features can be straight-forwardly be determined from the provided data, in the manners taught earlier.

Dot products among the nine different filters of the third set range from a minimum of 7.79 to a maximum of 21.26. The maximum value is again 2.7 times the minimum value. The average of the 36 dot product values is 13.8 and the standard deviation is 3.61. The full set of dot products is shown in Table XX:

**TABLE XX**

| FILTERS | DOT PRODUCT |
|---|---|
| Dot Product (AAA,BBB) | 15.5833 |
| Dot Product (AAA,CCC) | 9.4049 |
| Dot Product (AAA,DDD) | 18.5859 |
| Dot Product (AAA,EEE) | 15.2000 |
| Dot Product (AAA,FFF) | 9.0038 |
| Dot Product (AAA,GGG) | 11.8088 |
| Dot Product (AAA,HHH) | 8.4794 |
| Dot Product (AAA,III) | 15.1444 |
| Dot Product (BBB,CCC) | 10.7820 |
| Dot Product (BBB,DDD) | 20.0249 |
| Dot Product (BBB,EEE) | 19.5232 |
| Dot Product (BBB,FFF) | 14.1574 |
| Dot Product (BBB,GGG) | 15.5202 |
| Dot Product (BBB,HHH) | 11.6836 |
| Dot Product (BBB,III) | 21.2550 |
| Dot Product (CCC,DDD) | 14.1656 |
| Dot Product (CCC,EEE) | 7.7901 |
| Dot Product (CCC,FFF) | 10.0622 |
| Dot Product (CCC,GGG) | 13.8128 |
| Dot Product (CCC,HHH) | 12.1592 |
| Dot Product (CCC,III) | 9.9835 |
| Dot Product (DDD,EEE) | 17.7521 |
| Dot Product (DDD,FFF) | 13.7860 |
| Dot Product (DDD,GGG) | 18.2895 |
| Dot Product (DDD,HHH) | 14.0034 |
| Dot Product (DDD,III) | 19.5387 |
| Dot Product (EEE,FFF) | 10.9784 |
| Dot Product (EEE,GGG) | 12.0107 |
| Dot Product (EEE,HHH) | 8.3483 |
| Dot Product (EEE,III) | 18.9212 |
| Dot Product (FFF,GGG) | 13.2308 |
| Dot Product (FFF,HHH) | 11.0559 |
| Dot Product (FFF,III) | 13.1942 |
| Dot Product (GGG,HHH) | 14.5940 |
| Dot Product (GGG,III) | 14.8574 |
| Dot Product (HHH,III) | 10.9682 |

Some examples comprise a color filter cell comprised partly or wholly of non-normative filters, characterized in that a dot product computed between group-normalized transmission functions of two different filters in the cell, at 10 nm intervals from 400-700 nm, is at least 18, at least 20, or at least 21.

Some examples comprise a color filter cell comprised partly or wholly of non-normative filters, characterized in that a dot product computed between group-normalized transmission functions of two different filters in the cell, at 10 nm intervals from 400-700 nm, is less than 10, less than 9, or less than 8.

Some examples comprise a color filter cell comprised partly or wholly of non-normative filters, characterized in that a smallest dot product computed between group-normalized transmission functions of all different filter pairings in the cell, at 10 nm intervals from 400-700 nm, is at least 6, at least 7 or at least 7.5.

Some examples comprise a color filter cell comprised partly or wholly of non-normative filters, characterized in that a set of dot products between group-normalized transmission functions of all different filters in the cell, at 10 nm intervals from 400-700 nm, has an average value of at least 10, at least 12, or at least 13.

Some examples comprise a color filter cell comprised partly or wholly of non-normative filters, characterized in that a set of dot products between group-normalized transmission functions of all different filters in the cell, at 10 nm intervals from 400-700 nm, has an average value less than 17, less than 15, or less than 14.

Some examples comprise a color filter cell comprised partly or wholly of non-normative filters, characterized in that a set of dot products between group-normalized transmission functions of all different filters in the cell, at 10 nm intervals from 400-700 nm, has a standard deviation of at least 3, or at least 3.5.

Some examples comprise a color filter cell comprised partly or wholly of non-normative filters, characterized in that a set of dot products between group-normalized transmission functions of all different filters in the cell, at 10 nm intervals from 400-700 nm, has a standard deviation less than 4, or less than 3.7.

Some examples comprise a color filter cell comprised partly or wholly of non-normative filters, characterized in that dot products computed between group-normalized transmission functions of all possible pairings of different filters, at 10 nm intervals from 400-700 nm, yield a set of values, and at least 10% of said values are less than 8.5.

Some examples comprise a color filter cell comprised partly or wholly of non-normative filters, characterized in that dot products computed between group-normalized transmission functions of all possible pairings of different filters, at 10 nm intervals from 400-700 nm, yield a set of values, and at least 25% of said values are less than 11.

Some examples comprise a color filter cell comprised partly or wholly of non-normative filters, characterized in that dot products computed between group-normalized transmission functions of all possible pairings of different filters, at 10 nm intervals from 400-700 nm, yield a set of values, and at least 20% of said values are greater than 16.

Some examples comprise a color filter cell comprised partly or wholly of non-normative filters, characterized in that dot products computed between group-normalized transmission functions of all possible pairings of different filters, at 10 nm intervals from 400-700 nm, yield a set of values, and at least 10% of said values are greater than 19. Formation of Good Images from Problematic Data

Noise can impair the usefulness of color imagery. A familiar example is in an under-exposed image (e.g., captured in low light or with a short exposure interval), where the colors are low in saturation and the image is speckled with pixels of wrong colors. (Read-out noise is commonly the issue in low light situations. In other circumstances, shot noise may predominate where photons themselves are in short supply.)

Aspects of the present technology provide high-confidence techniques for restoring accurate and less noisy coloration to otherwise noisy imagery. Color direction of 'Hue' represents one aspect of the measurement of color. In extremely dim scenes where the signal to noise ratio of pixel data itself approaches 1:1, classic processing of RGB data has challenges in measuring even the cardinal directions of color in the red-green and yellow-blue axes of Hue. The approaches described below do a superior job, in lower and lower light levels, of still determining Hue angles and cardinal directions.

Consider, first, an image without noise. And further consider a region within an imaged scene that has a 400 nm spectral hue. Each pixel imaging this region will produce an output signal dependent on its filter's transmission function at 400 nm. Referring to Table I, and particularly considering pixels overlaid with filters A and B (illustrated in Figs. 6A and 6B), it will be seen that pixels filtered with Filter A will produce relatively high values, while pixels filtered with Filter B will produce relatively low values. This is because the former filter function passes more energy than the latter at 400 nm, i.e., transmission values of .6288 vs .5420. However, pixels overlaid with Filter A will produce relatively lower values than pixels overlaid with Filter C, due to transmission values of .6288 vs .7063.

In similar fashion, Filter A will pass more or less light than each of the other six filters D-I imaging the 400 nm scene region, depending on whether the Table I transmission value for Filter A is higher or lower than the transmission value for each of the other filters, at 400 nm.

Likewise, Filter B will pass more or less light than each of the other seven filters C-I imaging the 400 nm scene region, depending on their respective transmission values at that wavelength. And Filter C will pass more or less light than each of the other six filters D-I imaging the 400 nm scene region, depending on their transmission values at that wavelength. Etc.

Thus, in a properly-exposed scene, the differently-filtered pixels will produce different output signals from a 400 nm scene region, in accordance with their respective transmission values at that wavelength. The output signals from the differently-filtered pixels can be compared and ranked in order of magnitude, based on transmission values in Table I, and will be found to be ordered, at 400 nm: E-D-C-F-A-B-G-H-I. There are 9-summatorial different orders in which the filtered pixels may be ranked, i.e., 36.

At different wavelengths through the spectrum, the ranked ordering of filters will be different. At 410 nm, it is the same as at 400 nm, i.e., E-D-C-F-A-B-G-H-I. However, at 420 nm it switches to D-E-F-C-A-G-B-H-I. It is the same at 430 nm, but switches again at 440 nm, to D-E-F-A-C-G-B-H-I. Each segment of the spectrum is associated with a unique ordering of filters' output signals. Among the 31 sampled wavelengths in the range 400-700 nm, there are 26 unique orderings of filters. Duplicates are expected to be adjacent. The full set of orderings is given in Table XXI. These nine-letter orderings may be termed spectral reference strings.

**TABLE XXI**

| | |
|---|---|
| 400 nm | EDCFABGHI |
| 410 nm | EDCFABGHI |
| 420 nm | DEFCAGBHI |
| 430 nm | DEFCAGBHI |
| 440 nm | DEFACGBHI |
| 450 nm | DEFGACBHI |
| 460 nm | DEAGFCBHI |
| 470 nm | DEAGFBCHI |
| 480 nm | ADGEBFICH |
| 490 nm | BGADIEFHC |
| 500 nm | BIGADEHFC |
| 510 nm | IBGADEHFC |
| 520 nm | BIGAHDEFC |
| 530 nm | BIHAGDEFC |
| 540 nm | BHIAGDEFC |
| 550 nm | BHIADGEFC |
| 560 nm | BHADIGEFC |
| 570 nm | BHDAIFEGC |
| 580 nm | BHDAFCIEG |
| 590 nm | BCDHFAIEG |
| 600 nm | BCDHFAIEG |
| 610 nm | CBDHFAEIG |
| 620 nm | CBDHFAEIG |
| 630 nm | CBDFHAEIG |
| 640 nm | CBDFHEAIG |
| 650 nm | CDBFHEIAG |
| 660 nm | CDBEFHIAG |
| 670 nm | CDBEFHIAG |
| 680 nm | CDEBFHIAG |
| 690 nm | CDEBFIHAG |
| 700 nm | CDEBFHIAG |

If the scene lighting becomes dim, or if the camera exposure becomes very short, the output signals from the pixels will become noisy. Some will be higher than they should be; others will be lower. Yet some remnant of the ordering of the nine differently-filtered outputs, based on wavelength, will remain. (Consider, again, the 400 nm ordering. At the two ends of the ordered sequence of filters, Filter E has a transmission value of .8075 at 400 nm, whereas Filter I has a transmission value of .0426. That is, a pixel filtered with Filter E normally produces an output signal nearly 20-times as large as a pixel filtered with filter I, in a 400 nm scene. Even in extreme noise, it is improbable that the latter pixel will produce an output signal larger than the former pixel.)

In a noise-recovery mode, output signals from pixels in a 3 x 3 pixel region of the photosensor can be ranked by magnitude, to indicate a corresponding ordering of their filters' respective transmission values at the unknown wavelength of incoming light. This ordering of filters will be somewhat scrambled by noise effects, but the ordering will more closely correspond to some of the spectral reference strings in Table XXI than others. The closest match in Table XXI can be used to indicate the spectral hue of the incoming light.

Various known string-matching algorithms can be used. One is based on a Hamming distance. First, determine the ordering of outputs from nine differently-filtered pixels in a low-light scene. Call this nine-element sequence a query string. Then compare this query string with each of the 36 spectral reference strings in Table XXI. Count the number of positions at which the query vector has a different letter, in a given string position, within each spectral reference string. The smaller this count, the better the query string matches a spectral reference string. The spectral reference string that most closely matches the query string (i.e., the string having the smallest count of letter differences with the query string) indicates the hue at that region in the photosensor.

If the query string most-closely matches two spectral reference strings, then the query string can be deemed to match a wavelength between the two wavelengths indicated by the two spectral reference strings. For example, if the query string most-closely matches spectral reference string E-D-C-F-A-B-G-H-I, and this reference string is found in Table XXI for both 400 nm and 410 nm, then the query string can be associated with a hue of 405 nm.

An approach related to the foregoing does not use 31 nine-letter strings, as in Table XXI. Rather, it uses the 36 31-symbol top-code sequences from Table VI.

Recall that each top code in Table VI expresses which of a pair of filters has a higher transmission value at 31 wavelengths from 400-700 nm. The first entry in Table VI compares Filters A and B. The second entry in Table VI compares Filters A and C. And so forth through all 9-summatorial (36) possibilities.

Within each top-code, the first digit indicates which of the paired filters has a higher transmission value at 400 nm. The second digit indicates which of the paired filters has a higher transmission value at 410 nm. And so forth through all 31 sampled wavelengths.

If we read the top-code data in Table VI by vertical columns, instead of horizontal rows, we get a 36-digit sequence for each wavelength. Each of the 36 digits indicates which filter, of a respective pair of two filters, has the greatest output at the subject wavelength. We term each such 36-digit sequence a reference hue-code. Completing this exercise yields the reference hue-codes of Table XXII:

**TABLE XXII**

| | |
|---|---|
| 400 | 100001110000011000111111111111111111 |
| 410 | 100001110000011000111111111111111111 |
| 420 | 110001110000011000111111111111111111 |
| 430 | 110000110000011000011111111111111111 |
| 440 | 110011110000011000011111111111011111 |
| 450 | 110011111000011000011111111111011111 |
| 460 | 111111111001011000010111111011011110 |
| 470 | 111110111111111000000110111010010110 |
| 480 | 111110101111111000000110101010000100 |
| 490 | 011110101111110000000110101010000100 |
| 500 | 011110101111111000000110001000000100 |
| 510 | 011111001111111000000110001000000000 |
| 520 | 011111001111111000000110001000000001 |
| 530 | 011111001111111000000111001000000001 |
| 540 | 011111011111111000000111011000000001 |
| 550 | 010111011111111000000111010100100001 |
| 560 | 010111011111111010101111010100101001 |
| 570 | 000101011111111111111111110100101001 |
| 580 | 000101011111111111111111110100101001 |
| 590 | 000101010111111111111111110101101001 |
| 600 | 000101010111111111111111110101101001 |
| 610 | 000101010111111111111111110101111001 |
| 620 | 000001010111111111111111110101111001 |
| 630 | 000001000011111111111111110101111001 |
| 640 | 000001000011111111111111111111111001 |
| 650 | 000001000011111111111111111111111001 |
| 660 | 000001000001111111111111111111111001 |
| 670 | 000001000001111111111111111111111000 |
| 680 | 000001000001111111111111111111111001 |
| 690 | 000001010001111111111111111111111001 |
| 700 | 000001010001111111111111111111111001 |

Referring to the reference hue-code for 400 nm, the initial symbol, a "1," indicates that Filter A has a transmission value greater than Filter B. The second symbol, a "0," indicates that Filter A has a transmission value less than Filter C. The next three "0"s in the reference hue-code indicate that Filter A has a transmission value less than each of Filters D, E and F. The following symbol, "1," indicates that Filter A has a transmission value greater than Filter G. The next two symbols are both "0," indicating Filter A has a transmission value greater than Filter H and I. Following symbols for the 400 nm reference hue-code continue in this fashion, comparing Filter B to all the rest, and then Filter C, and so-on.

The just-described binary reference hue-codes of Table XXII are counterparts to the spectral reference strings of Table XXI. Each hue-code corresponds to a particular spectral wavelength and serves as a reference against which codes derived from noisy image data can be compared, to assign each pixel in the noisy image data a spectral hue. Again, Hamming distances can be used to compare the reference hue-codes against a query code derived from the noisy image data for a particular pixel, to determine the best match (i.e., the smallest Hamming distance). The best-matching reference hue-code indicates the most-likely hue for the query pixel.

Consider a 3 x 3 cell of pixels, using the filters detailed in Table I, that images a uniformly-colored scene region in low light. The pixels will produce different output signals (data) - different both due to their different filters, and also due to underexposure-related noise. The nine output data are considered in 36 pairs to identify, for each pairing, which filter yields the larger output signal. If the A-filtered pixel produces an output signal that is larger than the B-, C- and D-filtered pixels, but smaller than the E-, F-, G-, H- and I-filtered pixels, the query code begins with the digits 11100000... Further bits of the query code are generated by comparing the output signal from the B-filtered pixel with others, and then the C-filtered pixel, etc. A 36-bit query code is thereby produced. Comparing this query code with each of the reference hue-codes in Table XXII may find that the query code is closest to the reference hue-code for 430 nm, i.e. 110000110000011000011111111111111111. So pixel values for this region in the noisy image frame are replaced with RGB (or CMY) pixel values corresponding to the 430 nm hue.

In one example, a look-up table in memory stores, for each hue-code, corresponding red, green and blue (RGB) values defining a pixel's color. This mapping of hues to RGB values can be accomplished by first identifying the CIE XYZ chromaticity coordinates for each hue of interest. Then, these XYZ coordinates are transformed into a desired RGB space by a 3 x 3 transformation matrix. One suitable matrix, corresponding to the sRGB standard, with a D65 illumination, is: $\begin{matrix}3.2404542 & - 1.5371385 & - 0.4985314 \\ - 0.9692660 & 1.8760108 & 0.0415560 \\ 0.0556434 & - 0.2040259 & 1.0572252\end{matrix}$ This, and other suitable transformation matrices, are available at the web site brucelindbloom<dot>com/index.html?Eqn_RGB_ XYZ_Matrix.html.

Thus, one example of the technology involves receiving values corresponding to output signals from several photosensors within a local neighborhood, where the photosensors include photosensors overlaid by filters having different spectral transmission functions. And then, based on the received values, the method includes providing, e.g., from a memory, a set of plural color values (e.g., R/G/B or XYZ) for a subject photosensor within the neighborhood. Such method can also include determining, for each of the several photosensors, whether the output signal corresponding to the photosensor is larger or smaller than the output signal corresponding to another of said photosensors. Often this involves, for each of multiple pairs of two photosensors within the neighborhood, determining which of the two has a larger received value corresponding thereto. In many examples, the provided plural color values each corresponds to a particular hue, and such color values are available only for a discrete sampling of hues, lacking other hues between the discrete sampling of hues.

In the foregoing arrangements, both using binary hue-codes and the earlier-referenced spectral reference strings, the under-exposed scene was assumed to include a region of a particular color, so that each of nine differently-filtered pixels noisily-sampled the same color with its respective filter's transmission function. In most imagery, this is not a bad approximation, as most adjoining pixels will be similar in chrominance. Thus, in some embodiments, each pixel is regarded to be at the center of a cell, and its hue is determined based on comparisons of its value with values of other pixels in that cell. (If the cell doesn't have a center pixel, then a pixel near the center can be used.)

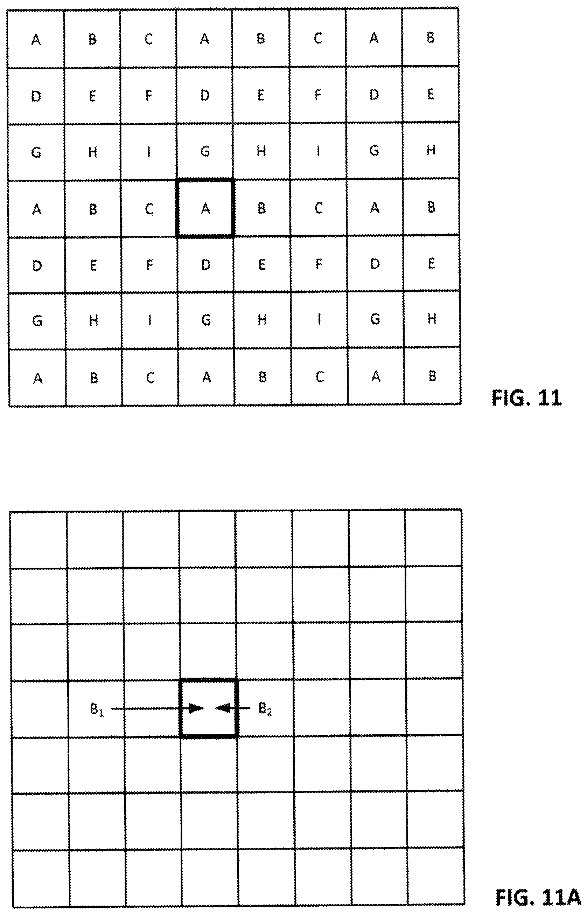

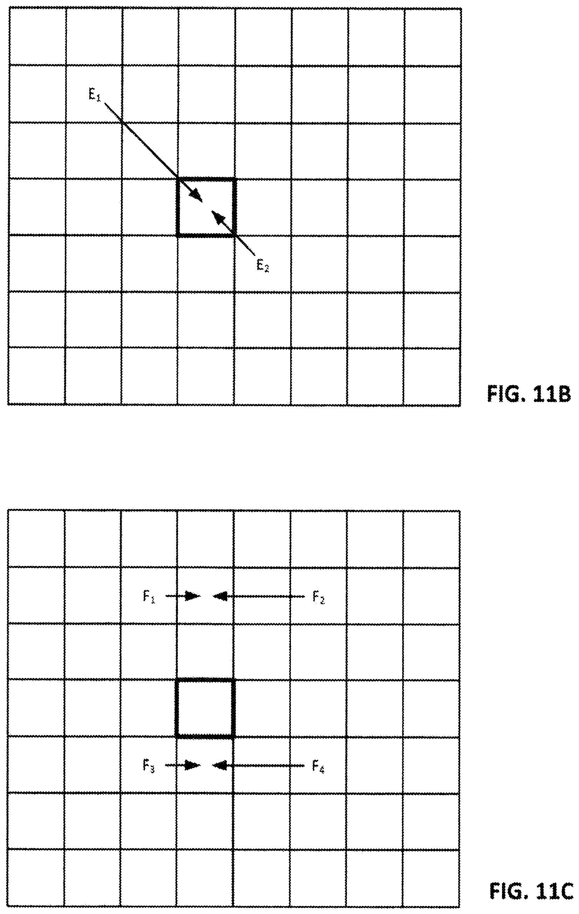

Other arrangements can alternatively be used. Consider a photosensor tiled with an array of 3 x 3 color filter cells, each having the arrangement shown in Fig. 5. A pixel of interest (i.e., the subject pixel) is filtered by one of the nine filters, say filter "A," shown in bold in Fig. 11. Other pixels surrounding the subject pixel are respectively filtered with different filters, according to the cell and tiling pattern.

To conduct one of the above-described methods (based on binary hue-codes or spectral reference strings) without assuming a region of constant or near-constant color, we interpolate values of B-filtered, C-filtered, D-filtered, E-filtered, F-filtered, G-filtered, H-filtered, and I-filtered pixels onto the location of the subject "A"-filtered pixel. We then employ the earlier-described methods using eight such interpolated filtered pixel values at a subject pixel, with a ninth, actually-filtered pixel value at that subject pixel. Various interpolation techniques can be used.

A simple technique is linear interpolation. To project a B-filtered value onto the location of the subject pixel, we look to the values of the two nearest B-filtered pixels (i.e., in the same row). These two pixels, identified as B1 and B2, are shown in Fig. 11A. Their values are weighted in accordance with the reciprocal of their distances to the subject pixel, with the weights summing to unity. In this instance, the interpolated "B" value at the subject pixel location is: ${B}_{1} / 3 + 2 {B}_{2} / 3$

Linearly-interpolated values for photosensors with other filters, found in the same row and column as the subject pixel (i.e., filters C, D and G) are computed likewise. So, too, with filtered pixels that are in a common diagonal with the subject pixel, such as pixels E1 and E2 in Fig. 11B.

For filters that are not in the same row or column as the subject pixel, a different interpolation, such as bilinear or bicubic interpolation, can be used. An example is shown in Fig. 11C, to project an F-filtered pixel value at the subject location. Bi-linear interpolation is illustrated, and involves performing three linear interpolations. First, values of the upper two "F" pixels, F₁ and F₂, and combined in a 2/3, 1/3 weighting to yield a linearly-interpolated F-filtered pixel value at a location indicated by the upper pair of opposing arrows. The values of the lower two "F" pixels, F₃ and F₄, are combined in the same fashion to yield a linearly-interpolated F-filtered pixel value at a location indicated by the lower pair of opposing arrows. These upper and lower interpolated values are then, themselves, combined in a 1/3, 2/3 ratio, to yield an interpolated value for an "F" pixel at the subject location.

At the subject location we then have the photosensor-measured "A"-filtered pixel value, and eight interpolated pixel values for the other eight filters. These nine values are then compared to one another to produce a 9-symbol ordered query string, or a 36-bit binary query code. This string/code is compared against reference spectral strings or hue-codes, respectively, to find the best match, and thereby determine what hue should be assigned to the subject pixel. This operation is similarly performed for all pixels in the photosensor array (or just the under-exposed pixels).

It will be recognized that the just-described processes for assigning colors to pixels/photosensors draw from a limited, discrete sampling of hues. For example, in one example detailed earlier there were 26 unique reference orderings of filters (i.e., reference spectral strings). This correspondingly indicates 26 hues. In contrast, a photosensor that provides red, green and blue output data of 8-bits each (i.e., a 24-bit output color space) has 2^24 possible hues. So, the available sampling is quite sparse - amounting to less than 1 in 2^19 of available colors. Of course, depending on implementation, the sparseness of different examples can be different. But many embodiments will still be capable of producing less than 1%, or less than .001%, or less than .000001% of the hues that can be represented in the output color space.

A corollary to the foregoing is that there is a many-to-one mapping between photosensor values in the neighborhood around a subject photosensor (pixel), and the indicated hue values (and the corresponding RGB output values). The ranking of photosensor output values, and the results of comparisons between pairs of pixels, are insensitive to certain variations in photosensor values. For example, a photosensor overlaid with Filter A will have a larger output signal than a photosensor overlaid with Filter B, whether the former photosensor has an output value of 20 or 200, if the latter photosensor has an output value of 10.

In addition to the noise reduction that the present arrangements afford, many examples can be implemented without complex arithmetic operations. For example, determining whether the output value for one photosensor is larger than the output value for another photosensor is a simple operation that can be done by an analog comparator (if done before the photosensor's accumulated photoelectron charge is converted to digital form) or by a digital comparator (if done after). Such operations can be implemented with simpler hardware circuitry than the arithmetic operations that are commonly used in image de-noising (which may include multiplies or divides).

The foregoing arrangements provide hue output data, but are silent on luminance. Luminance can be estimated based on the magnitude of the photosensor signal at a subject pixel. Alternatively, a weighted average of nearby photosensor signals can be employed, with the subject pixel typically being given more weight than other pixels. A non-linear weighting can also be employed, to reduce the impact of outlier signal values. If the various filters' average transmission values differ, then the photosensor signals can be normalized accordingly so that, e.g., a filter that passes a small fraction of panchromatic light is counted more - in estimating local image luminance - than a filter that passes a relatively larger fraction of panchromatic light. In still other embodiments, local luminance in a region of imagery is estimated based on the statistical distribution of (normalized) values, since low light images exhibit larger deviations. Different RGB values can be stored in the lookup table memory for different combinations of hue and luminance. Or a single set of RGB values can be stored for each hue, and then values can then be scaled up or down based on estimated luminance.

Thus, in accordance with one example, a value associated with a first pixel that has a first spectral response function, is compared with values associated with plural other pixels in a neighborhood that have spectral response functions different than said first spectral response function, and a color or hue is assigned to the first pixel based on a result of said comparisons. In some examples, the comparing is performed without any multiply or divide operations. In some examples, the comparing is used to determine an ordering of said pixels. Some examples include assigning the color or hue based on a Hamming distance or based on a result of a string matching operation.

Naturally, the examples taught above can be practiced using filters, and filter cells, having attributes detailed earlier.

### CMYRGB Filter Arrangements

Assume that a color filter array designer only has six choices of color resist at their disposal, namely red R, green G, blue B, cyan C, magenta M, and yellow Y. These colors are commonly available from commercial vendors. They are thus economical, and manufacturing processes using such resists are well-understood. Table III gives an exemplary set of transmission functions for such filters.

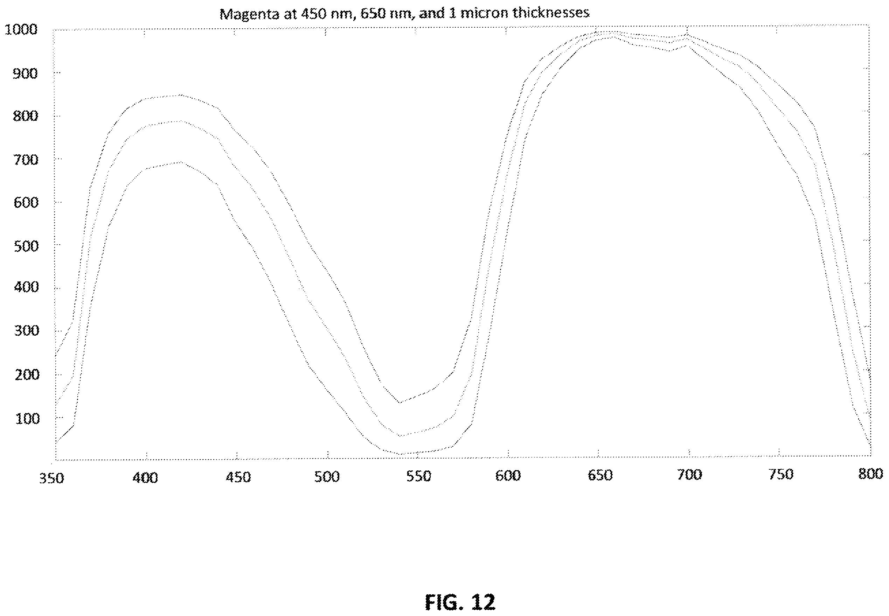

The transmission functions of filters employing such resists can be varied by varying their thicknesses, in accordance with the Beer-Lambert law. Such variations can include changing the widths of maxima and minima, and changing filter slopes. Fig. 12 is exemplary and shows the transmission function of a magenta resist at thicknesses of 450 nm, 850 nm and 1.0 micron thicknesses, at various wavelengths. By making plural filters within a filter cell using the same color resist, but with different thicknesses, different filtering functions can be achieved, thereby expanding the filter palette from the initial set of, e.g., six, resists.

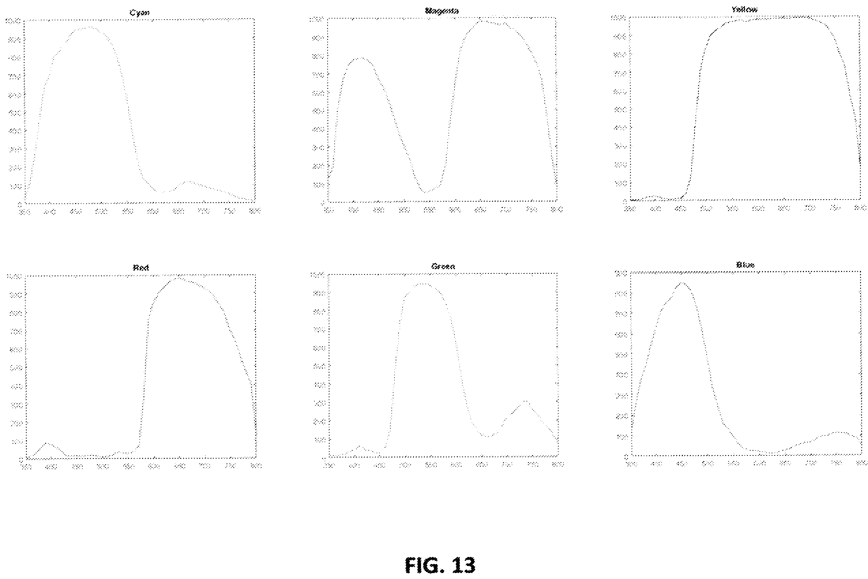

Fig. 13 shows exemplary spectral response functions for the six colors CMYRGB, each applied with a thickness of one micron. (The units are arbitrary, where 1000 denotes fully transparent and 0 denotes fully opaque. Note that the yellow slope between 450 and 500 nm is nearly identical with the green slope in this same range of wavelengths. Informationally, this is non-ideal. Similar redundancies occur with other pairings of filters.

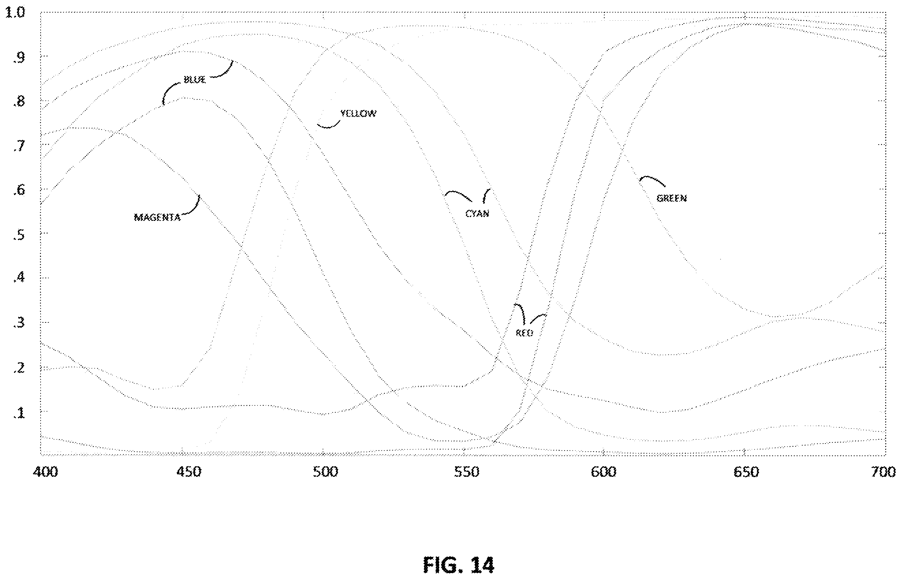

Fig. 14 illustrates how varying thicknesses can give rise to significantly different linearly-independent spectral filter functions. The two blues, the two cyans and the two reds are all doubled up, each with curves depicting the transmission function for resist thicknesses of 800 nm and 350 nm. This set of nine curves is produced using only six color resists. Arrangements described elsewhere in this disclosure, employing nine diverse filter functions, can thus be realized using just six resists.

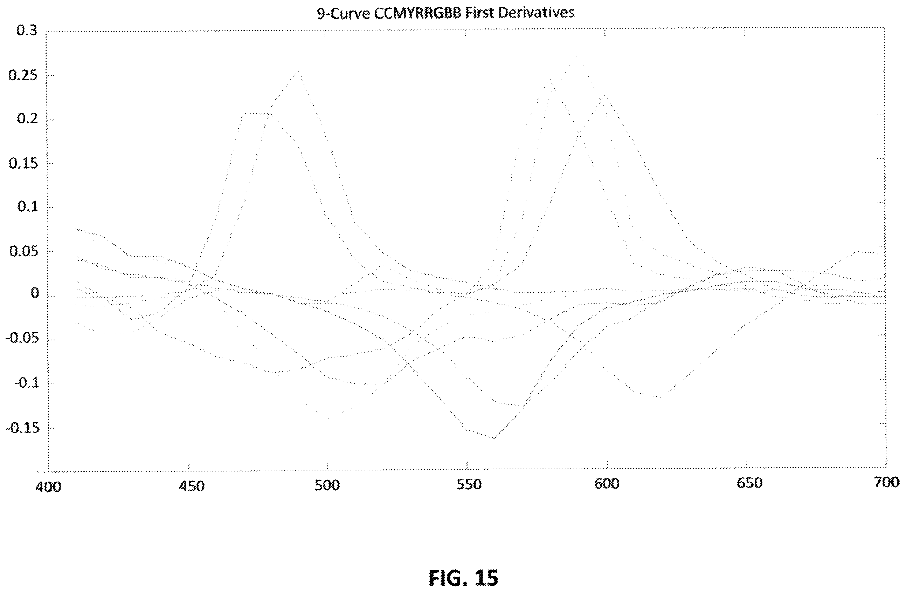

Fig. 15 is slightly more abstract but simply depicts the first derivatives (i.e., slopes) of the curves of Fig. 14. It is from the interactions of slopes whereby spectral information derives, and here we see that there is a nice diversification of slopes that the thick/thin bifurcations give rise to. It can be seen, for example, that the thick red 'peaks in slope' are roughly 10 nm shifted from where the thin red peaks are; this diversification is a primary driver behind color accuracy. There are various physical and manufacturing approaches that can be utilized to produce such thick/thin bifurcations (or tri-furcations for that matter) of a single-color resist.

One approach is to form a layer of unpigmented, transparent, stabilized (cured) positive- or negative- photoresist at each of certain filter locations within a cell. This creates an elevated, clear pedestal (platform) on which a subsequent layer of resist can be applied, serving to thin a layer of resist thereafter applied at that location relative to other locations that lack the transparent resist.

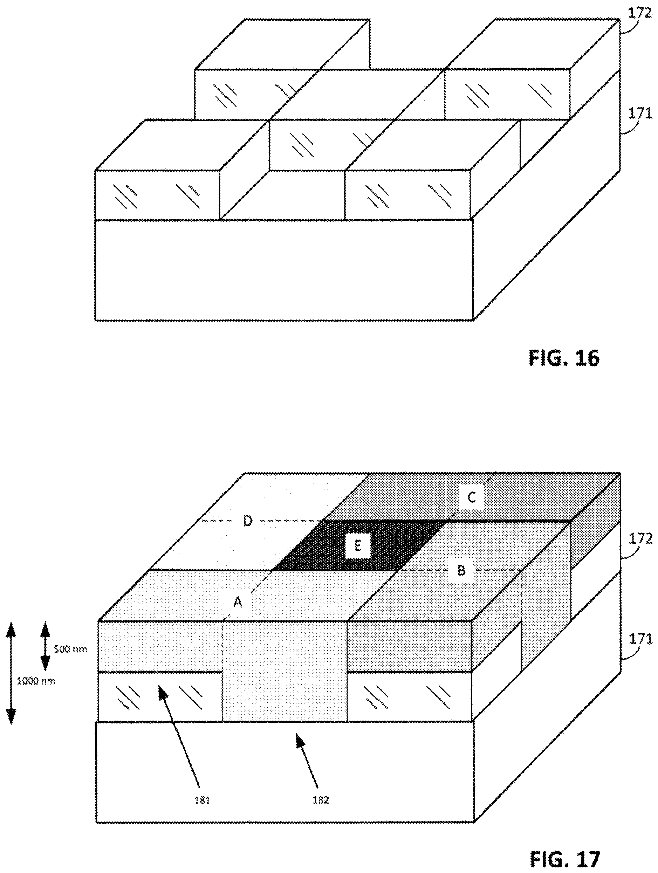

Fig. 16 illustrates the concept. In this example, a transparent resist is applied, exposed through a mask, developed and washed (sometimes collectively termed "masked") on a photosensor substrate 171 to form transparent pedestals 172 at five locations in a nine-filter cell. The resist may have a thickness of 500 nm. Fig. 17 shows this excerpt of the sensor after five subsequent masking layers have defined five colored filters - such as red, green, blue, cyan and magenta.

A first pigmented resist, identified as "A," is applied in a liquid state to the Fig. 16 structure. Where a transparent pedestal is absent, the resist pools down to the sensor substrate, forming a layer of, e.g., 1000 nm thickness, as shown by the longer double-headed arrow to the left in Fig. 17. At locations where a transparent pedestal is present, the liquid resist doesn't pool down to such a depth, but rather rests atop the pedestal, forming layer of 500 nm thicknesses. This resist is masked and washed-away from locations other than where resist "A" is desired. This results in a cell having filter layers of different thicknesses of resist "A" - a thin layer 181 where a transparent pedestal is present, and a thick layer 182 where a transparent pedestal is absent. Such filters of differing thicknesses have differing filtering functions, in accordance with the Beer-Lambert law.

Per the Beer-Lambert law, if a first filter of an absorbent medium has a layer thickness L₁ and a transmission T₁ (on a scale of 0-1), then a second filter of the same medium, having a layer thickness L₂, will have a transmission function T₂ as follows: ${T}_{2} = {{T}_{1}}^{\frac{{L}_{2}}{{L}_{1}}}$

The above-detailed process is repeated a second time using a second resist "B." Again, the "B" resist flows down to the substrate where transparent pedestals are absent, and pools on top of the transparent pedestals where they are present. The pigment layer is masked to leave regions of pigment "B" of two thicknesses - thin where the pigment rests on a transparent pedestal, and thick where the pigment rests on the substrate.

In the depicted example, this process is repeated two more times, with resists "C" and "D." For each color, a thick filter layer and a thin filter layer are formed - the latter being at locations having transparent pedestals. Finally, a fifth resist "E" is applied to the wafer, and masked to create a filter at the center of the color filter cell. Referring back to Fig. 16, it can be seen that there is a transparent pedestal at this location. Thus, resist layer "E" nowhere extends down to the photosensor substrate, but rather rests atop the transparent pedestal, only in a 500 nm layer.

The Fig. 17 arrangement thus includes nine different filtering functions, but is achieved with only six masks (one to form the transparent pedestals, and one for each of the five colored pigment layers).

In the illustrated example, the thicker and thinner filter layers of the same color resist have thicknesses in the ratio of 2:1 (i.e., 1000 nm and 500 nm). But this need not be the case. Such ratios can range from 1.1:1 to 3:1 or 4:1, or larger. Commonly the ratio is between 1.4:1 and 2.5:1, with a ratio between 1.5:1 and 2:1 being more common.

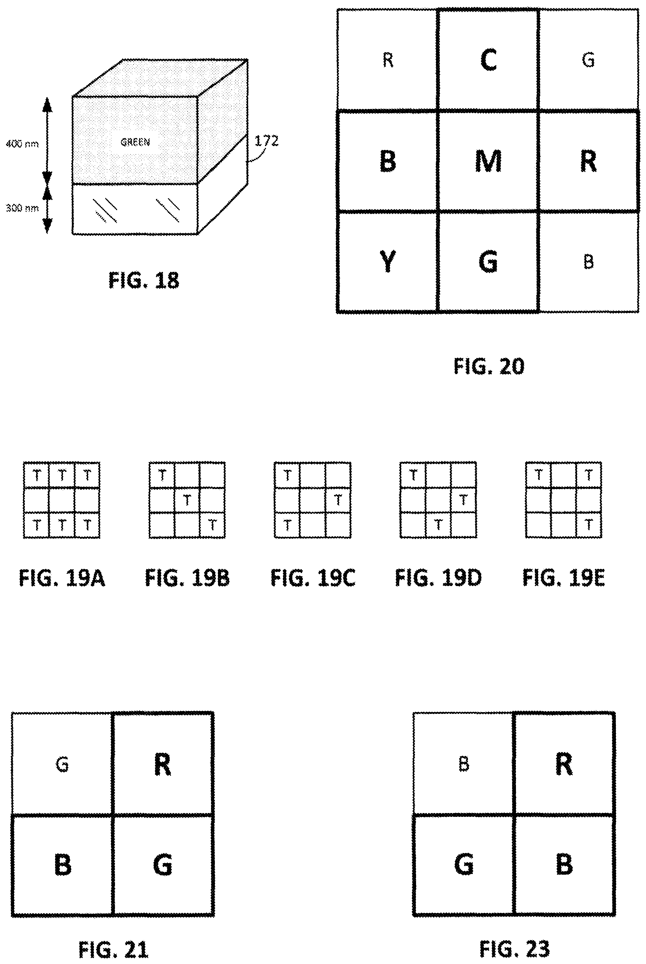

Fig. 18 shows an excerpt from a color filter cell in which a green resist layer of 400 nm thickness is formed atop a transparent pedestal of 300 nm thickness. Elsewhere in this color filter cell may be a green pigment layer that extends down to the level on which the transparent pedestal is formed, with a thickness of 700 nm. The thick-to-thin ratio in the case of these green-pigmented filter layers is thus 1.75:1 (i.e., 700:400).

In some exemplary embodiments, the pedestals have heights between 200 and 500 nm, and resist is applied to depths to achieve thick filters (where no pedestal is located) of 600 to 1100 nm. In one particular embodiment, the pedestals all have heights of 200-300 nm. In the same or other embodiments, resist is applied to form thick filters of 700 - 1000 nm thickness (with thinner filters where pedestals are located).

In Fig. 17, thin and thick filters of a given resist color edge-adjoin each other. This is not necessary. In some implementations, such thin and thick filters of the same resist color corner-adjoin each other, or do not adjoin each other at all. Some CFAs (or cells) have combinations of such relationships, with thin and thick filters of a first color resist corner-adjoining each other, and thin and thick filters of a second color edge-adjoining each other, or not adjoining at all. Some CFAs or (cells) are characterized by all three relationships: corner-adjoining for thin and thick filters of a first color, edge-adjoining for thin and thick filters of a second color, and not adjoining for thin and thick filters of a third color.

The checkerboard pattern of transparent pedestals in Fig. 16 can be inverted, with the four corner locations and the center location lacking pedestals, and pedestals instead being formed at the other four locations. Instead of four or five pedestals, a cell can include a greater or lesser number, ranging from 1 up to one-less than the total number of filters in the cell. As long as the number of pedestals is less than the number of filter elements in a cell (i.e., some filter elements do not rest on pedestals), the array of pedestals may be termed "sparse." That is, not every photosensor (or microlens) is associated with a pedestal.

One embodiment is thus an image sensor including a sparse array of transmissive pedestals, with an array of photosensors disposed below the pedestals and colored filter media (e.g., pigment) disposed above the pedestals. The sparse array may be a checkerboard array, but need not be so. Such arrangement commonly includes filter elements of thicker and thinner dimensions, the filter elements of thinner dimensions each being disposed above one of the transmissive pedestals.

Although the usual case is that the pedestals of a checkerboard, such as in Fig. 16, meet at their corners, this is not essential. A gapped checkerboard pattern can comprise such an array of pedestals without meeting at the corners (e.g., by reducing the sizes of each of the Fig. 16 pedestals in horizontal dimensions, by 1% or more (e.g., 2%, 5%, 10%, 25% or 50%).

Figs. 19A-19E show a few such sparse patterns, with "T" denoting filter locations with transparent pedestals. Each of these, in turn, can be inverted, with transparent pedestals formed in the unmarked locations rather than the "T"-marked locations. As can be seen, the transparent pedestal locations can be edge-adjoining, corner adjoining, or not adjoining, or any combination of these three within a given cell. (Here, as in the earlier discussion of thick and thin filters of the same color, the adjacency relationships are stated in the context of a single cell. Once a cell is tiled with other cells, different adjacencies can arise.)

One advantageous arrangement comprises a 3 x 3 filter cell formed with seven masking steps, one to form the pattern of transparent pedestals, and one for each of six subsequently-applied colored resists, such as red, green, blue, cyan, magenta, and yellow. (Sometimes the former three colors are termed primary colors, and the latter three colors are termed secondary colors.)

Fig. 20 shows a cell of this sort that includes three transparent pedestals, using the pedestal pattern of Fig. 19E. The three locations with transparent pedestals (in three of the four corners) yield less-dense color filters, since such filters are physically thinner. These are shown by lighter lines and lettering. The locations lacking transparent pedestals yield more dense color filters, since such filters are physically thicker. These are shown by darker lines and lettering.

In this example, each of the three primary-colored filters appears twice in the color filter cell - once in a thinner layer and once in a thicker layer. Each of the secondary-colored filters appears only once in the cell - each time in a thicker layer (i.e., not formed atop a transparent pedestal).

In other arrangements, the filters that appear twice in the cell can be secondary colors. In still other embodiments, the filters that appear twice in the cell can include one or more primary colors, and one or more secondary colors.

Naturally, it is not required that all three of the primary colors, and all three of the secondary colors, be included in such a cell. Filters of other functions can be included - including filters with desired ultraviolet (e.g., below 400 nm) and infrared (e.g., above 750 nm) characteristics, and filters of the diverse, non-conventional sorts detailed earlier. Each such filter can be included once in the cell, or can be included twice - once thin and once thick. Of course, it is not required that there be three transparent pedestals in a 3 x 3 cell; there can be more or less. In some 3 x 3 cells, six transparent pedestals are employed, so that six of the filter layers are relatively thinner, and three filter layers are relatively thicker. As in other embodiments detailed in this specification, certain pixels may be un-filtered (panchromatic), e.g., by a color resist that is transparent at all wavelengths of concern.

Of course, transparent pedestals to achieve thinner filter layers can be employed in cells of sizes different than 3 x 3, such as in cells of size 4 x 4, 5 x 5, and non-square cells.

Another exemplary implementation is shown in Fig. 21 - this one based on the 2 x 2 Bayer cell. Here, however, a first masking operation defines a transparent pedestal at one of the four pixel locations (in the upper left, indicated by the lighter lines and lettering). Three other masking operations follow, defining four color filters: one of red, one of blue, and two of green. The green filter in the upper left, formed atop the transparent pedestal, is thinner than the green filter formed in the lower right. (The green filter in the upper left is also thinner than the red and blue filters.) Being thinner, this thin green filter passes more light than the thicker green filter (which, like the red and blue filters, is of conventional thickness). This increases the sensor's efficiency. Being thinner also broadens-out the spectral curve, in accordance with the Beer-Lambert law. This changes the slopes and positions of the filter skirts, enabling an improvement in color accuracy.

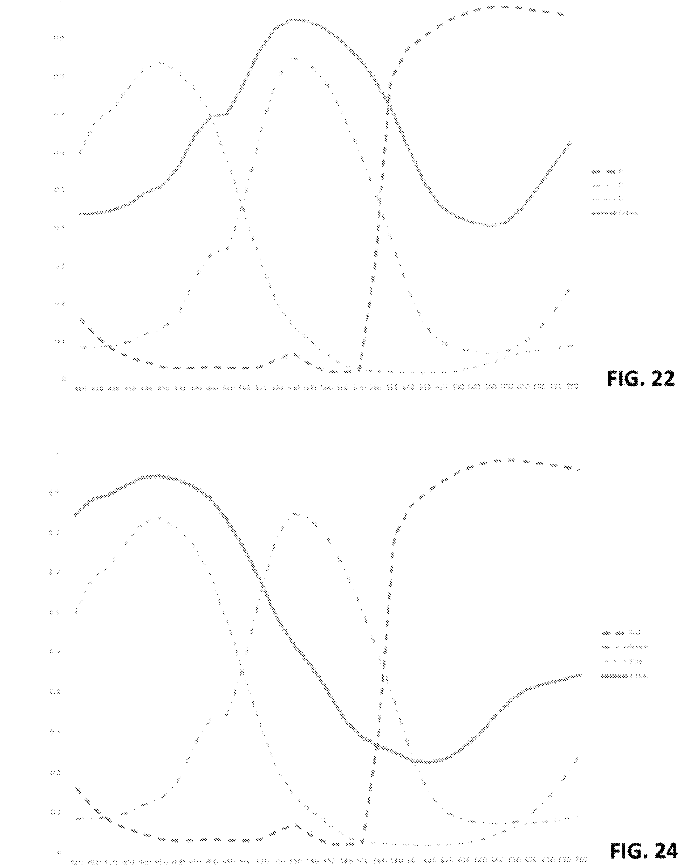

Fig. 22 shows exemplary spectral curves for the four filters in the cell of Fig. 21, with the thin green filter shown in the solid bold line. This plot is for the case that the thin filter is one-third the thickness of the other filters. (The red, green and blue curves are based on the data of Table III.)

The Bayer cell employs two green filters in its 2 x 2 pattern in deference to the sensitivity of the human visual system (HVS) to green. If a sensor is to serve machine vision purposes, then the HVS-based rationale for double-green is moot, and another color may be doubled, i.e., red or blue. Fig. 23 shows a variant Bayer cell employing two diagonally-adjoining blue filters, one thick and one thin. Fig. 24 shows transmission curves for such an arrangement. The thin blue filter curve is shown by the bold solid line. Here again, the thin filter is one-third the thickness of the other filters. As with Fig. 22 arrangement, this modification increases the efficiency of the sensor, and diversifies the spectral curves - enabling better color accuracy.

The cell needn't be square. Since there are six readily available pigmented resists (namely the three primary colors red, green and blue, and the three secondary colors cyan, magenta and yellow), such resists can be used to form six filters in a 2 x 3 pixel cell. Again, transparent pedestals can first be formed on certain of these pixels, so that resist that is later masked at such locations is thin relative to pixels lacking the pedestals.

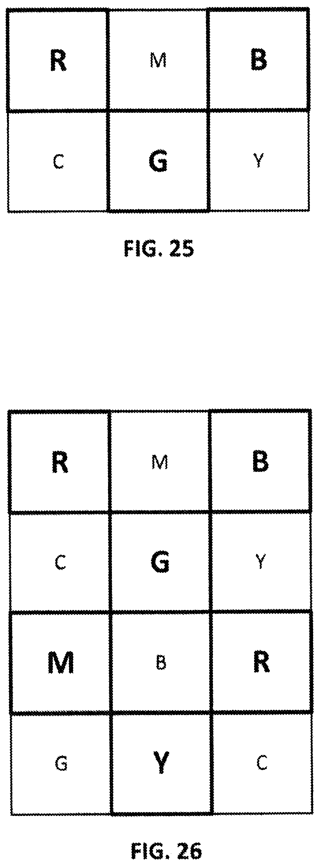

Fig. 25 shows such a cell. Transparent pedestals are formed under filters of the secondary colors, as indicated by the thin borders and the thinner lettering. Pedestals are lacking under filters of the primary colors, as indicated by the thick borders and bolder lettering.

The cell of Fig. 25 can be paired with a related cell in which the filter colors are each moved one pixel to the left, while the former pedestal pattern is maintained. This is shown in Fig. 26. The top two rows comprise the cell of Fig. 25. The lower 2 x 3 pixel cell is identical except the filters are each shifted one position to the left. The result is a 4 x 3 pixel cell of 12 filters, containing thin and thick filters of four of the six colors, together with two thin filters of the fifth color (here cyan) and two thick filters of the sixth color (here red). As in the previous examples, the thin and thick filters of a common color are formed in a single masking step - the difference being a transparent pedestal underneath the thin filter. Thus, only seven masking steps are used to produce the cell of Fig. 26 (and a CFA formed of multiple cells), despite including ten different filter functions. The diversity of slopes provided by the ten different filter functions enables improved color accuracy. The six thin filters also serve to provide increased efficiency.

Thus, one embodiment comprises an image sensor with a sparse (e.g., checkerboard) pattern of transparent pedestals spanning the sensor, where this pattern defines interspersed locations of two types: relatively raised locations and relatively lowered locations. A contiguous region of the sensor includes cyan, magenta and yellow filters at locations of one of said types (e.g., relatively lowered, i.e., without pedestals), and red, green and blue filters at locations of the other of said types (e.g., relatively raised, i.e., with pedestals).

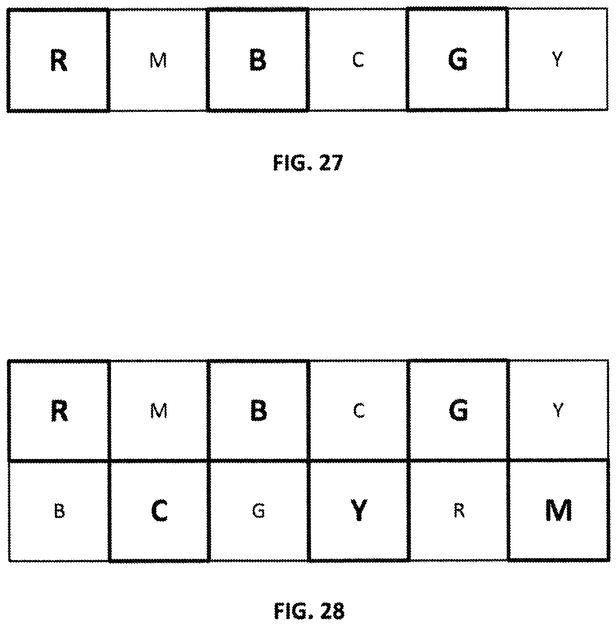

Another arrangement employing all six of the primary/secondary colors is shown in Fig. 27. This is a 1 x 6 linear cell, with every other filter element formed on a transparent pedestal (underlying the secondary magenta, cyan and yellow filters in this embodiment, although one or more primary colors can be substituted).

A second row can be formed with the pedestals shifted one position horizontally, so that each pedestal corner-adjoins another. This second row can be overlaid by the same sequence of filters as in Fig. 27, but shifted two places to the left. The 2 x 6 cell of Fig. 28 then results. It will be recognized that this 12-filter cell includes a thin and a thick filter for each of the six colors, providing 12 different filtering functions. This large number of diverse filter functions enables excellent color accuracy, while the large number of thin filters provides high efficiency. Like the cell of Fig. 26, such a cell can be fabricated with just seven masking operations - one for the transparent pedestals, and one for each of the six colors.

The Fig. 28 cell can be replicated in a tiled arrangement, with identical 2 x 6 cells positioned to the left, right, top and bottom, repeated as necessary to span the area of a photosensor. This results in a checkerboard-like arrangement of pixels having transparent pedestals. These transparent pedestals are defined in the initial masking step. The resulting 3D checkerboard structure provides square wells that facilitate creation of the color filters at the intervening pixel locations in subsequent masking steps. (The Fig. 16 arrangement appears as such a checkerboard, but when tiled with like structures, many of the transparent pedestals are found to edge-adjoin other pedestals, rather than only corner-adjoining other pedestals - as is the case in a checkerboard.)

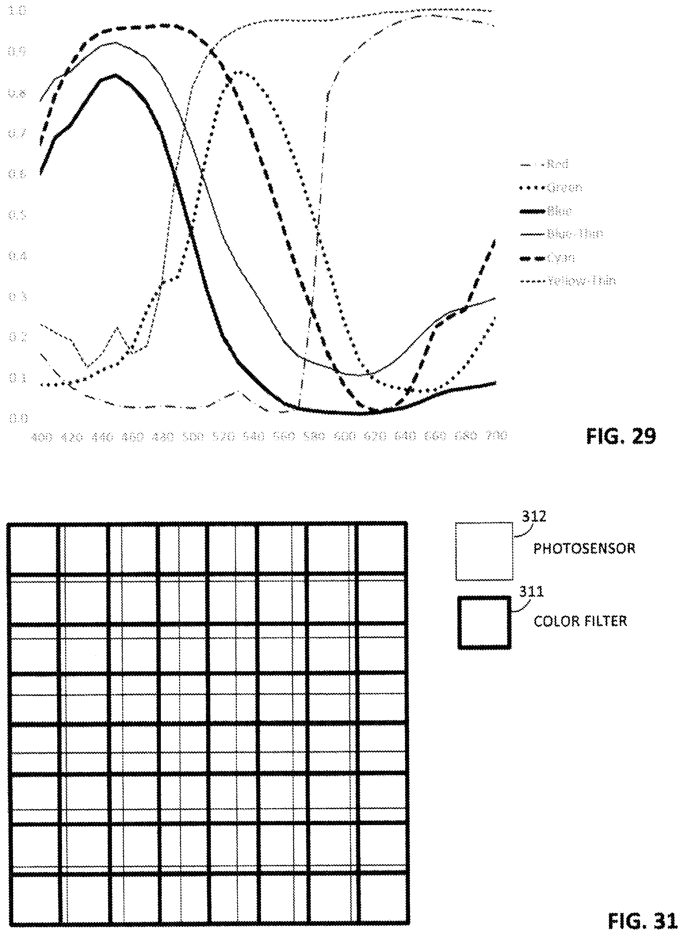

Fig. 29 shows group-normalized transmission functions for a six-element cell employing five resists. There are two filters formed with a blue resist - one thick and one thin (e.g., about 1000 nm and about 500 nm). There are three other thick filters (e.g., about 1000 nm): red, green and cyan. Finally, there is one yellow thin filter (e.g., about 500 nm). It will be understood that such arrangement can form the thin filter elements atop clear pedestals having heights of about 500 nm.

This is a species of a more general color filter cell embodiment characterized by comprising N>3 filter elements, two of which are formed of the same resist but one has a thickness of between 80% and 20% (and preferably between 66% and 33%, and most preferably between 60% and 40%) that of the other.

This is also a species of a color filter embodiment characterized as by comprising N>3 filter elements in which two or more of the filter elements are relatively thin, having thicknesses that are between 80% and 20% (and preferably between 66% and 33%, and most preferably between 60% and 40%) the thickness of another filter element in the cell. **In** one such arrangement, one of the relatively-thin elements has a relatively-thick counterpart element formed of its same material in the cell, while another of the relatively-thin elements does not have a relatively-thick counterpart element formed of its same material in the cell. **In** one such arrangement, one of the thin filters is a red-, green- or blue-passing filter, and another of the thin filters is, respectively, a red-, green, or blue-attenuating filter (i.e., a cyan, magenta or yellow filter).

There are many further variants. For example, two masking operations can be utilized to form two layers of transparent pedestals, some atop others. For example, a first masking operation can create six 500 nm-thick pedestals at locations in a 3 x 3 cell. A second masking operation can form three more pedestals, e.g., 300 nm thick - each atop one of the 500 nm pedestals created with the first masking step. This results in a first set of three pedestals of 500 nm thickness, and a second set of three pedestals of a total 800 nm thickness. Three other locations in the cell have no pedestal. When the latter locations are flooded with color resist to a thickness of 1000 nm, that resist will form a layer that is 500 nm thick atop transparent pedestals of the first set, and will form a layer that is 200 nm thick atop transparent pedestals of the second set. A color resist can thus form filters of two, or three, different thicknesses in a single masking operation.

In one such embodiment, following the two masking operations that form the pedestals of different thicknesses, three further resists are successively applied and masked, to create filters of three different colors (e.g., selected from red, green, blue, cyan, magenta and yellow). Each of these resists can be masked at positions corresponding to the three different thicknesses. Five masking operations then yield nine different filter functions.

In another variant, the pedestals are not transparent (clear), but rather are selectively spectrally-absorbing, such as by use of a color resist. Such arrangement yields the same thickness-modifying results as discussed above, but with the added spectral modulation of the pedestal color. Each of the above-described arrangements can be practiced using spectrally-absorbing pedestals. (While "transparent" or "clear" pedestals have transmission of 98% or more over 400 - 700 nm, spectrally-absorbing pedestals have less transmission at certain wavelengths. We use the generic term "transmissive" pedestals to encompass both transparent and spectrally-absorbing pedestals.)

In certain embodiments, some or all of the pedestals are formed with a resist that cuts infrared (e.g., a pigmented resist). If one filter in a cell is formed on such an IR-cutting pedestal, and another filter is formed of the same resist but not on an IR-cutting pedestal (e.g., it is formed not on a pedestal, or is formed on a pedestal that transmits infrared), then the different response of the resulting two pixels, at infrared, provides information about scene content at infrared. This can be useful, e.g., in AI applications.

One particular such resist has an IR-tapered panchromatic response. An IR-tapered panchromatic response is one that is essentially panchromatic through the visible light wavelengths, having a spectral transmission function greater than 80%, 90% or even 95+% over the 400-700 nm range, but then tapering down to be less responsive into IR. In a particular embodiment, the spectral transmission function of such a resist is below 50%, 20% or 10% at some point in the 700-900 nm range, and preferably at some point in the 700-780 nm range, such as at 720, 740 or 760 nm.

In still other variants, the pedestals can have optical functions, e.g., if their index of refraction is greater or less than that of the overcoated photoresist.

Positive and negative photo resists can both be used in the detailed arrangements. The choice of tonality can be based on practical considerations, such as photo speed, resolution, sidewall slopes/aspect ratio, implant stopping power or etch resistance, and flow properties.

Resists with high solid content (like pigment loaded CFA resists) often work best in a negative tone, since the so-called "gravel" (the solid content) is easiest to remove if the resist matrix that is not exposed by the lithographic process has the best possible solubility in the developer. If a positive resist is chosen, the volume to be removed first needs to be solubilized by exposure, which may lead to more residue formation. Also, due to light absorption with depth, sidewall profiles would tend to be more gradual, which is undesirable in a contiguous CFA array.

Creation of pedestals adds of a further degree of variability to the manufacturing process. This variability can be measured and memorialized in a Chromabath process as detailed herein, just as with other process variations. Gaussian variability in thickness of the (thinner) layers formed atop the pedestals will likely be larger, percentage-wise, than variability in thickness of filters not formed atop pedestals - another dimension of variability that can be characterized in the Chromabath process.

An embodiment according to one aspect of the technology is a color filter cell including a first filter comprised of a first colored resist formed on a transparent pedestal, and a second filter comprised of said same first colored resist not formed on a transparent pedestal, wherein the second filter has a thickness greater than the first filter.

An embodiment according to another aspect of the technology is a photosensor that includes a checkerboard pattern of transparent pedestals spanning the photosensor.

An embodiment according to another aspect of the technology is a color filter cell having filtered pixels with N different spectral transmission functions, created using just M masks, where M < N. In some such embodiments, M=N-1; in other such embodiments, M=N-2, or M=N-3, M=N-4, or M=N-5.

Producing more pixel spectral profiles than there are masks to produce those profiles, via the mechanism of thickness of the layers, is one way to achieve a set of diverse filter functions. In some embodiments, the filters are drawn only from CMYRGB color resists.

While this section has focused on commercially available conventional R, G, B, C, M, Y and infrared resists, it should be understood that the detailed teachings can be applied to filter media of any sort, including filters (and filter cells) having attributes discussed earlier in this specification, including non-normative filters.

### ExamplesEmploying Near Infrared

Image sensors that produce red, green, blue and near infrared channels of output data are known. The Canon 120MXS sensor is exemplary and comprises an array of silicon pixels overlaid with a color filter array, each cell of which includes three visible light filters (a red, a green, and a blue), and a near infrared filter. The infrared output channel enables discrimination between image features that appear otherwise identical based on red, green and blue data alone.

In accordance with certain examples of the present technology, an image sensor includes four pixels filtered to yield maximum outputs (i.e., exhibit maximum sensitivity) between 400 and 700 nm. These are termed visible light pixels, in contrast to the NIR-filtered pixels used in image sensors such as the Canon 120MXS. At least two of these four pixels have strong color responses at wavelengths extending through red (e.g., 650 nm) and into the near infrared (i.e., above 700 nm). The sensitivity of these two or more visible light pixels into the near infrared enables generation of four channels of image data, at least one of which is influenced by infrared image content.

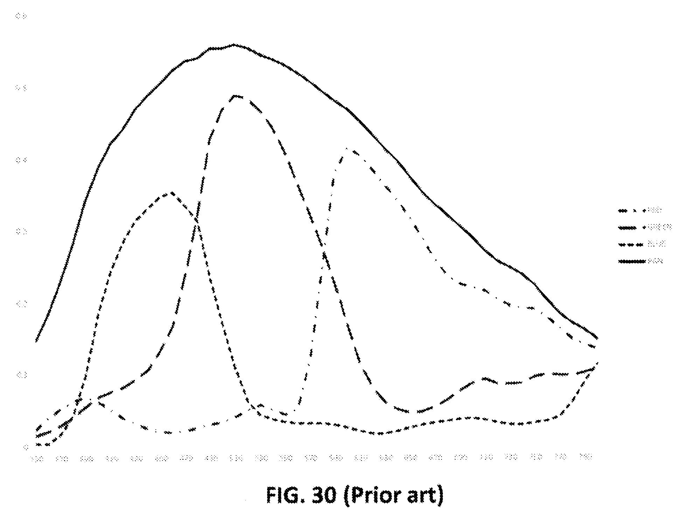

Fig. 30 is taken from a Canon datasheet for the 120MXS sensor and shows responses of its red, green and blue filtered pixels into the near infrared range. Also shown in Fig. 30, in solid line, is the response of pixels in the monochrome version of the Canon sensor. This is the sensor's panchromatic response, i.e., without an overlaid color filter array. The shape of this panchromatic response curve is primarily due to the quantum efficiency of the silicon photosensors but also is influenced by the sensor's microlens array and other factors.

Reference was made, above, to filtered pixels that have "strong" responses at certain wavelengths. As used herein, a strong response is one that is greater than 50%, and preferably greater than 60%, 70% or 80%, of the panchromatic (unfiltered) response of the sensor at that wavelength. For example, the red-filtered pixels in the Fig. 30 sensor have strong responses from 580 nm up to and through 800 nm, with the responses exceeding 60% from 590 - 800 nm, exceeding 70% over the same range, and exceeding 80% from 600 - 660 nm and 740 - 800 nm.

Responses of the red, green and blue pixels in the Canon sensor, as percents of the sensor's panchromatic response over the 350 - 800 nm range, are shown in Table XXIII:

**TABLE XXIII**

| Wavelength | Red | Green | Blue |
|---|---|---|---|
| 350 | 16.5% | 10.4% | 2.9% |
| 360 | 21.8% | 11.5% | 2.0% |
| 370 | 22.8% | 12.7% | 7.7% |
| 380 | 22.5% | 14.3% | 15.6% |
| 390 | 20.2% | 16.3% | 29.0% |
| 400 | 15.9% | 17.8% | 48.1% |
| 410 | 12.1% | 18.1% | 58.0% |
| 420 | 8.9% | 18.7% | 64.5% |
| 430 | 6.7% | 19.9% | 66.8% |
| 440 | 5.1% | 21.8% | 67.8% |
| 450 | 4.2% | 26.6% | 68.9% |
| 460 | 3.8% | 32.1% | 67.5% |
| 470 | 4.2% | 44.7% | 62.3% |
| 480 | 4.9% | 59.8% | 57.9% |
| 490 | 5.5% | 77.4% | 42.3% |
| 500 | 6.2% | 84.8% | 30.6% |
| 510 | 7.5% | 87.4% | 19.3% |
| 520 | 9.1% | 87.4% | 11.2% |
| 530 | 10.6% | 85.9% | 8.0% |
| 540 | 9.4% | 82.7% | 7.1% |
| 550 | 8.4% | 77.3% | 6.4% |
| 560 | 10.1% | 70.4% | 6.2% |
| 570 | 23.8% | 63.6% | 6.3% |
| 580 | 50.5% | 56.2% | 6.5% |
| 590 | 78.8% | 47.0% | 6.3% |
| 600 | 88.6% | 35.7% | 5.6% |
| 610 | 89.3% | 25.2% | 4.8% |
| 620 | 88.8% | 18.9% | 4.2% |
| 630 | 87.4% | 14.8% | 4.4% |
| 640 | 86.1% | 12.9% | 5.6% |
| 650 | 84.7% | 12.6% | 7.0% |
| 660 | 82.0% | 13.7% | 8.6% |
| 670 | 77.4% | 16.4% | 9.8% |
| 680 | 73.8% | 20.3% | 11.0% |
| 690 | 73.7% | 25.4% | 12.4% |
| 700 | 76.1% | 30.4% | 13.6% |
| 710 | 79.7% | 34.4% | 13.6% |
| 720 | 79.6% | 33.7% | 12.7% |
| 730 | 78.5% | 34.9% | 12.1% |
| 740 | 80.7% | 36.8% | 12.7% |
| 750 | 85.4% | 43.2% | 14.7% |
| 760 | 88.4% | 49.2% | 17.5% |
| 770 | 88.2% | 53.3% | 22.7% |
| 780 | 87.2% | 57.4% | 36.1% |
| 790 | 87.4% | 63.0% | 55.4% |
| 800 | 90.7% | 73.0% | 76.8% |

While the just-given definition of "strong" compares a pixel's filtered response at a wavelength to its panchromatic response at that wavelength, sometimes the latter datum is not available. In such case, a suitable definition of "strong" compares a pixel's filtered response at a wavelength to its maximum response within the wavelength range 400 - 700 nm. The peak response of visible light pixels diminishes with increasing wavelengths, e.g., to about 70% of the peak response at 650 nm, 50% of peak response at 700 nm, and 40% of peak response at 750 nm. If a pixel's filtered response at one of these wavelengths (relative to its peak response) is more than half of the just-given percentages, the pixel is said to have a strong response at that wavelength. For example, if a red pixel has a peak response of 0.9 (on some arbitrary scale) at 600 nm, and its response at 700 nm is 0.3 (i.e., 33% of the peak response), then this is judged to be a strong response, since 33% is greater than half of the 50% figure referenced above in connection with 700 nm. (Again, a pixel's strong response preferably exceeds half of the figures given above, such as 60%, 70% or 80%, of the just-given percentages.)

Another way to judge a "strong" response is by reference to the spectral transmission function of a pixel's respective filter. If a filter passes 50% or more of illumination incident onto the filter to the photosensor below at a given wavelength, the pixel can be said to have a strong response at that wavelength.

Thus, one example comprises an image sensor including four pixels that are most sensitive between 400 and 700 nm, where each pixel has a photosensor and a respective filter that causes the pixel to have a color response different than the others of the four pixels. The filters of at least two of the four pixels pass at least 50% of illumination incident on the filter onto their respective photosensors, at wavelengths from 650 nm to above 700 nm.

At wavelengths between about 500 and 780 nm, yellow-filtered pixels have strong responses, above 70% and commonly over 80% over panchromatic responses at such wavelengths (yellow filters being panchromatic except for blocking blue wavelengths below 500 nm). Between 640 and 780 nm, yellow-filtered pixels have responses that are very close to those of red-filtered pixels detailed in the above table. The yellow pixels, however, have greater efficiencies (e.g., over a spectrum extending between 400 and 750 nm) than the red pixels.

As noted, the presently-discussed examples comprise image sensors including four pixels that have peak responses in the visible light wavelengths. At least two of these four pixels have strong color responses at wavelengths extending through red (e.g., 650 nm) and into the near infrared

**In** a first class of such examples, the four visible light pixels include exactly three that are filtered to be primary-colored pixels, and one that is filtered to be a yellow- or magenta-colored pixel. **In** a second class of such examples, the four visible light pixels include exactly two that are filtered to be primary-colored pixels.

**In** an example of the first class of examples, the four visible light pixels are filtered to be red, green, blue and yellow pixels. The red and yellow pixels respond strongly at wavelengths in the near-infrared (e.g., 700 - 800 nm). With four channels of image data, differently-responding to an imaged scene at wavelengths from blue into the near-infrared, it is possible to extract four channels of output data. Three of these channels can be red, green and blue - representing image scene content as perceived by receptors of the human eye. The fourth channel can be made to vary in accordance with near infrared scene content (but need not vary exclusively in accordance with near infrared scene content).

In an example of the second class of examples, the four visible light pixels are filtered to be red, green, yellow and IR-tapered panchromatic pixels. The IR-tapered panchromatic pixels are essentially panchromatic through the visible range, but their responses drop in the near-infrared. For example, such pixels can exhibit responses that are within 80%+ (and preferably 90%+ or 95%+) of the sensor's unfiltered responses from 400 to 700 nm (i.e., their spectral transmittal function is 80%, 90% or 95+% from 400 to 700 nm), but are less responsive somewhere above 700 nm. In a particular example, these pixels are filtered so their transmission function drops to below 50%, 20% or 10% of corresponding panchromatic levels at some point in the 700 - 900 nm range, such as at 700, 740 or 780 nm.

Again, the red and yellow pixels in this exemplar of the second class of examples respond strongly at wavelengths in the near-infrared. The four channels of image data in this arrangement do not include a channel sensed by a blue pixel, but the IR-tapered panchromatic pixels are sensitive to blue. Here again, with four channels of image data that differently-respond to an imaged scene at wavelengths from blue into the near-infrared, it is possible to extract four channels of output data. As in the former example, three of these channels can be red, green and blue - representing image scene content as perceived by receptors of the human eye, while the fourth channel can be made to vary in accordance with near infrared scene content.

It will be understood that at least the red and yellow pixels in the examples in this discussion (and in many examples the blue and green filters as well) lack the infrared blocking filter (sometimes termed a hot mirror filter) that is commonly used with image sensors. Alternatively, IR-attenuating filters may be used, but may allow significant pixels responses in the near infrared, such as a response at 750 nm of 5% or more of peak response within the visible light range.

Examples described in this section can also be implemented by forming certain filters on IR-filtering pedestals, as described earlier.

The described examples can naturally make use of filters, and filter cells, having attributes detailed earlier. Except as expressly stated, red, green, blue, cyan, magenta and/or yellow filters are not required.

### Spatially-Varying Color Filter Arrays

Color image sensors typically comprise an array of photosensors, overlaid with a corresponding array of color filters. The filters are carefully aligned so that each filter corresponds to one, or an integral number of, photosensors.

In accordance with certain aspects of the technology, this alignment constraint is not maintained. A color filter array may casually, or deliberately, be positioned over a photosensor array so that a single filter overlies a non-integral number of photosensors. Some photosensors may be overlaid by plural filters. In some examples, the photosensors and filters have different dimensions to contribute to this effect

In one such example, side dimensions of photosensors and filters have a non-integral ratio. One such arrangement is shown in Fig. 31, which shows an excerpt from a color image sensor, with color filters 311 depicted by the thick-line squares, and the underlying photosensors 312 depicted by the thin-line squares. This excerpt comprises a patch of 8 x 8 color filters, overlying 7 x 7 patch of photosensors. The photosensors are thus larger than the filters. Each photosensor has a side dimension that is 8/7ths the side dimension of a color filter. Each photosensor has an area that is 64/49ths the area of a color filter.

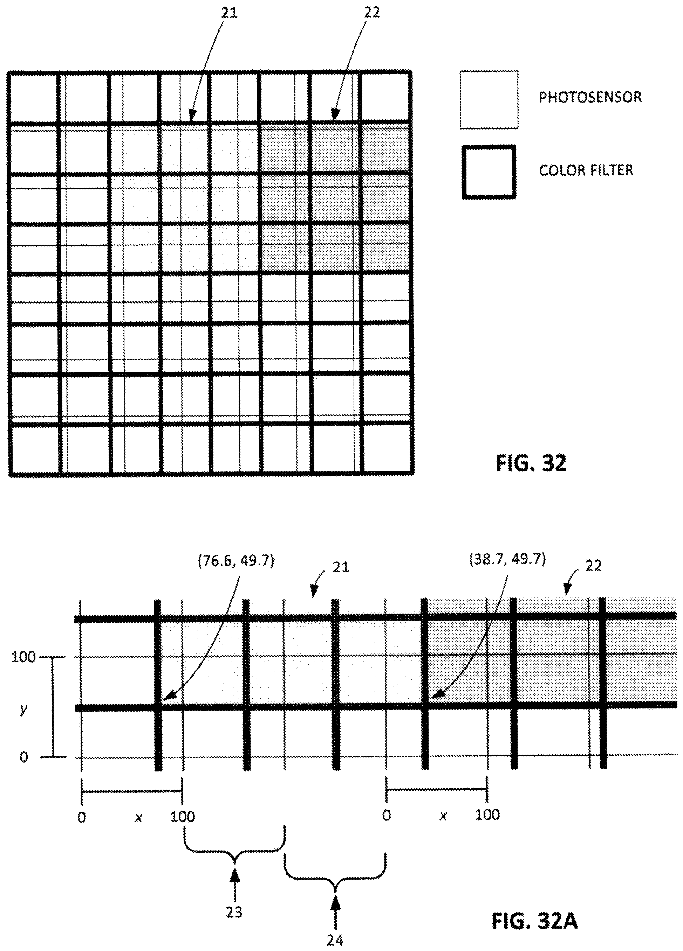

This non-integral relationship between dimensions of the filters and dimensions of the photosensors causes the positioning of filters, relative to photosensors, to shift progressively, in a modulo fashion. This is detailed further in Figs. 32 and 32A.

To review, the color filter array of an image sensor commonly comprises a tiling of multiple cells, where each cell comprises plural filters. Exemplary is the 2 x 2 cell of color filters used in the classic Bayer filter (red, green, green, blue). In the particular arrangement of Fig. 32, each of the cells comprises a 3 x 3 cell of color filters. Two such identical filter cells 21 and 22 are shown in Fig. 32, with different shadings to aid illustration.

Fig. 32A is an enlarged excerpt from Fig. 32, and serves to illustrate that filters in certain examples of the technology have different locations, relative to underlying photosensors.

The location of a filter cell can be established by any arbitrary feature of the cell. For purposes of illustration, we consider the lower left corner of a filter cell to serve as a reference point for specifying the cell's location. (Other corner points, or the center of the cell, are other possible reference points.) A filter cell's location can then be specified by a spatial relationship between this reference point and the photosensor that it underlies.

The left part of Fig. 32A is annotated with two Cartesian axes, x and y, defining a coordinate system within the leftmost of the depicted photosensors (indicated by the thin-lined squares), which is overlaid by the lower left corner of a filter cell (i.e., its reference point). Any point within the boundary of that leftmost photosensor may be specified by a coordinate along the *x* axis, which here ranges 0 to 100, and a coordinate along the *y* axis, again from 0 to 100. The position of the filter cell 21 shown by light shading is defined by such coordinate location of its lower left corner. This location is shown by an arrow in Fig. 32A and has the coordinates 76.6 and 49.7.

The position of the adjoining filter cell 22, shown by darker shading, is different. This location is again defined by the coordinate location of its lower left corner, within the photosensor area that it overlies. Again, an arrow in Fig. 32A indicates this location, and its coordinates are 38.7 and 49.7.

In like fashion, other filter cells have other locations relative to the underlying photosensors. Within a given color image sensor, there may be 5, 10, 20, 100, 1000 or a million or more different locations of filter cells relative to the underlying photosensors.

In this particular example, the *y* coordinate of each filter cell is constant among cells in a single horizontal row (i.e., 49.7 in the row that includes the light- and dark-shaded cells 21 and 22). The x coordinates vary. Put another way, the reference points for different filter cells will be different distances from the nearest adjoining column of photosensors. In this example, the distance between the reference point for filter cell 21 and the nearest adjoining column 23 of photosensors, is smaller than a distance between the reference point for filter cell 22 and the nearest adjoining column 24 of photosensors.

Reciprocally, although not depicted, the *x* coordinate of each filter cell in this example is constant among cells in a single vertical column. The *y* coordinates vary. Put another way, the reference points for different filter cells in a given column will be different distances from the nearest adjoining row of photosensors.

(We adopt the convention that rows are longer than columns. So, if a photosensor array has 3000 photosensors in one direction and 4000 photosensors in an orthogonal direction, the latter direction is the row direction.)

Color imaging devices as just-described are characterized, in part, by including J columns of photosensors, overlaid by a color filter array including K columns of color filters, where neither J/K nor K/J is an integer. Such devices may additionally, or alternatively, be characterized as including P rows of photosensors, overlaid by a color filter array including Q rows of color filters, where neither P/Q nor Q/P is an integer.

It will further be noted that plural (in fact most) of the photosensors in the Fig. 31 arrangement are overlaid, in part, by four filters. Similarly, plural (here again, most) of the filters in the Fig. 31 arrangement overlay four photosensors. (Exceptions occur around the boundaries.)

In other examples, plural photosensors are each overlaid, in part, by nine or more filters. In still other examples, plural filters each overlies nine or more photosensors.

In the Fig. 31 arrangement, with photosensor side dimensions and filter side dimensions related by the ratio 8/7, the spatial relations between photosensors and individual filters will begin to repeat after 8 rows and columns of filters, and after 7 rows and columns of photosensors. The locations of the 3 x 3 filter cells, relative to photosensors, will also repeat - although over a longer interval.

Such repetitions can be made less frequent by appropriate choice of the ratio between photosensor and filter side dimensions. In this and some other examples, the numerator and denominator of the ratio are chosen to be relatively prime (i.e., with no common factor other than 1).

In some examples, every filter cell has a different location relative to the photosensors. This can be achieved by choosing a relatively-prime ratio of filter and photosensor side dimensions, where each of the two numbers defining the ratio is larger than the largest pixel dimension of the color imaging device. For example, if the device has pixel dimensions of 4000 x 3000, each filter cell will have a different location relative to the photosensors if the side dimensions are chosen to have a ratio such as 4001/9949. (In this instance, both the numerator and denominator are primes.)

While in the arrangement of Figs. 31-32A, the photosensors are larger than the individual filters, this need not be the case. The filters can be larger than the photosensors. In both cases, it is desirable that the ratio between their side dimensions not be an integral value, e.g., not 2.

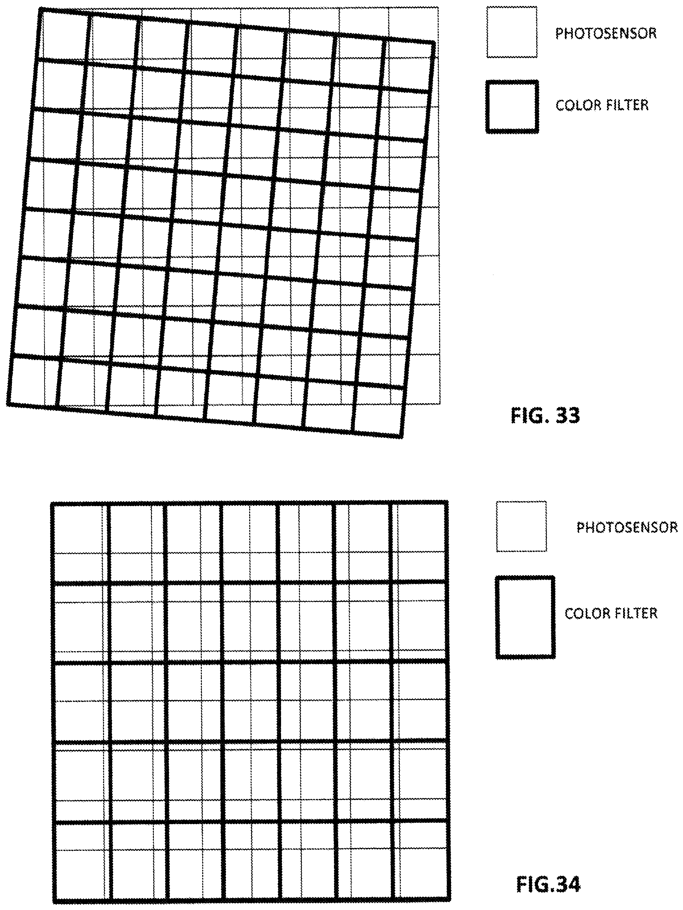

However, photosensors and filters whose side dimensions have an integral ratio, including 2 (and 1), can be used when they are overlaid in a skewed relationship, that is with rows of photosensors not parallel to rows of filters (and likewise for columns). Such an arrangement is shown in Fig. 33. Here the side ratios of filters and photosensors is 1; they are the same size. Again, because of the skew angle, different filter cells have different locations relative to the photosensors. Depending on choice of skew angle, 5, 10, 20 or more of the filter cells in the color image sensor can have different locations relative to the underlying photosensors. Again, in some examples, every filter cell can have a different location relative to the underlying photosensors.

While a skew angle between a color filter array and a photosensor array can be achieved deliberately, it can also be achieved otherwise, such as by loosening manufacturing tolerances, so that some "slop" arises in alignment of the color filter array relative to the photosensor array. Any degree of randomness in positioning (including fabricating) the color filter array over the photosensor array can introduce such skew.

As with the arrangement of Fig. 31, the arrangement of Fig. 33 introduces a progressive shift in locations of the filter cells relative to the underlying photosensors across the device.

In still other examples, the filters comprising the filter cells can have shapes different than shapes of the photosensors. For example, the filters may be elongated rectangles, while the photosensors may be squares. Such an arrangement is shown in Fig. 34. Many other different filter shapes (and photosensor shapes) can be devised, not all quadrilaterals. Again, such arrangements cause different filter cells to have different locations relative to the photosensors, with the locations progressively-shifting across the sensor.

Combinations of the just-detailed arrangements can be employed. For example, the color filter arrays of Figs. 31 or 33 can be positioned at skewed angles atop their corresponding photosensor arrays.

The differing locations of filter cells relative to photosensors in the above-detailed examples yield different pixel spectral filtering functions. Normally, in a color imaging device using a color filter array of tiled 3 x 3 filter cells, each pixel has one of nine spectral filtering functions. However, in the detailed arrangements, individual pixels are filtered with plural different physical filters, in different proportions (corresponding to a percentage area of the pixel photosensor that each filter overlies), yielding hundreds, thousands, or millions of different pixel filtering functions across the device.

While the illustrated examples employ normal color filters, relatively-thick and relatively-thin filters of different spectral transmission functions can be employed, such as the non-normative filters detailed earlier.

In accordance with a further aspect of the present technology, the spectral filtering function for each photosensor in the device is characterized. Applicant's Chromabath procedure can be used. Associated data memorializing the filtering function for each photosensor is stored in memory on the device. Similarly, data for kernels by which scalar outputs from individual photosensors in a neighborhood can be transformed into color values for desired color channels, for a pixel at the center of the neighborhood, are also stored in the device memory. (Such neighborhoods may be, e.g., of size 5 x 5 or 7 x7).

In the present arrangements - as in the other arrangements detailed herein - filters of two different spectral functions can be achieved with the same media (e.g., pigmented resist) by making the two filters of different thicknesses, as detailed earlier. Similarly, the spatially-varying filter arrangements can also employ filters, and filter cells, having attributes detailed earlier.

One particular filter cell comprises individual filters of conventional red, green, blue, cyan, magenta and/or yellow resists, with one or more of these colors formed with different layer thickness. For example, such color(s) can be formed as a thick layer (e.g., with a thickness in the range of 0.8 to 1.5 microns) and also as a thin layer (e.g., with a thickness in the range of 0.4 to 0.8 microns).

In some such embodiments, clear resist is applied to the photosensor substrate to define a checkerboard pattern of clear elements. Then 2 x 3 filter cells are formed, e.g., with colored resist. Half of these filters are on top of the clear resist elements (and are thus thin), and half extend down between the clear resist elements (and are thus thick). The filter cells can all be of the same pattern, or two or more filter cells can be repeated in a tiled pattern.

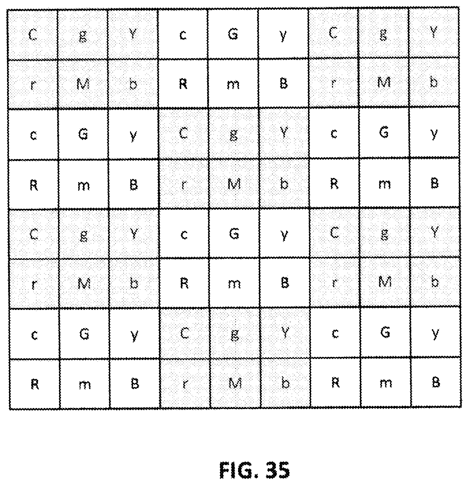

One such arrangement employs two different 2 x 3 filter cells in a tiled array. A first filter cell comprises filters of R, G, B, c, m, y, and a second filter cell comprises filters of r, g, b, C, M, Y, where upper case letters denote thick filters and lower-case letters denote thin filters (each letter corresponding to one of red, green, blue, cyan, magenta and yellow, respectively). Such cells can be tiled in a checkerboard arrangement, as shown in Fig. 35. (Shading is added simply to make the two different filter cells easier to distinguish.) A color filter array having some or all of the just-detailed attributes can be employed in any of the other embodiments detailed herein.

### Chromabath

As noted, the Chromabath process optically characterizes pixels on a sensor. In one particular implementation it produces a full sensor, multi-parameter pixel behavior map: a map of optical, primarily chromatic, deviations about certain sensor-wide norms. 'Characterizes' means measuring and recording how each pixel responds to light. Classic characteristics such as 'bias' and 'gain', as panchromatic parameters, are known. Measuring, storing and making use of these two classic parameters are included in the Chromabath process. The Chromabath process additionally handles color filter array image sensors; the panchromatic characterizations are bonuses. It can be utilized on all sensors that employ CFAs.

Fig. 7 and Table III contain sensitivity functions for red, green and blue of representative Bayer sensor pixels. Clearly not every pixel, of any given color, will have precisely these functions; they will deviate from the global norm at typically sub-10% deviation levels. Such deviations can be due to variations in filter thicknesses, cross-talk between different photosensors, contamination of filters with pigment component residue from previous masking steps, layer alignment errors (including filters and microlenses), etc. Data characterizing resulting deviations in pixel performance is measured and stored as part of the Chromabath process - enabling later correction of such pixel data to compensate for such error sources.

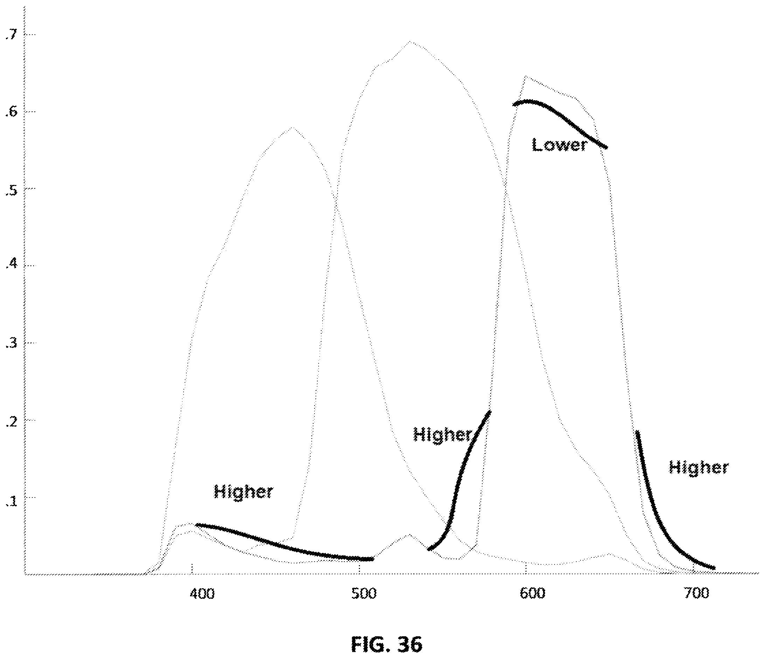

Fig. 36 exaggerates the idea for the sake of illustration. In this figure we find four specific regions of the spectrum where a given red pixel - sitting somewhere in a sea of pixels - happens to deviate measurably from the global mean red spectral function. It is this kind of spectral function deviation that the Chromabath procedures measure and correct. As described earlier, execution of this process can involve a calibration of a sensor-under-test stage using a multi-LED lighting system, and a calibration of the calibrator stage using a monochromator.

"Chromabath" as a single, isolated word will often refer to the entirety of the procedures involved in its application to real sensors. Strictly speaking, the singular word refers to the prolonged bathing of a sensor with light from a multi-LED lighting unit. This light-bathing process involves hundreds if not thousands of image captures from a sensor-under-test. This image data is typically offline-processed, where data is collected and stored, with processing of that data not commencing until all data from the sensor has been collected.

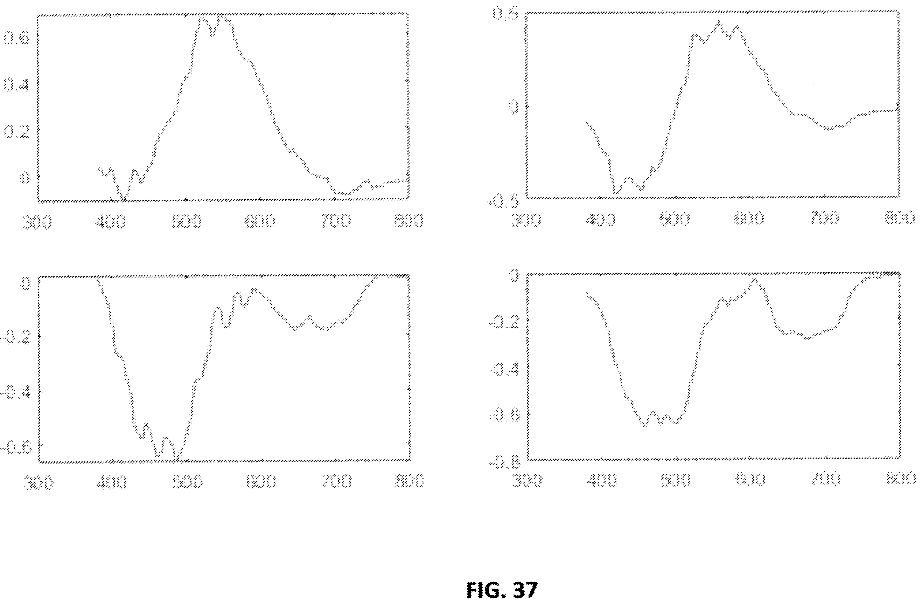

In one illustrative arrangement, spectral transmissivity curves are measured for each pixel on the sensor. Each curve can comprise, e.g., 85 data points, detailing transmissivity at 5 nm increments from 380 to 800 nm. For each different type of filter on the sensor (e.g., thin cyan), an 85-point global average curve is determined, based only on filters of that type. Each individual filter of that type is then characterized by its deviation from the corresponding type-average. Fig. 37 shows a sampling of such filter characterization curves for individual pixels. These curves may be used as signatures for the respective pixels. (In this illustration, the Y axis calibrations are not meaningful; the figure serves only to show the concept.)

As will be recognized, the pixel signatures shown in Fig. 37A are noise-prone spectral function plots. These types of noisy waveforms are amenable to a wide range of "compression" approaches which, in this example, take 85 values of floating-point numbers (380 nm to 800 nm in 5 nm steps), and turn them into a 4 byte compressed value.

One way to do this employs principal component encoding. With principal component encoding, one starts with a very large set of sample pixel signatures (e.g., all the pixel signatures for filters of the thin cyan type across on the sensor), and then performs a singular value decomposition of this set. This produces, e.g., six significant principal vectors (aka eigenvectors) which, when multiplied by unique coefficients for each pixel signature, will "fit" that pixel signature to some acceptable level of accuracy, such as 0.1%. These coefficients are each quantized, e.g., into one of 16 values, represented by four binary bits. These 16 values can be uniformly spaced (e.g., -7.5 to +7.5 in steps of 1), or non-uniformly spaced (i.e., into one of 16 histogram bins, chosen so that each has roughly the same number of counts).

If each pixel signature is represented by six coefficients (corresponding to the six principal vectors), using a 4-bit arrangement as just-described, that totals 24 bits. The remaining 8 bits (of the four bytes) can be allocated as 4 bits for a pixel offset value datum, and 4 bits for a gain datum. The 4 bits for a pixel offset value can be used to represent 16 uniformly-spaced or non-uniformly-spaced values relating the offset value for that pixel to the sensor-wide global norm. Similarly for the 4 bits for the gain datum. (The sensor-wide global norms used for offset value and gain data can be for pixels of like type, e.g., thin cyan, or for all pixels on the device.)

In a variant example, the 24 bits allocated to represent the six principal component coefficients are not uniformly distributed, with 4 bits to each coefficient. Instead, more bits are used to represent the primary component coefficient (e.g., 6 bits), with successively fewer bits used to represent the following components. For example, the secondary and tertiary components may be represented by 5 bits each, and the fourth and fifth components may be represented by three bits each. This leaves two bits to represent the sixth coefficient.

To store these 32 bits for each pixel, the sensor is equipped with associated memory of a size adequate to the task. Since the per-pixel signature data, offset value and gain value, are all relative to sensor-wide averages, the memory also stores these average values. When image data is transferred from the sensor to a system for use, the pixel data is transferred with the associated 4 bytes per-pixel, and the global averages. The receiving system can then correct, compensate, or otherwise take into account the pixel values in accordance with this correction data, to yield more accurate results.

There are at least three uses for the Chromabath data:
1. Sensor manufacturing quality control and assurance;
2. Creating globally uniform color images; and
3. As pixel-specific input data for AI and machine learning image processing, wherein classic pixel data is supplemented with a given pixel's signature (Chromabath-generated) data

Use of such data in creating globally uniform images can measurably increase manufacturing yields of image sensors. Yields of high quality, large CMOS image sensors in particular are notoriously low, often under 90%. What this means is that 10% or more of the manufactured sensors are going into the recycle bins ideally, but also the trash bins in some cases. Practitioners understand that the yield problem is more complicated that this simple description, where practices such as "binning" attempt to match economic demand against quality, but the main point stands: yields of CMOS image sensors are generally poor.

For Bayer/RGB CFA sensors specifically, yield is largely dictated by global uniform-quality specifications. You can't have one part of a sensor measuring a true cyan color for some scene-patch, and another part of the sensor measuring a greenish-cyan color for the same patch. This is the lay version of the situation; the professional version boils down to optical and chromatic uniformity specifications.

It is these specifications that the Chromabath procedures address. If a global color correction matrix is applied to a traditionally-produced sensor and the resulting color image is out-of-tolerance, the sensor is normally trash. If, instead, a Chromabath process is applied to that sensor, thereby enabling local tweaking of color on a per-pixel basis, then the sensor's utility is preserved - even enhanced.

### Color Correction

The 'Color Correction Matrix' is a familiar approach to transforming a raw red, green and blue sensor datum triad into a superior estimate of X, Y and Z chromatic estimates defined within the CIE 1931 color conventions. This color correction matrix is 'global,' or at least 'regional,' in the sense that the same matrix applies to hundreds, thousands and even millions of pixels. Aspects of the present technology concern, in part, a manufacturing-stage and/or a sensor-operation-stage calibration procedure that first gathers data to measure how pixel neighborhoods have slight variations in their individual pixel spectral response functions, stores such data for later use, and then uses that data to calculate regional, local, neighborhood or cell level color correction kernels that subsequently modify a classic color correction matrix tuned to the particular pixels in any given neighborhood of pixels. Such a calibration procedure can equally apply to three channel sensors like the Bayer RGB sensor as well as four through N channel sensors, where N can be into the hundreds.

'Matrix' is a simpler form of the more generally defined kernel. Kernel operations allow for both linear and non-linear local pixel-value operations, while 'matrix' conventionally is limited to linear operations. This specification teaches both linear and non-linear and machine-learning based kernel operations which perform this locally-tuned color correction. Imperfections and non-uniformities of pixel behavior can largely be mitigated and corrected by so doing.

Manufacturing color image sensors is difficult. Many sensors fail quality assurance tests and are destroyed. This consumes extra resources, incurs extra costs, and produces extra semiconductor processing wastes.

Manufacturers of color image sensors apply numerous quality assurance (QA) criteria to finished devices. Some criteria concern uniformity of pixel output signals in the presence of uniform illumination. It is not uncommon for some rows or column of pixels to be "hotter" than others. Or for patterns of pixels, e.g., in a checkerboard pattern, to be hotter than others. CMOS imager manufacturers commonly 'bin' individual sensors and thus categorize them into a commercial grading system. This grading system brings with it disparities in the price that can be charged for any given sensor. Vast amounts of R&D, engineering and quality-assurance budgets are allocated to increase the yield of the higher quality level bins.

Some criteria concern spectral sensitivity. Some "green" pixels may by more sensitive to red illumination than other "green" pixels, etc. Likewise for other color-filtered pixels.

These and other anomalies may be localized to a small region of a photosensor, or they may span the device, or they may span the large wafer on which dozens of photosensor devices are simultaneously fabricated. Spin coating, which is used to deposit microscopic layers of material across a wafer for processing, is one of dozens of different steps that can introduce non-uniformities.

In accordance with aspects of the technology, each pixel on an image sensor is associated with an individualized N-byte signature that expresses the pixel's unique behavior. This behavior includes, but need not be limited to, the pixel's particular spectro-radiometric sensing characteristics. In exemplary arrangements, N can be 3 or 4 bytes. These signatures are generated during Chromabath test, calibration and certification stage(s) of the manufacturing/quality assurance processes, for both mass-produced and specialty image sensors.

In some examples, the Chromabath process illuminates a sensor (or a wafer with many sensors) with a very-narrow-band light source that is swept across the range of electromagnetic spectrum to which the sensor is sensitive, where 'very' might be indicative of a monochromator's light output of one or two nanometers bandwidth. Each pixel's response is detected as a function of illumination wavelength. Deviations of each pixel's attributes, relative to normative behavior of locally- or regionally-neighboring pixels, and/or pixels sensor-wide, and/or pixels wafer-wide, are determined and recorded as a function of light wavelength across the swept spectrum. Sensitivity differences discerned in this manner are encoded into an N-byte compressed 'signature' that may be stored directly on memory fabricated on a CMOS sensor substrate, or stored in some other (e.g., off-chip) manner by which processes utilizing the image sensor output signals can have access to this N-byte signature data. During use of the sensor, the processing of pixels into output images utilizes information indicated by these N-byte signatures to increase the quality of image output. For example, the output of a "hot" pixel can be decreased, and the pixel's unique spectral response can be taken into account, in rendering or analyzing data from the sensor. Machine-learning and AI applications can also use these N-byte signatures as further dimensions of 'feature vectors' that are employed during training, testing and use of neural networks and related applications.

A series of medium-narrow-bandwidth LEDs, individually illuminated, can also be used in place of a monochromator for this measurement of pixels' N-byte signatures. The practical advantage of using a series of LEDs is that it is generally less expensive than monochromators and the so-called 'form factor' of placing LEDs in proximity to wafer-scale sensors is superior: the LEDs as a bank can sit just above a wafer as is inferred in the commercial product by Gamma Scientific, their RS-7-4 Wafer Probe Illuminator.

As indicated, global-sensor uniformity of radiometric behavior is one of several manufacturing tolerance criteria that are used in deciding whether an individual sensor passes or fails quality assurance testing. Provision of pixel-based N-byte signatures, which quantify pixel-by-pixel variations in radiometric behavior and other pixel non-uniformities, enable manufacturing and quality assurance tolerances to be relaxed, since such non-uniformities are quantified and can be taken into account in use of the sensor image data. Relaxation of these tolerances increases manufacturing yields and reduces per-sensor costs. Sensors that previously would have been rejected and destroyed, instead pass quality testing. Moreover, such sensors yield imaging results that are superior to prior art sensors that may have passed more stringent acceptance criteria, because the N-byte signature data can mitigate the otherwise acceptable minute variations of one pixel to the next.

In a particular scenario, a sensor manufacturer identifies the quality assurance criteria that are most frequently failed. A few of these may not be susceptible to mitigation by N-byte signature information, such as a simply-dead sensor, or a sensor with an internal short or open circuit that disables some function. But the vast majority of QA failures are due to performance shortcomings, such as an output uniformity metric or pixel spectral sensitivity metric that is a few percent beyond a permitted threshold. The N-byte signature data is then used to convey data (or indices to data stored elsewhere) by which these idiosyncrasies can be ameliorated. Often too, a connected pair, a connected trio, etc., of pixels can either be 'dead' or otherwise out of specific performance parameters. Here, too, N-byte pixel characterization can become a useful mitigation factor transforming a lower-binned sensors fetching a lower market-price, into a higher-binned sensor fetching a higher market-price.

In accordance with a further aspect, certain examples of the present technology employ a photosensor array and a color filter array that are uncoordinated, as detailed herein. By such arrangement, an image sensor with, e.g., color filtering elements of N=9 different colors have pixels with M>N different spectral response characteristics.

It will be understood that examples described above can employ filters having strong responses at and above 650 nm, with other features described in the discussion entitled Examples Employing Near Infrared. So-doing permits acquisition of data from which information for both visible light and NIR can be extracted. It will likewise be understood that the described examples can make use of the filters, and filter cell arrangements, detailed earlier in this specification.

### General Image Solutions for Arbitrary Spectral Profile Pixel Neighborhoods

In some examples, neighborhoods of pixel-spectral-functions (profiles) may not employ a fixed, repetitive cell-pattern, such as the 2x2 Bayer (RGGB) cell. An example is the spatially-varying color filter arrays detailed above. The following discussion addresses how data generated by these non-repetitive pixel neighborhoods can be turned into image solutions.

In many operations that seek to map pixel data to output data, it is desirable to first determine values of a luminance (luma) image that corresponds to the pixel data. One way to do this is to use N x N linear kernel operators. For a 2 x 2 filter cell, N may be 6. For a larger filter cell, such as the 3 x 3 cells detailed above, N may be 7.

A different kernel is defined for each differently-colored pixel, with a given neighborhood of surrounding pixel colors. Thus, in the red, green, blue, and yellow filter cell discussed above, there would be four different 6 x 6 kernels - each kernel centered on a respective one of the differently-colored pixels. In a cell employing nine different color filters, there would be nine different 7 x 7 kernels. Considering this latter case, when a pixel datum is generated, it is multiplied by all 49 kernel values associated with that particular pixel color (and that pixel's particular neighborhood of pixels, if the neighborhoods are not all alike), and the 49 results go into an accumulator array centered on the pixel and extending through the 7 x 7 pixel neighborhood centered on the subject pixel. Every pixel is processed this way, and the accumulated values comprise a full luma image

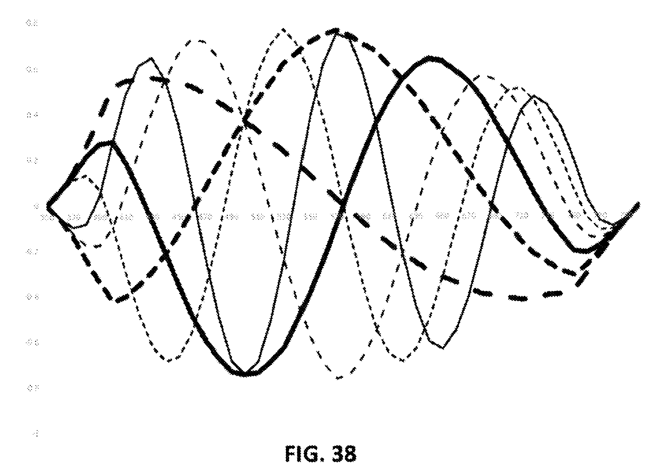

To obtain a color mapping from the pixel output values to desired output colors (spectral function solutions), a first step can be to parameterize each differently-colored pixel's spectral response profile. This parameterization is desirably accurate enough to "fit" the empirically measured pixel profiles to within a few percentage points of the pixel's peak response level in the spectrum. Fig. 38 depicts an example of a windowed Fourier series of functions, defined here over the interval 350 - 800 nm, which can be fit to both (a) to pixel spectral response profiles, and (b) to pixel spectral function solutions. In some cases, the functions can also be weighted by the photosensor's quantum efficiency, as a function of wavelength. Each term of the Fourier series is associated with a corresponding weighting coefficient, and the weighted functions are then summed, as is familiar in other applications employing the parametric fitting of functions.

Note that the Fourier series has no function that is not zero mean. This indicates that an initial solution for an image should first determine the image luminance, such as by the procedure just-described, before determining the pixel spectral function solutions. The luminance value should be removed from the pixel's value before the spectral solution functions of Fig. 38 are utilized.

There are two data here that should be turned into vectors of Fourier coefficients. The first is the spectral sensitivity profile of each pixel. This is primarily a function of the filter and the photosensor quantum efficiency, but can also include lens effects, scattering, etc. The function thereby defined in bounded by the raw spectral response of the photosensor (its irradiance profile). This is a familiar exercise in function fitting - determining coefficients that cause a sum of the weighted Fourier functions to best match the empirical measurements of each pixel's spectral sensitivity.

The same exercise is the conducted for spectral profile solutions. Truth data is employed for this exercise, e.g., a collection of reference scene images collected without sensor filtering, but illuminated at 46 narrow wavelengths of light, at 350, 360, 370 ... 800 nm, to thereby determine the spectral scene reflectance at each of these wavelengths for each image pixel. The same scene is also imaged with the subject color filter arrangement.

Once the pixel spectral sensitivity profile functions are parameterized and the spectral profile solution functions are parameterized, one is now able to derive a linear set of equations that matches acquired pixel data to solutions - one such set of linear equations for each differently-colored pixel.

In some examples, demosaicing is ignored, with the procedure determining nine different spectral function values for each pixel. This can be accomplished via interpolation. The price paid is that each spectral channel's spatial sampling distance is a factor of 3 lower in each direction, relative to a sensor where indeed all 9 channels are present at each pixel.

In other examples, a further demosaicing operation is employed. Such operation can follow teachings set forth, e.g., in Sadeghipoor, et al, A novel compressive sensing approach to simultaneously acquire color and near-infrared images on a single sensor, 2013 IEEE International Conference on Acoustics, Speech and Signal Processing, pp. 1646-1650; Park, et al, Visible and near-infrared image separation from CMYG color filter array based sensor, 2016 IEEE International ELMAR Symposium, pp. 209-212; and Teranaka, et al, Single-sensor RGB and NIR image acquisition: toward optimal performance by taking account of CFA pattern, demosaicing, and color correction, Electronic Imaging, 2016(18), pp. 1-6. These documents are incorporated herein by reference in their entireties.

A neural network approach, also using Fourier vectorization, can be employed instead of the linear solution described above. One models millions of scenes, and trains a pixel-by-pixel neural net solution that will be associated with unique pixels. The neural network will typically come up with a more compact solution that the linear solution approach, e.g., requiring perhaps just 10% of the data storage.

While Fourier series are used in the foregoing arrangement, others can be substituted, such as Taylor polynomials, Chebyshev, and Legendre family of polynomials.

### Neighborhood-Variant Color Correction Kernels

In accordance with certain examples, local tweaking of color is performed by application of a neighborhood-specific color correction kernel (a color correction matrix, or CCM) to an array of pixel values surrounding each subject pixel.

Color correction matrices (kernels) date back to Bayer sensors. What started as arcane mathematics is now mainstream, especially as concerns hardware and firmware implementations.

In one known prior art, an image sensor is used to capture an image of a color test chart having multiple printed patches of known color, in known lighting. The captured image is stored in an m x n x 3 array, where m is the number of rows in the sensor, n is the number of columns, and 3 indicates the number of different output colors. Ideally, the captured image would be identical to another m x n x 3 array containing reference data corresponding to the correct colors, but it is not. To transform the captured pixel array so as to more nearly approximate the ideal reference pixel array, the captured image array is multiplied by a 3 x 3 x 3 color correction matrix, whose coefficients have been tailored so that the product of such multiplication yields a best least-squares fit to the reference array. Thereafter, when an arbitrary image is captured, its image data is similarly processed by multiplication with this 3 x 3 x 3 color correction matrix to yield a color-corrected counterpart of the captured image.

In accordance with an aspect of the technology, instead of applying a single-color correction matrix to image pixels across a captured image, a variety of locally-adapted color correction matrices are employed. The formulaic version of this is, turning a global color correction matrix, which may be simplified as: $\left[\begin{matrix}A 11 & A 12 & A 13 \\ A 21 & A 22 & A 23 \\ A 31 & A 32 & A 33\end{matrix}\right]$ formula XX1 (where A is simply a generic letter representing various formulations, some involve X, Y and Z, others involving R, G and B, and yet other hybrids of these), into a locally adaptive form: $\left[\begin{matrix}f \left(4BN,1,1\right) & f \left(4BN,1,2\right) & f \left(4BN,1,3\right) \\ f \left(4BN,2,1\right) & f \left(4BN,2,2\right) & f \left(4BN,2,3\right) \\ f \left(4BN,3,1\right) & f \left(4BN,3,2\right) & f \left(4BN,3,3\right)\end{matrix}\right]$ formula XX2 where "4BN" is mapped to 4-byte data associated with a particular pixel neighborhood. These are the Chromabath-derived pixelmap pixel-signatures. 4-bytes is a nominal figure; data of other sizes can naturally be used. The neighborhoods can be of any size, such as 2 x 2 pixels, 4 x 4 pixels, 6 x 6 pixels, etc. Thus, a locally adapted color correction matrix value is a function of many parameters, including its 'index' of where it sits in the 3x3 color correction matrix itself. (As with the previously-detailed four-byte pixel signature data, the local color correction data is stored on-device in memory adequate for this purpose.)

This definition of these new functions, f, in formula XX2, deserve the same level of care and attention as did the definition and measurement of the 4-byte signatures themselves. In one example, these functions f in formula XX2 are empirically derived using machine learning training, but their 'classic' form can be described here.

One form of the 4-byte pixel signature posits the encoding of some "mixing" (cross-contamination) of the masked pigments, e.g., red and green pigments having trace amounts in a nominal blue pixel, and the same situation for nominal red and nominal green. If we take this 'encoding scheme' as an example for how to build these f functions for the locally adaptive color correction matrices, then we can build in this additional translation layer. Again empirically (and via simulation), mappings can be solved (the f functions themselves) via putting together 'truth' datasets matched to millions of instances of 4-byte neighborhood values imaging the full gamut of colors, and learning the answer. This is a brute force approach but is acceptable in the sense that the training of these functions can utilize as much time and compute power as needed. The end result yields linearly multiplicative coefficients that become the definition of each f function: $f \left(4BN,1,1\right) = c 11 _ 1 * 4 BN 1 + c 11 _ 2 * 4 BN 2 + c 11 _ 3 * 4 BN 3 , , ,$ etc. onward to perhaps 20 or 30 c11 coefficients, for each of the nine locally adaptive color correction values. This is also referred to as L1 or L2 linear systems of equations solving. Again, one method trains these locally adaptive color correction functions through machine learning and any number of choices which match millions or billions of truth-examples to corresponding millions or billions of 4-byte neighborhood pixel-signature values, viewing millions of color patches and color patterns across the entire gamut of colors.

When the sensor is thereafter used, the traditional global color correction stage of image processing is replaced by this locally-adaptive variant, where there will be this additional data feed of the 4-byte pixel signatures themselves. In general, these 4-byte pixel signatures are fixed and lead to similarly fixed locally adaptive color correction matrices. In mathematical terms, these new locally adaptive matrices are fixed but spatially variant. Thus, these will employ the allocation of memory-per-pixel just as the 4-bytes per pixel signatures required. However, in this case of operation, it becomes the color correction matrix maps that are operationally relevant, and no longer the 4-byte signatures themselves. So operationally there is the option to not bother having the 4-byte signature values themselves available to image processing. If only color correction is needed, then indeed one does not need the 4-bytes, but if one is doing AI/machine-learning image processing, one will not want to throw away these informationally-rich 4-byte signature values. Rough order of magnitude memory requirements for the locally adaptive color matrices is difficult, being contingent on many factors. But estimating 10-bytes per pixel as a common upper limit is not unreasonable.

These matrices are then utilized in the kernel-based processing of individual pixel outputs, in the same manner as such kernel-based processing to derive pixel data is traditionally-applied.

An exemplary excerpt from a locally-adaptive color correction matrix is indicated below:

| | R_{sRGB} | G_{sRBG} | B_{sRGB} |
|---|---|---|---|
| R_{raw} | 1.87 | -0.78 | -0.09 |
| G_{raw} | -0.16 | 1.54 | -0.38 |
| B_{raw} | 0.07 | -0.5 | 1.43 |

It is these nine numbers that change on a local basis, as a function of the local 4-byte pixel signatures. These numbers may vary slightly from one pixel to the next, or, within a demosaicing algorithmic context, one kernel to the next. This data, too, can be compressed into 4- to 6-byte difference encodings, and they will be fixed until further calibration measurements might change them.

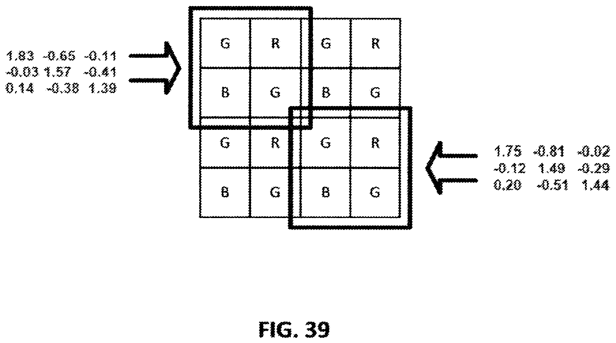

Fig. 39 goes further and makes explicit (and exaggerated) how these color correction matrices (CCMs as they may be called) are functions of local positions. The functions which convert the 4-bytes signatures into these numbers is what has been discussed earlier. The example here has one CCM per 2 x 2 pixel Bayer cell; other arrangements are certainly possible (including one CCM per each N x N region, with overlaps; and applying CCMs to pixels rather than cells). We can see that CCMs become locally tuned to minor imperfections in the pixel-to-pixel spectral functions of the underlying pixel types. Regional and global scale corrections can be built in to these local CCMs, where, for example, if spin coats over a chip are at a unit thickness at one corner of a sensor, and 0.97 unit thickness at another corner, this global scale non-uniformity can still be corrected by having the local values slowly change accordingly.

### ShadowChrome

This section expands on the earlier section entitled Restoration of Image Data.

Prior art camera systems do a poor job of discerning colors at low light levels. In accordance with below-detailed aspects of the technology, an image sensor produces data by which chromaticity of a pixel can be discerned accurately even at very low light levels. We sometimes refer to such technology as ShadowChrome.

The accepted theory of light measurement by CMOS sensor photosites (pixels) is that incident light generates so-called photo-electrons at a discrete pixel. The number of collected photo-electrons is discrete and whole, having no other numbers than 0, 1, 2, 3 and upwards. For present commercial-grade CMOS sensors, it is not possible to directly measure these discrete numbers due to so-called read-noise of an amplifier plus analog to digital conversion arrangement. So-called shot-noise is also present, an industry term used to describe the Poissonian statistics of discrete (whole number) measurement arrangements. Yet an additional factor that often should be considered is pixel to pixel variations in individual measurement behavior, a phenomenon often referred to as fixed pattern noise. ShadowChrome grapples with all four of these items: (a) paucity of photoelectrons; (b) read noise, typically on the order of 2e- to 5e- for modern CMOS image sensors, (c) significant shot noise owing to the paucity, and (d) pixel non-uniform measurement behavior.

Although ShadowChrome works well for normal brightness scenery imaging, where pixels are enjoying 100's if not 1000's of generated photo-electrons in every image snap, it has really been designed for very low light levels where the so-called signal to noise ratio (SNR) is 10 or even down to 1, and below 1. In numbers, we define a signal to noise ratio of 1 for a given digital image sensor to simply be where the average number of photo-electrons generated within a pixel is exactly equal to the read noise specification.

Indeed, it is precisely the SNR of 1 that guides many of the various parametric choices that are presented within a ShadowChrome solution framework. The commercial imaging desire to 'see color' - even as one can barely see the luminous forms of objects - at extremely low light level - drives the ShadowChrome agenda. Plucking but one of hundreds of examples where dim-scene color is important might be ADAS cameras (automated driver assistance system): starlit stop signs and starlit lane markers (as well as roadside objects) ought to exhibit their, e.g., red-ness and yellow-ness, respectively, as soon as their forms manifest themselves.

Prior art digital imaging systems define so-called 'dark frames' wherein all pixels have their mean digital numbers (DN) values recorded typically after 100's or even 1000's of 'no light' images have been recorded. The resulting values of this dark frame are most typically fractional opposed to discrete and whole numbers, essentially due to the many measurement frames used to derive the mean values.

With ShadowChrome, an explicit data structure becomes a scaffolding mechanism which then derives these dark frames, logging instead the median value DN points of each pixel, as opposed to their means. ShadowChrome reduces the lowlight color measurement problem into a vast network of coin-flips or pseudo-50-50 decisions which culminate in chromatic hue angle and saturation estimation, and this striving for 'pseudo 50-50' decision making begins with applying those principles to the no-light behavior of each pixel. The encoded dark level values of these pixel-by-pixel medians can conveniently use the exact same fractional value forms as their prior art 'dark frame' predecessors. In words, a fractional median value of, for example, 20.17 indicates that just under half of a pixel's dark-frame DNs will be below the DN of 20, and just under half of those values will be above the DN of 20. The remaining values will be DN=20 itself. Then when the fractional value is lower than 0.5 as it is with 20.17, this indicates that there are slightly more histogram values 21 and above, integrated, as there are 19 and below, integrated. These small details can matter when one is attempting to measure color at SNRs of 1 and even lower.

Thus, a possible preliminary stage to using ShadowChrome is dark frame calibration of a sensor, explicitly cast in the median pixel value form. Chromabath (discussed elsewhere) has this dark-level histogram creation built in to its process. For brevity's sake therefore, ShadowChrome can make use of the Chromabath data results.

A second possible preliminary stage to ShadowChrome involves the use of either calibrated white patches, or, in situations where such patches are unavailable, some equivalent 'scene' where there is access to 'no color' objects. As an ultimate backup where no scenes are available at all, one still can use 'theoretical' sensor specification data such as the sensor spectral sensitivity curves of each pixel type. (E.g., 9 types in a 3x3 cell arrangement.) The aim of the this second preliminary stage is to track the so-named 'gray-gain' of either A) all pixels of some given spectral type, e.g., 9; or B) each pixel's gray-gain in a Chromabath fashion. The latter is preferred for reaching the utmost in color measurement performance, but the former is acceptable as well, since CMOS sensors typically have well within 1% uniform behavior in 'generic gain.' Since we are dealing with very low light level imaging, often involving single-digit photo-electron counts, this 1% uniformity is a class diminishing returns situation. Put another way: pixel spectral types as a class have very different grey-gains, one type compared to another, but within a given spectral type, the grey-gains are effectively the same.

So the measurement of a pixel-spectral-type's grey-gain can be useful to maximize ShadowChrome's color measurement capabilities. Chromaticity and color are measured exclusively by the signal-ratio characteristics between pixels of different spectral-types, and so these signals desirably have a kind of zero-point reference on color, which is what these grey-gain values become. They are the 'no color' baseline signals, as it were. Again, these spectral-type-individual values can be derived by taking a few dozen to a few hundred images of a white patch, removing the effects of the dark levels discussed above, then the grey-gains of the spectral-types manifest as mean values from these many images. Grey-gain values themselves can be arbitrarily defined and then normalized to each other, but in this disclosure we use the convention that the highest grey-gain value belonging to only one of the spectral-pixel-types will be assigned the value of 1.0, and all others will be slightly lower than 1.0 but in the proper ratio. So-called 'white patch equalization' between the pixel-spectral-types would posit that grey-gain values below 0.8 is preferably avoided, if possible. (It will be recognized that these white patch and grey gain data are, in a sense, metrics of pixel efficiency.)

Use of these now-here-called dark-medians, and separately these grey-gains, will become evident within further ShadowChrome descriptions below.

### A Particular Example

Consider an example involving an image sensor comprising a 3 x 3 cell of nine pixels - some or all of which have differing spectral responses (i.e., they are of differing types). Filters and filter cells having the attributes detailed earlier are exemplary. These nine pixels may be labeled as the first through ninth pixels (or, interchangeably, as pixels A-I), in accordance with some arbitrary mapping of such labels to the nine pixel positions.

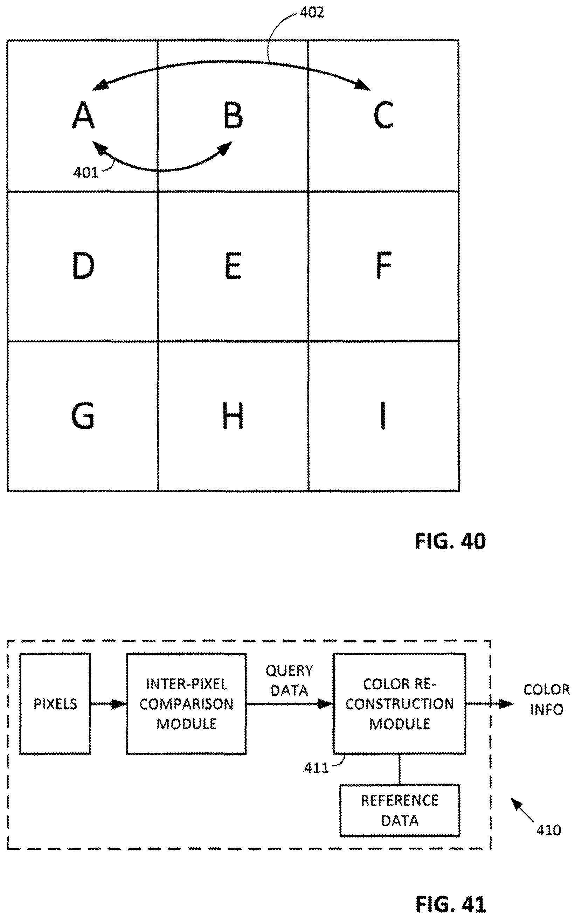

Referring to Fig. 40, information useful to indicate the chromaticity of the central pixel is generated by comparing a scene value associated with one pixel in the cell, termed a base pixel, with a scene value associated with a different pixel in the cell, termed an ordinate pixel. (The term "scene value" is sometimes used to refer to a value associated with a pixel when the image sensor is illuminated with light from a scene. The scene value of a pixel can be its raw analog or digital output value, but other values can be used as well. The term digital number, or DN, is also commonly used to represent a sensed datum of scene brightness.) In Fig. 40, pixel A is the base pixel and pixel B is the ordinate pixel; the comparison is indicated by the arrow 401 between these pixels.

This scene value comparison operation is performed between different pairs of pixels in the cell. For example, comparison can be performed between pixel A and pixel C. This is also shown in Fig. 40 by the arrow 402, with pixel A still serving as the base pixel, and pixel C serving as a second ordinate pixel.

Query data is formed based on results of these comparisons, and is provided to a color reconstruction module 411 of an image sensing system 410 as input data (Fig. 41), from which such module determines chromaticity information to be assigned to a pixel in the cell (typically a central pixel of the cell). In some examples, this color reconstruction module operates just with the query data as input; the color reconstruction module does not operate on pixel data itself (e.g., of the central pixel).

These two pixel pair comparison data are useful in indicating the color (i.e., chromaticity) of the central pixel in the cell, despite that fact that at least one, and here both, of the comparisons do not involve the central pixel (here pixel E). That is, the base pixel and the two ordinate pixels may not include the central pixel.

Such pixel pair comparison data is desirably produced by a hardware circuitry module fabricated on the same semiconductor substrate as the image sensor, and a representation of such data (e.g., as a vector data structure) is output by such circuitry as query data. This query data is applied to a subsequent process (typically implemented as an additional hardware circuitry module, either on the same substrate or on a companion chip), which assigns output color information for the central pixel based in part on such data. (This module may be termed a demosaicing module or a color reconstruction module.) Such hardware arrangement is shown in Fig. 41, with the dashed line indicating a common semiconductor substrate including the stated modules. (For commodity applications where there is a desire to keep the costs of a sensor to a minimum, raw data from the pixels can be communicated to either a camera module or cloud-based processors in order to perform the function of the color reconstruction module.)

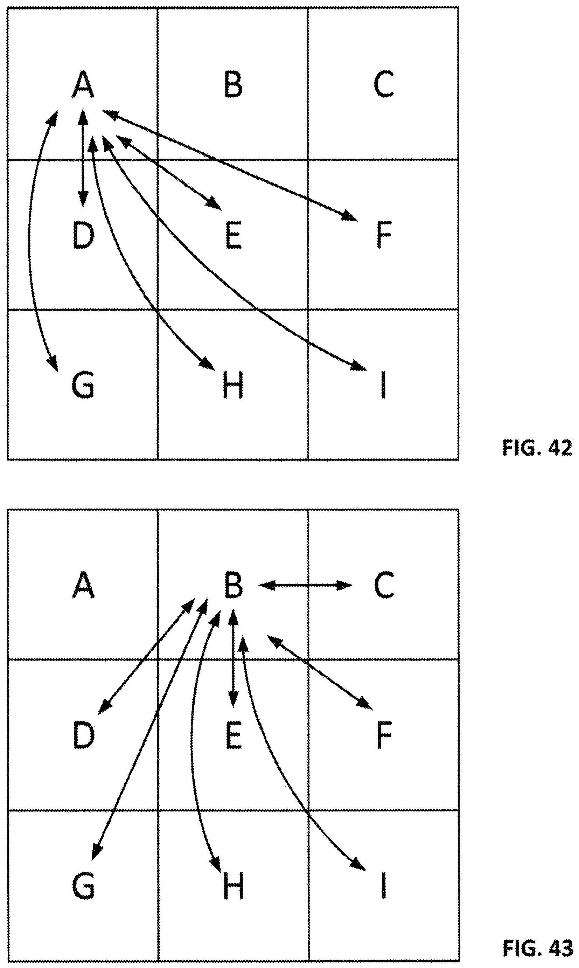

The quality of output color information will ultimately depend on the richness of the query information. Accordingly, query information based on just two inter-pixel comparisons (base and first ordinate; base and second ordinate) is rarely used. In many examples, further comparison operations are undertaken between the scene value associated with the base pixel, and scene values associated with still other pixels in the cell, yielding other pixel pair data. If the base pixel is termed the first pixel, then eight pixel pair comparison data can be produced, involving comparisons with the second through ninth (ordinate) pixels. The first two inter-pixel comparison data are produced as described above, i.e., by comparing the scene value associated with the first pixel with scene data associated with the second pixel (i.e., a [1,2] comparison, where the former number indicates the base pixel and the latter number indicates the ordinate pixel), and by comparing the scene value associated with the first pixel with scene data associated with the third pixel (i.e., a [1,3] comparison). Similar such comparisons likewise compare the scene value associated with the first pixel with scene data respectively associated with the fourth through ninth pixels in the cell, yielding [1,4] through [1,9] pixel pair data. Fig. 42 illustrates these further comparisons - each involving pixel A as the base pixel. Again, a representation of all such pixel pair data is output by the hardware circuitry as query data.

The use of the word compare, and its various forms such as 'comparing' and 'comparison', are used for a variety of mathematical choices of precisely how said comparison is made. One form of comparison is a sigmoid function comparison (see Wikipedia for details). The limiting case of the sigmoid function becomes a simple greater-than, less-than comparison of two separate values. In the case of whole number DNs, the case of equal-to also becomes a realized case, often leading to a null result or the assignment of the value 0. The limiting value of the sigmoid both in this disclosure and more generally is the numbers 1 and -1.

So far, the query data involves only a single base pixel. But just as the first pixel can be compared with eight other pixels, namely the second through ninth pixels (or more accurately, scene values associated with such pixels are compared), similarly the second pixel can be compared with seven other pixels, namely the third through ninth pixels. These comparisons are depicted in Fig. 43. And likewise, the third pixel can be compared with six other pixels, namely the fourth through ninth pixels. Similarly, the fourth pixel can be compared with five other pixels, namely the fifth (central) through ninth pixels. And so on until the eighth pixel is compared with just one pixel: the ninth pixel.

In the aggregate, these comparisons produce a total of 36 pixel pair data. This value is the number N-summatorial, in which N is the number of pixels in the cell (i.e., 9), as noted above. This value is also the (N-1)th triangle number. It can be computed as N(N-1)/2, which equals 36 for N=9.

Put another way, with N pixels in a cell, the detailed process compares a scene value associated with a Qth pixel in the cell, with a scene value associated with an Rth pixel in the cell, to update a Qth-Rth ([Q,R]) pixel pair data, for each Q between 1 and N-1, and for each R between Q+1 and N.

The comparison result comprising the pixel pair data can take different forms in different examples. In one example, the comparison result is a count that is incremented when the base pixel scene value is greater than the ordinate pixel scene value, and is decremented when the base pixel scene value is less than the ordinate pixel scene value. (If the base and ordinate values are equal, then the comparison yields a result of zero.) In the example just given, the 36 comparisons thus yield a 36-element vector, each element of which is -1, 0 or 1. This may be termed a high/low comparison.

In another example, the comparison result is an arithmetic difference between the two scene values being compared. For instance, if the scene value of the base pixel is 25 and the scene value of an ordinate pixel is 70, the comparison result (the pixel pair datum) is -45. In such case, the 36 element vector is comprised of 36 integer or real numbers (depending on whether the scene values are integer or real values). This may be termed an analog or difference-preserving comparison. There are also various forms of non-linear 'weighting' that can be applied to these comparisons as well, which is often the case in machine-learning implementations where one is not equipped with full knowledge of the final correct choices: let the training of data against large 'truth' based images make the choices. Likewise, the parameters of the sigmoid function itself can be machine-learning tuned.

As noted, the quality of output color information will ultimately depend on the richness of the query information. While the just-described arrangement generates query data by comparisons within a single color filter array cell, richer query information can be obtained by extending such comparisons into the field of pixels beyond that single cell.

In most image sensors, the color filter array comprises a tiling of cells. That is, referring to the just-discussed single cell as a first cell, there are multiple further cells tiled in a neighborhood around the first cell. Such further cells adjoin the first cell, or adjoin other further cells that adjoin the first cell, etc. These further cells may each replicate the first cell in its pattern of pixel types and its orientation. In such case, we sometimes refer to pixels found at the same spatial position in each of two cells as spatial counterparts, or as spatially-corresponding (e.g., a first pixel found in the upper left of the first cell is a spatial counterpart to a first pixel found in the upper left of the further cell).

In other examples, some or all of these further cells may have the same pattern of pixel types as the first cell but be oriented differently, e.g., rotated 90 degrees to the right. Or some or all of these further cells may have a different pattern of pixel types but include pixels of one or more types found in the first cell. In such cases, we sometimes refer to pixels of the same type found in each of two cells as color- (or type-) counterparts, or as color- (or type-) corresponding (e.g., a blue pixel found in the first cell is a color-counterpart of a blue pixel found in a further cell).

(In the case of a further cell that is a replicate of the first cell, all spatially-corresponding pixels between the two cells are also color-corresponding pixels.)

In accordance with some examples, scene values of pixels within the first cell are compared with scene values of spatial- or color-counterpart pixels in the further cells.

To give a specific non-limiting example, the scene value associated with the first pixel in the first cell is compared not only against the scene value of the second pixel in the first cell (as described above), but also with a scene value associated with a second pixel in one of the further cells. The first-second ([1,2]) pixel pair datum referenced earlier reflects a result of this comparison. This operation is repeated one or more additional times, with second pixels in one or more other of the further cells.

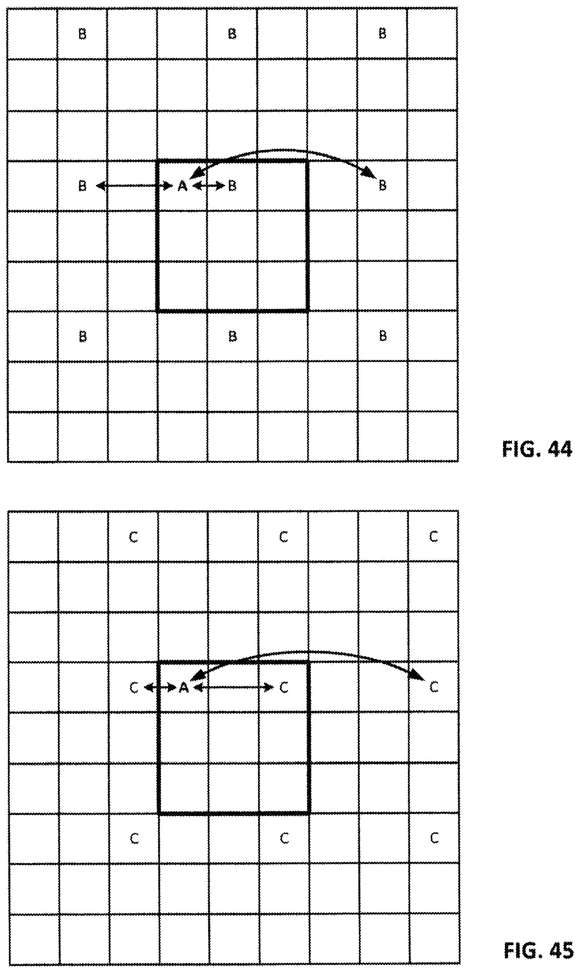

Such operation is shown in Fig. 44, which shows the first cell (i.e., the nine pixels outlined in bold in the center), within a local neighborhood of replicated cells. Here pixel A of the first cell is the base pixel. As described earlier, it is compared with the second pixel (B) in the first cell, as indicated by the short arrow. This base pixel is also compared against second pixels in the cells to the left, and to the right, of the first cell, as indicated by the longer arrows. These three comparisons all contribute to (update) the [1,2] pixel pair data. That is, if high/low comparisons are employed, a [1,2] count is incremented each time the base pixel scene value is larger than an ordinate pixel scene value, and is decremented in each opposite case. If analog comparisons are employed, the differences in scene values between the base pixel and each of the ordinate pixels are accumulated into a running total.

Similarly, the scene value associated with the first pixel in the first cell is compared with a scene value associated with a third pixel not only in within the first cell, but also within one of the further cells. The first-third ([1,3]) pixel pair datum referenced earlier is changed to reflects a result of this comparison. This operation is repeated one or more additional times, with third pixels in one or more of the other further cells.

Such operation is shown in Fig. 45, which parallels Fig. 44 but for the [1,3] pixel pair case.

The richer [1,2] and [1,3] pixel pair data thereby produced forms part of the query data.

Likewise, the first pixel (A) in the first cell can be compared with two or more fourth pixels in the further cells, to yield richer [1,4] pixel pair data.

Where, as here, there are N=9 pixels in each cell, such comparisons can similarly extend to compare the first pixel in the first cell with 5^{th} through Nth pixels in the further cells, enriching the [1,5] through [1,N] pixel pair data with this further information.

Just as the former example compared the first pixel with eight others, and then compared the second pixel with seven others, and so on until comparing the eighth pixel with one other, so too can the present example. That is, the second pixel (B) in the first cell can be compared against third through ninth pixels in multiple of the further cells, to enrich the comparison data employed in the query data. Similarly, the third pixel (C) in the first cell can be compared against fourth through ninth pixels in the further cells. Etc.

As just-described, a scene value associated with the pixel in the first cell is compared against scene values associated with second pixels in two further cells - one to the left and one to the right. But a larger set of further cells can be employed. For instance, instead of just the left- and right-further cells, eight further cells can be employed in this manner, i.e., the left-, right-, top- and bottom-adjoining cells, and also the four corner-adjoining cells. The [1,2] pixel data is thus based on a total of nine comparisons, i.e., compared against the second pixel in the first cell, and second pixels in the eight adjoining cells. That is, the first, base, pixel in the first cell is compared against second, ordinate, pixels in each of a 3 x 3 tiling of cells having the first cell at its center.

In like fashion, the comparisons can extend to ordinate pixels in a 5 x 5 tiling of cells having the first cell at its center. Each pixel pair datum, such as [1,2], is thus based on 25 comparisons. If high/low comparisons are employed, then each pixel pair datum can have a value ranging from -25 to +25. In many examples, each such datum is shifted by 25, to make the value non-negative. For example, if the base pixel for pixel pair [1,2] is associated with a scene value of 150, and the 25 ordinate pixels with which it is compared are associated with scene values between 40 and 60, then the [1,2] pair datum will accumulate to 50 (since, in 25 instances, the base value is greater than the ordinate value, with shifting by 25).

If analog comparisons are employed, then each pixel pair datum can have a large value dependent on the accumulated sum of scene value differences. For instance, in the just-given example, the [1,2] pixel pair datum will accumulate to about 2500 (since, in 25 instances, the base value exceeds the ordinate value by about 100).

The two detailed comparisons, high/low and analog, are exemplary only. Many other comparison operations can be used. For example, the arithmetic differences between the base value and each of the ordinate values can be weighted in accordance with the spatial distance between the pixels being compared, with larger distances being weighted less. Many other arrangements will occur to the artisan given the present disclosure. Likewise, as previously stated, machine learning applied to large training sets of imagery can guide neural net implementations/weightings of these comparisons.

The scene values associated with the base and ordinate pixels of each pair can each be raw pixel values - either analog or digital. Or they can be processed values, such as data output by an image signal processor module that performs hot pixel correction or other adjustment on raw pixel data. Furthermore, superior color measurement output will be produced if each pixel has been 'corrected' by its own unique dark-median, as described above. Thus, any comparison of one pixel raw datum to another pixel's raw datum will also involve each pixel's dark-median correction values. Also, the individual gray-gains of individual pixels, or the type-class gray-gains (described above), can be used to 'luminance level adjust' the compared values prior to the comparison operation itself. In the case where photo-electron generation in most pixels is only at the single-digit level, such gray-gain adjustments can amount to fractional DN values being added to values prior to the comparison operation, where the dark-median operation has already produced a fractional-valued DN. Thus, two correction operations are both involved in producing a comparison of two thus-corrected fractional DNs. At SNR levels of 1, these minute detailed fractional values - when applied to what usually becomes well over 100 comparison operations affecting any given pixel's eventual chromaticity value output can be important to 'seeing veritable color' instead of a chaotic swarm of randomized color produced by the sensor read noise alone.

Moreover, the scene value associated with a subject pixel can also be a mean or median value computed using all of the pixels of that same type within a neighborhood of 3 x 3 or 5 x 5 centered on the subject pixel. (In forming a mean or median, pixels that are remote from the subject pixel may be weighted less than pixels that are close.)

Values associated with pixels should not be assumed to be raw values unless so-stated.

In some examples, base pixels are associated with scene values of one type (e.g., mean) while ordinate pixels are associated with scene values of another type (e.g., raw).

The foregoing discussion details a procedure for generating query data to determine color information for a single pixel within a cell of N pixels - namely a (the) central pixel in the cell. To obtain color information for a different pixel in the cell, the process is repeated. However, the cell boundaries are shifted, re-framing the cell, to make this different pixel the central pixel.

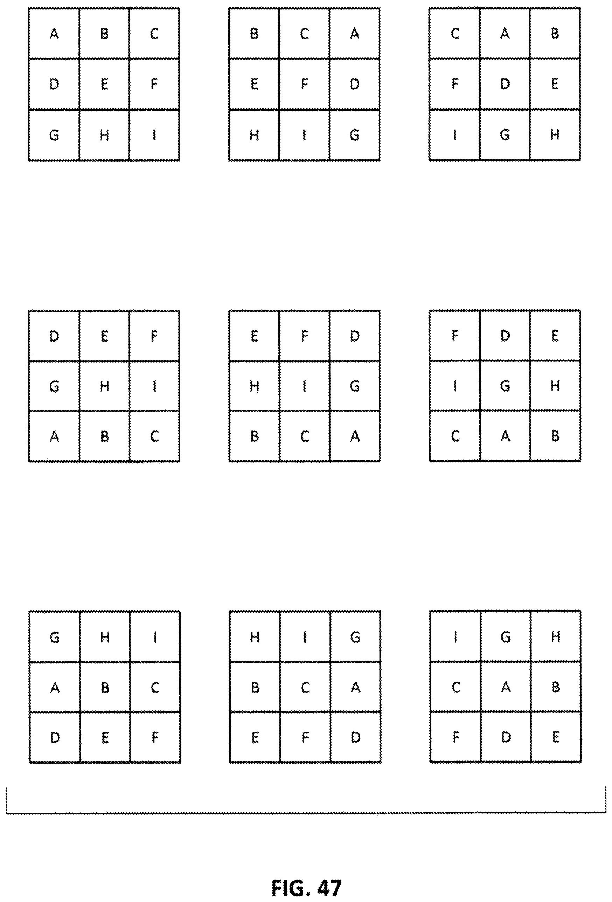

Given the field of millions of pixels in an image sensor, the boundary of a repeatedly-tiled cell is arbitrary. For instance, a Bayer cell can be regarded, scanning from top left and then down, as a grouping of red/Green/Green/Blue. Or as green/Red/Blue/Green. Or as green/Blue/Red/Green. Or as blue/Green/Green/Red. Relatedly, the nine pixels of the illustrative Fig. 40 cell can be re-framed in nine ways, as shown in Fig. 47. A different set of query data, based on a differing set of comparison data, is produced for each of these framings, and is used to determine color information for pixels E, F, D, H, I, G, B, C and A.

In expressing the query data, applicant has adopted the convention of an order that starts with the pixel in the upper-left of the framed cell as the base pixel, and performing comparisons with ordinate pixels to the right and then down (in the first cell, and optionally in further, neighboring cells), yielding the first eight elements of the 36 pixel-pair data. The process continues by using the pixel in the top-center of the framed cell as the base pixel, and performing comparisons with ordinate pixels that follow, right and down, yielding the next seven elements of the 36 pixel-pair data. And so forth through subsequent pixels. Thus, if pixels in the framed cell are numbered 1 through 9, starting in the upper left (across and then down), the set of pixel pair data is ordered as follows:
{[1,2], [1,3], [1,4], [1,5], [1,6], [1,7], [1,8], [1,9], [2,3], [2,4], [2,5], [2,6], [2,7], [2,8], [2,9], [3,4], [3,5], [3,6], [3,7], [3,8], [3,9], [4,5], [4,6], [4,7], [4,8], [4,9], [5,6], [5,7], [5,8], [5,9], [6,7], [6,8], [6,9], [7,8], [7,9], [8,9]}

It will be recognized that these 36 pixel pairings comprise only half of the possible ordered pairings. For example, there is no "pixel 2 compared with pixel 1."

If raw values are used for both the base and ordinate pixels, then pixel 2 compared with pixel 1 gives no new information; it is simply the negative of pixel 1 compared with pixel 2. However, if the value associated with the base pixel is determined by a mean or median operation, and the value associated with the ordinate pixel is a raw value (or vice-versa), then the comparison between pixels 2 and 1 can yield results different than the comparison between pixels 1 and 2. In such case, a vector of 72 elements may be used, based on comparisons between all possible ordered pixel pairs. However, such difference is not normally significant, so the smaller number of elements is typically used (i.e., 36) even if the base and ordinate scene values are not determined in the same manner. Thus, in practice, applicant suggests combining the slightly independent lower-higher pair result with the higher-lower pair result, keeping the pair-counts themselves to 36 instead of 72. (We sometimes term use the phrase "non-ordered pixel pairings" to refer to arrangements in which the order is not critical. Thus, the count of all non-ordered pixel pairings in a cell of nine pixels is 36.)

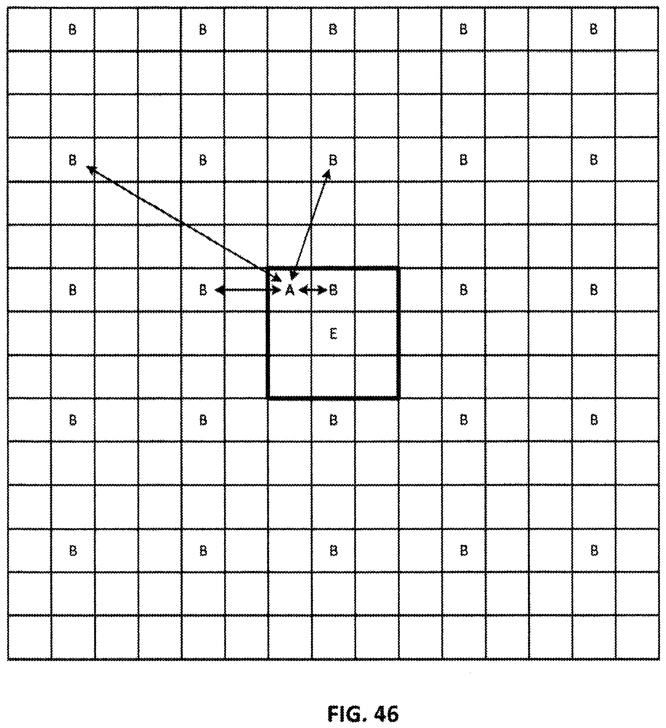

If the simple high/low form of comparison is used (with shifting to yield positive values), and comparisons are performed across a 5 x 5 array of cells (e.g., as represented in Fig. 46, with only a few comparisons indicated by arrows), then the query data for a single pixel at the center of the framed cell may take a form such as:
{23, 21, 48, 8, 32, 42, 24, 22, 10, 4, 1, 46, 38, 31, 15, 49, 34, 0, 34, 13, 13, 25, 2, 23, 28, 26, 25, 11, 35, 5, 4, 1, 10, 4, 0, 12}

Such a data structure will be recognized to comprise a multi-symbol code that expresses results of determining, between pairs of pixels, which are associated with larger scene values.

This is an extremely rich feature vector, in the sense that it has 50³⁶ possible forms (i.e., on the order of a 61-digit decimal number). The universe of potential colors is radically smaller. If colors are regarded in the RGB space, and each of the three values is expressed by 16 bits of data, there are only 2⁴⁸ possible colors (i.e., on the order of a 14-digit decimal number). Within the 36-dimensional universe described by the query data, the universe of possible colors forms an extremely sparse mapping. Each color of light, reflected from a scene and incident on pixel E in the Fig. 46 array of cells, falls within a volume within the 36-dimensional space of the query data that is unique to that color. Once a pixel's response to incident light is characterized in this 36-dimensional space, the volume in which it falls indicates its color. The reference data serves to provide the mapping between volumes in the 36-dimensional space and corresponding colors of pixel E.

(To be pragmatic about it, it is known that the human visual system itself is limited in its ability to discern color, generally agreed to be a two-dimensional chromaticity surface exemplified by the 1931 CIE chromaticity diagram. It is further accepted that so-called Macadam ellipses can map out a space of discernable colors that takes these astronomical numbers in mathematics down into addressable 'perceived' colors into the few thousands if even that much. The point being that this mathematical richness will eventually get back to, at best, good cardinal direction estimation in Hue angles as the SNR of a sensor approaches 1 and goes even lower.)

One way to generate the reference data is to employ the sensor to image color charts comprising patches of known colors (e.g., Gretag color charts) under known illumination (e.g., D65), and to perform the above-detailed comparisons on resulting pixel data to yield 36-D reference data vectors. That is, the reference comparison data is generated in the same manner as the query data, but the scene colors are known rather than unknown. A given patch of reference scene color will produce various data vectors depending on the various random factors involved, including random variations in the patch color, random variations in illumination intensity, sensor shot noise, sensor read noise, photosensor sensitivity variations among the pixels, etc. Such perturbations serve to splay the vector representation of the known color into a distribution of data vectors. The 36-D volume containing such vectors defines the space associated with the known color.

Once such reference data vectors associated with known colors are captured, they can be stored and used as a basis for comparison to 36-D query data associated with a subject pixel E capturing light of an unknown color. The task becomes finding, in the reference data, the 36-D vector data that best-matches the query vector. The known color associated with the best-matching reference vector is then assigned as the output color information for that pixel.

This is an exercise in string-matching (or pattern matching), and numerous techniques can be employed. One is to compute Hamming distances between the query data and vectors of the reference data to determine the closest match. Another similarly employs Levenshtein distances. Still another is to perform dot product operations between the query data and vectors of the reference data to determine the closest match. Many other suitable methods are detailed in the Approximate String Matching section of the "Encyclopedia of Algorithms," Springer Link, 2016 (ISBN 9781493928637).

Instead of serving as a catalog of reference data against which a best-match can be determined, the reference vectors - labeled with the colors to which they correspond - can be used to train a convolutional neural network. The parameters and weights of the network are iteratively adjusted during training, e.g., by a reverse gradient descent process, to configure the network so as to respond to an input query vector corresponding to pixel E by providing output data indicating the color for that pixel. (Such parameters/weights can then be stored as reference data.)

In these and other implementations, the colors can be defined in a desired color space. Most commonly X,Y CIE coordinate data are employed, but other color spaces - including sRGB, L*a*b*, hue angle (L*c*h), etc. - can be used.

Color charts provide only a limited number of known colors. Another method of generating reference data is to employ trusted multi-spectral images. One suitable set of multi-spectral images is the so-called CAVE data set, published by Columbia University. The set comprises 32 scenes, each represented by full spectral resolution 16-bit reflectance data from 400 nm to 700 nm at 10 nm steps (31 bands total). This set of data is available at www<dot>cs<dot>columbia<dot>edu/CAVE/databases/multispectrall and also at corresponding web<dot>archive<dot>org pages.

This approach does not utilize the physical image sensor itself to sense a scene. However, behavior of the image sensor can be modeled, e.g., by measuring the spectral transmittance function of its differently-filtered pixels, its spectral transmittance variation among filters of the same type, its shot noise, its read noise, its pixel amplitude variations, etc. Such parameters characterizing the sensor behavior can be applied to the published imagery to produce a thousand or more sets of simulated pixel data as might be produced (and perturbed) by the image sensor from a given scene, in Monte Carlo fashion. Each such different frame of pixel data is analyzed to determine a 36-D vector associated with each "E" pixel in the frame. The color of each such pixel is known (in terms of the published amplitude at each of 31 spectral bands), and can be converted to the desired color space. This reference data, associating 36-D reference vectors with known colors, is then utilized in one of the manners detailed above, to output color information in response to input query data.

It will be understood that the foregoing discussion has concerned assigning color information to a single pixel E in the cell. The reference data just-discussed is specific to that pixel E.

The same procedure is likewise undertaken to develop, and utilize, reference data for the other eight pixels in the cell. Thus, a total of nine sets of reference data are typically needed.

While the query data detailed in the illustrative examples is nominally invariant to brightness changes (that is, if a scene gets dimmer, all pixels should produce smaller output signals in unison, leaving inter-pixel comparison results unchanged), applicant has found this is not reliably the case. This is particularly evident at very dim brightnesses, e.g., where the signal-to-noise ratio is smaller than 10:1 or 4:1 or 2:1. Accordingly, in some examples, applicant generates multiple sets of reference data for each of the nine pixels in the cell, each corresponding to a different range of luminance levels. (Luminance can be determined on a local neighborhood basis, such as average raw pixel value across a field of 5 x 5, 9 x 9, or 15 x 15 pixels, or a field of 3 x 3, or 5 x 5, or 10 x 10 pixel cells.)

Thus, in assigning a color to a pixel, the first step is often to determine brightness of a region around the pixel, and then to select a set of reference data, or parameters/weights of a neural network, tailored to that brightness. (In the neural network case, the training data can comprise triplets of information: the vector of pixel-pair data, the local brightness, and the known color. In use, the network is provided with the vector of query data and the measured local brightness as inputs, and outputs its estimation of the corresponding color information.)

In some examples there may just be two ranges of brightness, e.g., dim and not-dim (such as by a signal-to-noise ratio of less than 5:1, or larger). In other examples there may be two, five, or a dozen or more different ranges of brightness, each triggering a different mapping of query data to output colors. One range may be for signal-to noise ratios of less than 1.5. Another may be used when the SNR is less than 3 but at least 1.5. Another may be used when the SNR is less than 5 but at least 3. Another may be used when the SNR is less than 10 but at least 5, etc.

A vector of 36 elements is one of many possible representations of this pixel comparison information. The symmetric group theory of linear algebra affords many alternative representations. In particular, pixel pairings within a cell of nine pixels can be expressed using S8 algebra (i.e., the group of bijections from a set of nine pixels). Any of these alternative representations can be stored in a corresponding data structure and used in examples of the technology.

One alternative representation is to focus on the color information output being directly specified in hue angle and saturation spaces. There is an independent mapping between hue angles of points in a given scene, and how those hue angles, as single scalar value, map into and out-from the 36 dimensional pixel-pair comparison space. One approach to measuring these direct hue angles is to utilize cosine and sine functions operating on the hue angle to find a hyperplane in 36 dimensional space which optimizes the fit between angles in 36 dimensional space and the x and y chromaticity hue angles in the CIE chromaticity space (or the a and b vectors of the Lab color space, or several other color spaces where the color is separated from the luminance).

While the above disclosure has focused on a 3 x 3 pixel cell, cells of other dimensions (and non-square shapes) can also be used. If the pixel cell has an even number of rows or columns, such as 2 x 2 or 2 x 3, then interpolative methods can be employed to adapt the above arrangements (which are premised on a "central" pixel) to such cells.

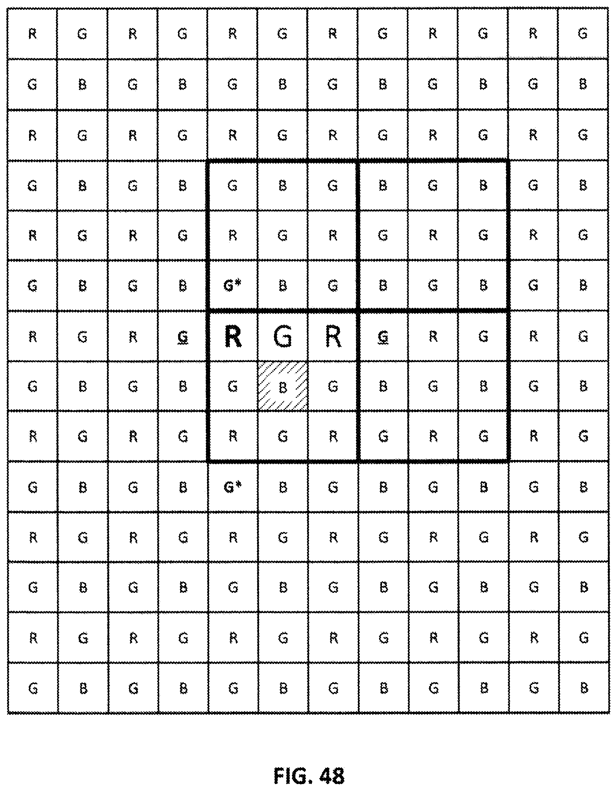

Alternatively, such a cell can be re-framed as a larger cell - one having a center pixel. An example is the classic Bayer cell. This cell can be re-framed into, e.g., 3 x 3 cells, as shown by the bold outlines in Fig. 48. This pattern can thus be seen to be a tiling of four different 3 x 3 cells. In one cell (the bolded cell at the upper left) there are five greens, two reds and two blues. In another cell (to the right) there are four greens, four blues and one red. In the third cell (the bolded cell at the lower left), there are four greens, four reds and one blue. And in the fourth cell there are again five greens, two reds and two blues. Thus, it will be seen that a cell can include two or more (and sometimes four or more) pixels of the same type. It will further be recognized that, although the cells are different, the component colors are the same in each.

Methods detailed above can be used here. For example, within each 3 x 3 pixel cell, a vector of 36 {-1, 0, +1} elements can be formed, and used to assign a color to the center pixel of the cell.

Other methods detailed above can be adapted here. For example, to enrich the query data, comparisons extending outside a single cell can be used. One such method is detailed next.

Consider the pixel B at the center of the bolded cell in lower left of Fig. 48 (in cross-hatching). In the upper left of this cell, the first pixel position is an R pixel, and serves as the base pixel against which the eight other pixels in the cell are compared as ordinates. The second pixel position (i.e., the first ordinate) is a G pixel. In addition to comparing the first pixel (R) value to this second pixel (G) value within the cell, the first pixel is also compared to the G pixel nearest to the base pixel but in the adjoining cell to the left. And a comparison is also made to the G pixel nearest to the base pixel but in the adjoining cell to the right. (These G pixels are underlined.) This triples the richness of the [1,2] pixel pair data - extending it from a single comparison to three comparisons.

Similarly, this first base pixel (R) can also be compared with the G pixel nearest to the base pixel but in the adjoining cell above the subject cell, and to the nearest G pixel in the adjoining cell below the subject cell. Both of these pixels are denoted by asterisks. This enriches the [1,2] pixel pair datum to reflect five comparisons rather than one.

Still further comparisons to additional pixels outside the subject cell can be employed, depending on needs of particular applications.

Sometimes the "nearest" pixel in the adjoining cell to the left/right/above/below is ambiguous, because two such pixels of the specified type are equidistant in the adjoining cell. In such case, the upper of two equidistant pixels in the cell to the left, and the lower of two equidistant pixels in the cell to the right can be selected for comparison. Relatedly, the left of two equidistant pixels in the cell above, and the right-most of two equidistant pixels in the cell below, can be selected for comparison.

It will be recognized that in this example of the technology, the first, second and third pixels are of first, second and third types, respectively (shown in enlarged letters R, G, R, respectively in Fig. 48). Moreover, the image sensor includes plural further cells around the first cell, each of which comprises pixels of types included in the first cell. Such example includes comparing the scene value associated with the first pixel in the first cell with a scene value associated with a pixel of the second type (G) in one of the further cells, and updating the first-second ([1,2]) pixel pair datum based on a result of this comparison. This act is repeated one or more additional times with pixels of the second type in other of the further cells.

This example can further include comparing the scene value associated with the first pixel in the first cell with a scene value associated with a pixel of the third type (R) in one of the further cells, and updating the first-third ([1,3]) pixel pair datum based on a result of this comparison. Again, this act can be repeated one or more additional times with pixels of the third type in other of the further cells. Query data is then formed that represents, in part, each of the [1,2] and [1,3] pixel pair data.

In like fashion, each of the 36 pixel pair data can be enriched by performing other comparisons outside the subject cell.

In the example given, in which a pixel cell with an even number of pixels is re-framed to form pixel cells with odd numbers of pixels, the query data is not resolved into color data by reference to one of nine sets of reference data, as in the earlier case (the nine sets corresponding to the nine re-framing of the cell to place each of the pixels in the center, per Fig. 47). Instead, one of 36 sets of reference data is used (disregarding further sets of reference data to account for brightness variations). That is, there are four different cell arrangements, and there are nine re-framings unique to each.

The processing detailed herein can be performed by a general purpose microprocessor, GPU, or other computational unit of a computer. More commonly, however, some or all of the processing is performed by a specialized image signal processor (ISP). The ISP circuitry (comprising an array of transistor logic gates) can be integrated on the same substrate - usually silicon - as the photosensors of the image sensor, or the ISP circuitry can be provided on a companion chip. In some examples, the ISP processing is distributed: some on the image sensor chip, and other on a companion chip.

Advantageously, all of the many comparison operations used to generate the query data, together with associated accumulation operations, can be performed with simple logic circuits, e.g., addition and subtraction units. This lends itself to low gate counts, with associated reduction in substrate area and device cost. The comparison operations can be performed, and the query data can be generated, without use of multiplication or division operations. (Multiplication may be required in other circuitry, e.g., for neural network execution.)

Unless otherwise indicated, the term pixel as used herein includes a photosensor, and may also include a respective filter and/or microlens.

It will be understood that the 36 pixel pair data represented by the query data in certain of the detailed examples s is exemplary only; more or less pixel pair data can naturally be used. For example, in one rudimentary example, two pixel pair data are used. For instance, scene values associated with one pair of pixels in the first cell are compared, and a result is employed in one pixel pair datum. Scene values associated with a second pair of pixels in the first cell are compared, and a result is employed in a second pixel pair datum. (The two pixel pairs may have base or ordinate pixels in common; e.g., they may be pixel pairs [1,2] and [1,3]. Or they may involve four pixels; e.g., they may be pixel pairs [1,2] and [3,4].)

It can also be understood that after the process of these comparisons and their accumulations have been concluded, there will then be a mapping from these gathered values (the 36 comparisons, for example) and the x and y chromaticities of a scene point. The breadth of choices in performing such mappings is inherently wide, ranging from classic linear mappings, to non-linear mappings, through machine learning-trained mapping and AI processing in general. With all of these mappings, the raw data as input generalizes to the term 'feature vector' quite nicely; this same term is in common use within machine learning applications. This large set of inter-comparisons of pixel datum enables ever-richer feature vectors to be constructed, allowing for lower and lower light measurements of color.

It will further be understood that each of the pixel pair data can be initialized to a value such as zero, or 25. The comparison data then serves to update such values.

Reference is sometimes made to a center, or central pixel, in a cell. A center pixel is a pixel that spans a geometric center point of a cell. Sometimes a cell does not have a center pixel (e.g., a 4 x 4 pixel cell). In such cases, a central pixel denotes a pixel whose distance to the geometric center point of the cell is no larger than any other pixel's distance to that geometric center point. Thus, a 4 x 4 pixel cell has four central pixels. A 3 x 3 pixel cell has only a single central pixel, namely the center pixel.

In certain examples employing the detailed principles, average chromaticity accuracy of better than 0.03 (in XY space) can be achieved with imagery of a standard Gretag 24-panel color chart, captured in such dim illumination that the signal-to-noise ratio is less than 3: 1. Generally speaking, applicant has seen at least one F-stop if not 2 F-stop and even 3-F-stop improvements of color measurement capabilities in pseudo side-by-side comparisons between a classic Bayer sensor and one of the 3x3, 9 channel variants. (F-stops equal a factor of 2 in photography terms.)

The detailed ShadowChrome technology works, in part, due to the fact that imaged scenes are not random pixel fields; the color at one pixel is not independent of colors at adjoining pixels. So information about relationships between pairs of pixels within a neighborhood, and particularly their scene values, can guide color estimates for individual pixels. The size of the neighborhood can vary depending on application requirements. Chromatic MTF requirements will influence how large a neighborhood is used to obtain what level of color accuracy. Lower spatial frequency color does very well with ShadowChrome in exemplary 3 x 3 cell examples, but there is a chromatic spatial frequency limit in every example where aliasing and moire'ing start to appear. Specifications of unacceptable levels of such artifacts can serve as constraints by which neural network-based examples are trained, so as to achieve implementations where such artifacts are kept within desired bounds.

### Concluding Remarks

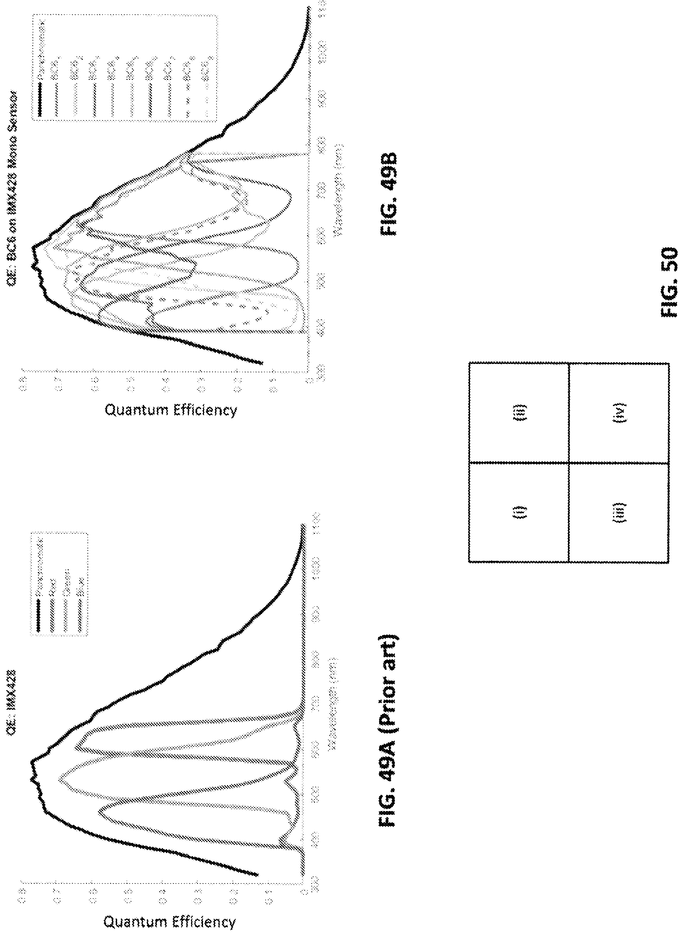

Different embodiments of applicant's technology achieve better performance in several critical areas than image sensors using Bayer pattern color filter arrays and multi-spectral image sensors. These areas include sensitivity, extended spectral sensitivity, multiple independent channel confirmation, contrast (panchromatic MTF), color gamut, and color accuracy. In certain nine-filter embodiments, for example, sensitivity is approximately twice that of Bayer CFAs, and color gamut is much-extended. See Figs. 49A and 49B, which compare standard Bayer performance with that achieved by the third filter set above - in both cases using a Sony IMX428 sensor array.

Having described and illustrated the principles of the technology with reference to illustrative embodiments, it should be recognized that the invention is not so limited.

For example, while many embodiments of the technology were described with reference to 3 x 3 color filter cells, embodiments employing both larger and smaller cells can also be used. Examples include 4 x 4, 5 x 5, 2 x 3, 2 x 2, 2 x 1, etc.

While a color filter array can be fabricated apart from a photosensor (e.g., on a glass plate), and then bonded to the sensor, it is more common to fabricate a color filter array as an integrated part of the photosensor using photolithography. A photosensor assembly used in an image sensor commonly also includes a microlens array and/or an anti-reflection film.

Some implementations of the detailed embodiments comprise pixels that are less than 10 microns on a side. Most comprise pixels that are less than 2 microns, less than 1.5 microns, or less than 1 microns on a side.

In some embodiments, non-normative filters comprise some or all of the filters. In other embodiments, normal red, green, blue, cyan, magenta, yellow or panchromatic filters comprise all of the filters.

An example with four filter elements can draw filters from the first, second or third exemplary filter sets detailed above. Such an embodiment is depicted in Fig. 50. Filter element (i) can use any of the nine filters of a filter set. Element (ii) can use any of the then-remaining other eight filters. Element (iii) can use any of the still-remaining seven other filters. Element (iv) can use one of the yet-remaining six other filters. Or Element (iv) can use the same filter selected for element (i). Or it can use a normal (R, G, B, C, M, Y) filter, such as the green filter of Table III.

Subject to the exception noted below, it should be understood that the limitations characterizing the various embodiments can be combined to characterize more particular embodiments. So-doing helps increase the diversity between filters in a color filter cell. For example, one such more particularly-characterized example is a color filter cell in which:
a dot product computed between group-normalized transmission functions of two different filters in the cell, at 10 nm intervals from 400-700 nm, is less than 4;
a dot product computed between group-normalized transmission functions of a first pair of different filters in the cell, is greater than such a dot product between a second pair of different filters in the cell, by a factor of between 2 and 4;
plural pairs of filter transmission curves, defined by samples at 10 nm intervals from 400-700 nm, cross each other at least four times;
the filter cell includes three or more different filters, each with an associated transmission curve, where a count of crossings between all pairs of said curves, in each of thirty 10 nm bands between 400-700 nm, yields a vector of 30 count values, including one count value of at least 9;
the cell includes one filter that has an efficiency of at least 2.0 times, or at least 2.5 times, the efficiency of another filter in the cell; and
a correlation computed between transmission functions of two different filters in the cell, at 10 nm intervals from 400-700 nm, is negative.

The exception is where limitations would conflict.

It will be recognized that the specification sometimes refers to filter outputs or filter values. This is generally a shorthand, which more properly might refer to a photosensor output or value, when a photosensor with 100% quantum efficiency is overlaid with the identified filter.

Although many detailed embodiments employ non-normative filters (i.e., not normal red, green, blue, cyan, magenta, yellow or panchromatic filters, as defined above), it will be understood that color filter cells employing such normal filters can also be employed. In some embodiments, color filter cells in which a single color resist is applied at two or more different thicknesses, to achieve two or more different spectral transmission functions, can be used.

There are various references to "different filters" in this specification. In some sense, all filters are different, even those intended to be identical, due to manufacturing variations. For purposes of this specification, the term "slightly different," when applied to two filters in a color filter cell, indicates the mean squared error between the filters is greater than 0.0018, when the transmission functions of the two filters are normalized to each other (i.e., so that at least one reaches a maximum value of 1.0), and are sampled at 10 nm intervals over a spectrum of interest. Unless otherwise stated, the spectrum of interest is 400-700 nm.

In contrast, for purposes of this specification, the terms "moderately different" and "substantially different," when applied to two filters in a color filter cell, indicates the mean squared error between the filters is greater than 0.02 and 0.25, respectively, when the transmission functions of the two filters are normalized to each other, and are sampled at 10 nm intervals over a spectrum of interest (here assumed to be 400-700 nm).

"Different," when used without the qualifying adjective "slightly," "moderately" or "substantially," is intended to denote "slightly different." However, since slightly different indicates a mean-squared error greater than 0.0018, such term also generically-encompasses moderately different and substantially different, and these latter two terms should be understood as intended species of "different" when that term is used without any qualifying adjective.

The mean square error metric just mentioned (and also mentioned earlier, in determining filters "comparable" to normal red, green, blue, etc.) involves determining the difference between each pair of transmission values at each sample point in the spectrum of interest, squaring those differences (e.g., 31, if 400-700 nm is used), summing those (31) values, and dividing by the number of sample points.

Reference is sometimes made to "transparent" pedestals, pigments, etc. As used herein, transparent denotes a spectral transmission function of greater than 90%, and preferably greater than 95% or 98%, over a spectrum of interest. If an image sensor produces RGB- or XYZ- based output, the spectrum of interest is the spectrum of human vision, taken here to be 400-700 nm.

Certain color filter arrangements detailed herein are characterized, in part, in that each filter in the cell has a spectral transmission function that is linearly-independent from the transmission functions of all other, different filters in the cell. Linear-independence indicates that a filter's transmission function cannot be achieved (within a margin of error) by a linear combination of the transmission functions of other filters in the cell. For purposes of this specification, the margin of error is the same 0.25 mean squared error threshold that defines "substantially different," as detailed above.

For the avoidance of doubt, the standard deviations referenced herein are computed using Microsoft Excel STDEVP function, which is understood to apply the following equation to a set of N values *x*: $\sqrt{\frac{\sum {\left(x-\overline{x}\right)}^{2}}{n}}$

Attention should be paid to the fact that, except as noted, the discussed spectral transmission functions are measured with a spectrometer without near infrared (NIR) or near ultraviolet (NUV) filtering. Moreover, such data does not reflect any spectral variation due to photosensor sensitivity. If data is taken in a circumstance that involves NIR or NUV filtering, or involves a photosensor, such effects may need to be addressed (e.g., removed) to ensure that any comparisons are valid.

This specification generally uses the term "cell" to refer to a geometrical arrangement of plural adjoining filters (or filtered pixels) that is repeated through a color filter array (or photosensor). A CFA can include cells of different sizes or shapes in a tiled pattern. A block that includes two or more identical tiles is not, itself, a cell. For example, the conventional Bayer cell is of size 2 x 2 pixels, with two pixels being green filtered, and the other pixels being red- and blue filtered. A grouping of 2 x 4 pixels, comprising two such Bayer cells side by side (four greens, two reds and two blues), is not regarded as a cell, but rather as two cells.

In the claims that follow, it will be understood that numeric limitations are used in an open-ended sense, unless otherwise denoted by a qualifier such as "exactly." A classic example is that a claim reciting a three-legged stool is met by a four-legged stool, since the four legs encompass the requisite three (and provides more). Similarly, e.g., a claim to a filter cell with an average efficiency of 50% encompasses a filter cell with an average efficiency of 55%.

Reference is sometimes made to primary and secondary colors. Red, green and blue are commonly said to be primary colors, while cyan, magenta and yellow are commonly said to be secondary colors. When context indicates a primary or secondary color is one of three choices, these are the choices.

More generally, however, we can characterize primary and secondary colors in terms of composition of a light spectrum relative to the spectrum's peak value within the visible light wavelengths (400 - 700 nm). If most of a visible light spectrum has a magnitude below 50% of the peak value, and the other wavelengths - with magnitudes above 50% - comprise a continuous range of wavelengths, we term that light spectrum a primary color. If most of a visible light spectrum has a magnitude above 50% of the peak value, and the other wavelengths - with magnitudes below 50% - comprise one or two continuous spectra, we term that light spectrum a secondary color.

Reference is frequently made to the spectral transmission function of a pixel. Generally, such statements likewise apply to the spectral sensitivity function of an associated pixel. The alternative recitation in each instance is omitted for reading clarity.

The reader is presumed to be familiar with image sensors and color filter arrays generally. The text "Image Sensors and Signal Processing for Digital Still Cameras" by Nakamura, CRC Press, ISBN 978-0-8493-3545-7, 2005, is a treatise on the topic. A good foundation is provided by the original Bayer patent, assigned to Kodak, US3,971,065. Patent documents US20070230774 (Sony), US8,314,866 (Omnivision), US20150185380 (Samsung) and US20150116554 (Fujifilm) illustrate other color filter arrays and image sensor arrangements - details of which can be incorporated into embodiments of the technology (including, e.g., pixels of varying areas, triangular pixels, cells of non-square shapes, etc.). Use of interference filters in color filter arrays are detailed, e.g., in U.S. patent publications 20220244104, 20170195586, 20050153219 and 6,638,668.

Fabrication processes for color filter arrays are familiar to artisans. Examples are detailed in U.S. patents 9,632,222, 8,853,717, 8,603,708, 7,914,957 and 7,763,401. Spin coating is one of several techniques may be employed to achieve photoresist layers of differing thicknesses.

The compounding of pigmented or dyed resists to achieve spectral transmission functions as discussed herein is within the skill of artisans. An exemplary yellow resist includes C.I. Pigment yellow 185 having particle sizes of .01 to .1 micron, with the content (by mass) of pigment particles amounting to 30 - 60% of the resist. (Artisans understand that controlling the sizes of the pigment particles serve to vary the tinting strength and hue, while controlling the mass content serves to vary the saturation and maximum transmission.)

Additional pigments can be combined to tailor the spectral features of the just-detailed yellow resist, such as C.I. Pigment yellow 11, 24, 31, 53, 83, 93, 99, 108, 109, 110, 138, 139, 147, 150, 151, 154, 155, 167, 180, 199, as well as pigments of other colors (e.g., red). Such a yellow resist can be used to a make so-called yellow filter. (Such a filter, of course, does not filter yellow light but rather filters (attenuates) blue light, so yellow remains. Such usage is common with other filters as well.)

Additional details on compounding resists and creating color filters is found, e.g., in Japanese patent publication JP2006098684 and U.S. Patent Publications 20220043344, 20190332008, 20140349101 and 20110217636. The latter two publications teach resists employing both pigments and dyes.

The design of infrared-attenuating filters is similarly familiar to artisans. Exemplary arrangements are taught in U.S. patent publications 20150346404 and 20210079210.

Many of the arrangements detailed herein can be implemented using off-the-shelf resists available from vendors such as FujiFilm, Toppan, Sumitomo Chemical, and Samsung SDI.

Additional information on color filter arrays, including the selection of filter transmission functions, is provided in the following papers, each of which is incorporated herein by reference. Teachings from these references can be used in conjunction with applicant's disclosed arrangements.
- Yako, M. et al, Video-rate hyperspectral camera based on a CMOS-compatible random array of Fabry-Pérot filters. Nature Photonics, pp.1-6, January 23, 2023;
- Arad, B., et al, Filter selection for hyperspectral estimation. In Proceedings of the IEEE International Conference on Computer Vision (pp. 3153-3161), 2017.
- Imai, F.H., et al, Digital camera filter design for colorimetric and spectral accuracy. In Proc. of third international conference on multispectral color science (pp. 13-16), July, 2001.
- Sippel, F., et al, Optimal Filter Selection for Multispectral Object Classification Using Fast Binary Search. In 2022 IEEE 24th International Workshop on Multimedia Signal Processing (MMSP) (pp. 1-5).
- Li, S.X., Filter selection for optimizing the spectral sensitivity of broadband multispectral cameras based on maximum linear independence. Sensors, 18(5), p.1455, 17 pp., 2018; and
- Hardeberg, J.Y., Filter selection for multispectral color image acquisition. Journal of Imaging Science and Technology, 48(2), pp.105-110, 2004.

When a sensor employing the nine filters of Table I is exposed to a scene, each filtered pixel provides an output datum (e.g., 12- or 16-bits). The ensemble of nine values from each 3 x 3 filter cell can be mapped to values a desired color space by a multiplication operation with a linear transformation matrix. A common color space is an RGB space that models the color receptors of the human eye. But other color space data can be produced as well. The nine differently-filtered data from each filter cell can be mapped to color spaces larger than 3 channels. 4-, 5- and 6-dimensional output color spaces are exemplary, while 7-, 8- and 9- dimensional output color spaces can also be used. Different applications can be best served by use of different color spaces. In some examples, plural different transformation matrices are employed by which, e.g., the differently-filtered pixel data can be mapped to two or more different color spaces, such as human RGB, and a different color space characterized by Gaussian curves centered at 450, 500, 550, 600 and 650 nm.

When image data is provided to a neural network for analysis, e.g., in an autonomous vehicle application or a medical diagnostic expert system, the color-space data produced as described above can be used. Alternately, and often preferably, no mapping is done; the untransformed pixel data is used as input to the neural network system. The system is trained using such data, and learns what transformations of this sensor data best serve to reduce an error metric used by the network.

Neural networks referenced herein can be implemented in various fashions. Exemplary networks include AlexNet, VGG16, and GoogleNet (US Patent 9,715,642). Suitable implementations are available from github repositories and from cloud processing providers such as Google, Microsoft (Azure) and Amazon (AWS).

Some cameras employing the present technology provide both types of outputs: data that has been mapped to one or more different color spaces, and data that is untransformed.

The processes and arrangements disclosed in this specification can be implemented as instructions for computing devices, including general purpose processor instructions for a variety of programmable processors, such as microprocessors (e.g., the Intel Atom, the ARM A8, etc.) These instructions can be implemented as software, firmware, etc. These instructions can also be implemented in various forms of processor circuitry, including programmable logic devices and field programmable gate arrays.

Implementation can additionally, or alternatively, employ dedicated electronic circuitry that has been custom-designed and manufactured to perform some or all of the component acts, as an application specific integrated circuit (ASIC).

Software instructions for implementing the detailed functionality can be authored by artisans without undue experimentation from the descriptions provided herein, e.g., written in C, C++, Visual Basic, Java, Python, Tcl, Perl, Scheme, Ruby, Matlab, etc., in conjunction with associated data.

Software and hardware configuration data/instructions are commonly stored as instructions in one or more data structures conveyed by tangible media, such as magnetic or optical discs, memory cards, volatile and non-volatile semiconductor memory, etc.

This specification has discussed various embodiments. It should be understood that the methods, elements and concepts detailed in connection with one embodiment can be combined with the methods, elements and concepts detailed in connection with other embodiments. While some such arrangements have been particularly described, many have not-due to the number of permutations and combinations. Applicant similarly recognizes and intends that the methods, elements and concepts of this specification can be combined, substituted and interchanged-not just among and between themselves, but also with those known from the cited art. Moreover, it will be recognized that the detailed technology can be included with other technologies-current and upcoming-to advantageous effect. Implementation of such combinations is straightforward to the artisan from the teachings provided in this disclosure.

While this disclosure has detailed particular orderings of acts and particular combinations of elements, it will be recognized that other contemplated methods may reorder acts (possibly omitting some and adding others), and other contemplated combinations may omit some elements and add others, etc.

Although disclosed as complete systems, sub-combinations of the detailed arrangements are also separately contemplated (e.g., omitting various of the features of a complete system).

While certain aspects of the technology have been described by reference to illustrative methods, it will be recognized that apparatuses configured to perform the acts of such methods are also contemplated as part of applicant's inventive work. Likewise, other aspects have been described by reference to illustrative apparatus, and the methodology performed by such apparatus is likewise within the scope of the present technology. Still further, tangible computer readable media containing instructions for configuring a processor or other programmable system to perform such methods is also expressly contemplated.

In view of the wide variety of embodiments to which the principles and features discussed above can be applied, it should be apparent that the detailed embodiments are illustrative only, and should not be taken as limiting the scope of the invention.

## Claims

1. An image sensor that includes: transmissive pedestals (172) spanning the image sensor; an array of photosensors disposed below the pedestals (172); first color filters disposed above the pedestals (172); and second color filters which do not rest on pedestals (172), the number of pedestals (172) being less than the number of color filters.

2. The image sensor of claim 1 in which the first color filter nowhere extends down to the array of photosensors.

3. The image sensor of claim 1 or 2 in which the pedestals (172) define interspersed locations of two types: relatively raised locations and relatively lowered locations, whereby the first color filters comprise a thin layer (181) where a pedestal (172) is present, and the second color filters comprise a thick layer (182) where a pedestal (172) is absent.

4. The image sensor of any preceding claim in which the pedestals (172) define interspersed locations of two types: relatively raised locations and relatively lowered locations, wherein a contiguous region of said image sensor includes cyan, magenta and yellow color filters at locations of one of said two types, and red, green and blue filters at locations of the other of said two types.

5. The image sensor of any preceding claim including pedestals (172) that are spectrally absorbing.

6. The image sensor of claim 5 including pedestals (172) that cut infrared (IR).

7. The image sensor of claim 6 wherein at least one first color filter is disposed on a pedestal (172) formed with a resist that cuts IR, and at least one first color filter is disposed on a pedestal (172) formed with a resist that transmits IR.

8. The image sensor of claim 6 in which a first color filter is formed on an IR-cutting pedestal, and a color filter is formed of the same resist but is a second color filter, or is a first color filter formed on a pedestal that transmits IR, giving rise to a different response.

9. The image sensor of any preceding claim in which a first color filter, comprised of a first colored resist, is formed on one of said pedestals (172), and a second color filter, also comprised of said first colored resist, is not formed on a pedestal (172), wherein the second color filter has a thickness greater than the first color filter.

10. The image sensor of any preceding claim in which said pedestals (172) are transparent.

11. The image sensor of claim 10 in which the pedestals (172) are clear, having transmission of 98% or more of light in the range 400-700 nm.

12. The image sensor of any of claims 1-9 wherein the pedestals (172) are not transparent, and are selectively spectrally-absorbing.

13. The image sensor of claim 9 in which the one of said pedestals (172) has a spectral transmission function above 80% from 400-700 nm, and below 50%, 20% or 10% at 720, 740 or 760 nm.

14. The image sensor of any preceding claim wherein a pedestal (172) has an index of refraction greater or less than that of a first color filter disposed above the pedestal (172).

15. The image sensor of any preceding claim in which the pedestals (172) comprise a checkboard pattern of pedestals (172).

## Patentansprüche

1. Bildsensor, der einschließt: transmissive Sockel (172), die den Bildsensor überspannen; eine Anordnung von Fotosensoren, die unter den Sockeln (172) eingerichtet ist; erste Farbfilter, die über den Sockeln (172) eingerichtet sind; und zweite Farbfilter, die nicht auf Sockeln (172) ruhen, wobei die Anzahl von Sockels (172) kleiner als die Anzahl von Farbfiltern ist.

2. Bildsensor nach Anspruch 1, wobei sich der erste Farbfilter an keiner Stelle bis hinunter zu der Anordnung von Fotosensoren erstreckt.

3. Bildsensor nach Anspruch 1 oder 2, wobei die Sockel (172) eingestreute Stellen von zwei Arten definieren: relativ erhöhte Stellen und relativ abgesenkte Stellen, wobei die ersten Farbfilter eine dünne Schicht (181) umfassen, wo ein Sockel (172) vorhanden ist, und die zweiten Farbfilter eine dicke Schicht (182) umfassen, wo ein Sockel (172) nicht vorhanden ist.

4. Bildsensor nach einem der vorstehenden Ansprüche, wobei die Sockel (172) eingestreute Stellen von zwei Arten definieren: relativ erhöhte Stellen und relativ abgesenkte Stellen, wobei ein zusammenhängender Bereich des Bildsensors Cyan-, Magenta- und Gelb-Farbfilter an Stellen einer der zwei Arten und Rot-, Grün- und Blaufilter an Stellen der anderen der zwei Arten einschließt.

5. Bildsensor nach einem der vorstehenden Ansprüche, der Sockel (172) einschließt, die spektral absorbierend sind.

6. Bildsensor nach Anspruch 5, der Sockel (172) einschließt, die Infrarot (IR) abschneiden.

7. Bildsensor nach Anspruch 6, wobei mindestens ein erster Farbfilter auf einem Sockel (172) eingerichtet ist, der mit einem Resist ausgebildet ist, das IR abschneidet, und mindestens ein erster Farbfilter auf einem Sockel (172) eingerichtet ist, der mit einem Resist ausgebildet ist, das IR durchlässt.

8. Bildsensor nach Anspruch 6, wobei ein erster Farbfilter auf einem IR-Schneidsockel ausgebildet ist, und ein Farbfilter aus demselben Resist ausgebildet ist, aber ein zweiter Farbfilter ist, oder ein erster Farbfilter ist, der auf einem Sockel ausgebildet ist, der IR durchlässt, was zu einer unterschiedlichen Reaktion führt.

9. Bildsensor nach einem der vorstehenden Ansprüche, wobei ein erster Farbfilter, bestehend aus einem ersten farbigen Resist, auf einem der Sockel (172) ausgebildet ist, und ein zweiter Farbfilter, ebenfalls bestehend aus dem ersten farbigen Resist, nicht auf einem Sockel (172) ausgebildet ist, wobei der zweite Farbfilter eine größere Dicke als der erste Farbfilter aufweist.

10. Bildsensor nach einem der vorstehenden Ansprüche, wobei die Sockel (172) transparent sind.

11. Bildsensor nach Anspruch 10, wobei die Sockel (172) klar sind, eine Transmission von 98 % oder mehr von Licht in dem Bereich von 400-700 nm aufweisen.

12. Bildsensor nach einem der Ansprüche 1 bis 9, wobei die Sockel (172) nicht transparent sind und selektiv spektral absorbierend sind.

13. Bildsensor nach Anspruch 9, wobei der eine der Sockel (172) eine spektrale Transmissionsfunktion über 80 % von 400-700 nm und unter 50 %, 20 % oder 10 % bei 720, 740 oder 760 nm aufweist.

14. Bildsensor nach einem der vorstehenden Ansprüche, wobei ein Sockel (172) einen Brechungsindex aufweist, der größer als oder kleiner als derjenige eines ersten Farbfilters, der über dem Sockel (172) eingerichtet ist, ist.

15. Bildsensor nach einem der vorstehenden Ansprüche, wobei die Sockel (172) ein Schachbrettmuster von Sockeln (172) umfassen.

## Revendications

1. Capteur d'image qui comporte : des socles transmissifs (172) s'étendant sur le capteur d'image ; un réseau de photocapteurs disposé sous les socles (172) ; des premiers filtres de couleur disposés au-dessus des socles (172) ; et des seconds filtres de couleur qui ne reposent pas sur des socles (172), le nombre de socles (172) étant inférieur au nombre de filtres de couleur.

2. Capteur d'image selon la revendication 1, dans lequel le premier filtre de couleur ne s'étend nulle part jusqu'au réseau de photocapteurs.

3. Capteur d'image selon la revendication 1 ou 2, dans lequel les socles (172) définissent des emplacements intercalés de deux types : des emplacements relativement surélevés et des emplacements relativement abaissés, de sorte que les premiers filtres de couleur comprennent une couche mince (181) où un socle (172) est présent, et les seconds filtres de couleur comprennent une couche épaisse (182) où un socle (172) est absent.

4. Capteur d'image selon l'une quelconque des revendications précédentes dans lequel les socles (172) définissent des emplacements intercalés de deux types : des emplacements relativement surélevés et des emplacements relativement abaissés, dans lequel une région contiguë dudit capteur d'image comporte des filtres de couleur cyan, magenta et jaune à des emplacements de l'un desdits deux types, et des filtres rouge, vert et bleu à des emplacements de l'autre desdits deux types.

5. Capteur d'image selon l'une quelconque des revendications précédentes, comprenant des socles (172) qui sont spectralement absorbants.

6. Capteur d'image selon la revendication 5 comprenant des socles (172) qui coupent l'infrarouge (IR).

7. Capteur d'image selon la revendication 6, dans lequel au moins un premier filtre de couleur est disposé sur un socle (172) formé avec une résine qui coupe les IR, et au moins un premier filtre de couleur est disposé sur un socle (172) formé avec une résine qui transmet les IR.

8. Capteur d'image selon la revendication 6 dans lequel un premier filtre de couleur est formé sur un socle coupant les IR, et un filtre de couleur est formé de la même résine mais est un second filtre de couleur, ou est un premier filtre de couleur formé sur un socle qui transmet les IR, donnant lieu à une réponse différente.

9. Capteur d'image selon l'une quelconque des revendications précédentes, dans lequel un premier filtre de couleur, constitué d'une première réserve colorée, est formé sur l'un desdits socles (172), et un second filtre de couleur, également constitué de ladite première réserve colorée, n'est pas formé sur un socle (172), dans lequel le second filtre de couleur a une épaisseur supérieure à celle du premier filtre de couleur.

10. Capteur d'image selon l'une quelconque des revendications précédentes dans lequel lesdits socles (172) sont transparents.

11. Capteur d'image selon la revendication 10, dans lequel les socles (172) sont transparents, ayant une transmission de 98 % ou plus de la lumière dans la plage de 400 à 700 nm.

12. Capteur d'image selon l'une quelconque des revendications 1 à 9, dans lequel les socles (172) ne sont pas transparents, et sont sélectivement absorbants spectralement.

13. Capteur d'image selon la revendication 9 dans lequel l'un desdits socles (172) a une fonction de transmission spectrale supérieure à 80 % de 400 à 700 nm, et inférieure à 50 %, 20 % ou 10 % à 720, 740 ou 760 nm.

14. Capteur d'image selon l'une quelconque des revendications précédentes, dans lequel un socle (172) a un indice de réfraction supérieur ou inférieur à celui d'un premier filtre de couleur disposé au-dessus du socle (172).

15. Capteur d'image selon l'une quelconque des revendications précédentes, dans lequel les socles (172) comprennent un motif en damier de socles (172).
